(19) Europäisches Patentamt
European Patent Office
Office européen des brevets

(11) EP 4 610 128 A1

(12) **EUROPEAN PATENT APPLICATION**
published in accordance with Art. 153(4) EPC

(43) Date of publication:
**03.09.2025 Bulletin 2025/36**

(21) Application number: **23882649.9**

(22) Date of filing: **24.10.2023**

(51) International Patent Classification (IPC):
***B60W 30/085*** *(2012.01)* ***B60G 3/00*** *(2006.01)*
***B60L 15/20*** *(2006.01)* ***B60W 10/08*** *(2006.01)*
***B60W 10/22*** *(2006.01)* ***B60W 30/02*** *(2012.01)*
***B60W 30/08*** *(2012.01)* ***B60W 30/10*** *(2006.01)*
***B60W 30/095*** *(2012.01)* ***B60W 40/00*** *(2006.01)*
***B60W 40/02*** *(2006.01)* ***B60W 40/06*** *(2012.01)*
***B60W 60/00*** *(2020.01)* ***B62D 7/15*** *(2006.01)*
***G01B 11/00*** *(2006.01)* ***G01C 3/06*** *(2006.01)*
***G01C 21/34*** *(2006.01)* ***G01P 13/00*** *(2006.01)*
***G06N 3/04*** *(2023.01)* ***G06N 3/08*** *(2023.01)*
***G06T 7/00*** *(2017.01)*

(52) Cooperative Patent Classification (CPC):
**B60G 3/00; B60L 15/20; B60W 10/08; B60W 10/22; B60W 30/02; B60W 30/08; B60W 30/085; B60W 30/095; B60W 30/10; B60W 40/00; B60W 40/02; B60W 40/06; B60W 60/00; B62D 7/15; G01B 11/00;** (Cont.)

(86) International application number:
**PCT/JP2023/038380**

(87) International publication number:
**WO 2024/090444 (02.05.2024 Gazette 2024/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:
**24.10.2022 JP 2022170165**
**27.10.2022 JP 2022172777**
**01.11.2022 JP 2022175679**
**11.11.2022 JP 2022181362**
**14.11.2022 JP 2022182131**
**21.11.2022 JP 2022186040**
**24.11.2022 JP 2022187648**
**24.11.2022 JP 2022187649**
**28.11.2022 JP 2022189546**
**27.12.2022 JP 2022210851**
**09.03.2023 JP 2023036967**
**31.03.2023 JP 2023058312**
**10.05.2023 JP 2023078139**
**18.05.2023 JP 2023082445**
**26.05.2023 JP 2023087263**
**31.05.2023 JP 2023090418**
**06.06.2023 JP 2023093420**

(71) Applicant: **SoftBank Group Corp.**
**Tokyo 105-7537 (JP)**

(72) Inventor: **SON, Masayoshi**
**Tokyo 105-7537 (JP)**

(74) Representative: **DREISS Patentanwälte PartG mbB**
**Friedrichstraße 6**
**70174 Stuttgart (DE)**

# (54) INFORMATION PROCESSING DEVICE, VEHICLE, INFORMATION PROCESSING METHOD, AND PROGRAM

(57) An information processing device of the disclosure includes an information acquisition unit that is capable of acquiring plurality information related to a vehicle, an inference unit that calculates index values from the plurality information acquired by the information acquisition unit, and uses deep learning to infer plural control variables from the index values, and a driving control unit that executes driving control of the vehicle on the basis of the plural control variables.

FIG.41

1F
5010
5020
5030
INFORMATION ACQUISITION UNIT
Weather
Road resistance
Angle of road
INFERENCE UNIT
DRIVING CONTROL UNIT
CONTROL VARIABLE

(52) Cooperative Patent Classification (CPC): (Cont.)
**G01C 3/06; G01C 21/34; G01P 13/00; G06N 3/04; G06N 3/08; G06T 7/00; G06T 7/20; G06T 7/70; G06V 10/94; G06V 20/58; G08G 1/0968; G08G 1/16; H01L 23/473; H04N 7/18; H04N 23/60; H05K 7/20**

## Description

Technical Field

The present disclosure relates to an information processing device, a vehicle, an information processing method, and a program including multivariate analysis using deep learning.

Background Art

Japanese Patent Application Laid-Open (JP-A) No. 2022-035198 discloses a vehicle having an autonomous driving function.

SUMMARY OF INVENTION

Technical Problem

In a conventional autonomous driving vehicle, it is difficult to, during traveling, analyze the influence of factors such as an air resistance and friction generated while the autonomous driving vehicle is traveling on a road.

Solution to Problem

According to an aspect of the disclosure, there is provided an information processing device including an information acquisition unit that is capable of acquiring a plurality of information related to a vehicle; an inference unit that calculates index values from the plurality of information acquired by the information acquisition unit, and uses deep learning to infer a plurality of control variables from the index values; and a driving control unit that executes driving control of the vehicle on the basis of the plurality of control variables.

According to an aspect of the disclosure, in the information processing device, the inference unit infers the plurality of control variables from the plurality of information through multivariate analysis according to an integration method using the deep learning.

According to an aspect of the disclosure, in the information processing device, the information acquisition unit acquires the plurality of information in units of prescribed cycles, and the inference unit and the driving control unit execute inference of the plurality of control variables and driving control of the vehicle in units of the prescribed cycles by using the plurality of information acquired in units of the prescribed cycles.

According to an aspect of the disclosure, the information processing device further includes a strategy setting unit that sets a travel strategy until the vehicle reaches a destination, in which the travel strategy includes at least one of theoretical values of an optimal route to the destination, a traveling speed, a tilt, and braking, and the driving control unit includes a strategy update unit that updates the travel strategy on the basis of a difference between the plurality of control variables and the theoretical value.

According to an embodiment of the disclosure, in the information processing device, the information acquisition unit includes a sensor that is provided in a lower portion of the vehicle and is capable of detecting a temperature, a material, and a tilt of a traveling ground.

According to an embodiment of the disclosure, an information processing device is provided. The information processing device includes an acquisition unit that acquires a plurality of information related to a vehicle from a detection unit including a sensor that detects a surrounding situation of the vehicle in a second cycle shorter than a first cycle of imaging surroundings of the vehicle as a cycle of detecting the surrounding situation of the vehicle; a calculation unit that calculates an index value related to the surrounding situation of the vehicle from the plurality of acquired information, and calculates a control variable for controlling a behavior of the vehicle from the calculated index value; and a control unit that controls the behavior of the vehicle on the basis of the calculated control variable.

According to an aspect of the disclosure, in the information processing device, the calculation unit calculates the control variable from the index value through multivariate analysis according to an integration method using deep learning.

According to an aspect of the disclosure, in the information processing device, the acquisition unit acquires the plurality of information in units of nanoseconds, and the calculation unit calculates the index value and the control variable in units of nanoseconds by using the plurality of information acquired in units of nanoseconds.

According to an aspect of the disclosure, in the information processing device, the calculation unit predicts a collision of a target obj ect with the vehicle on the basis of the plurality of acquired information, and in a case in which a predicted result indicates an unavoidable collision, the calculation unit calculates, as the control variable, a control variable corresponding to damage in which damage generated in the vehicle in the unavoidable collision is a predetermined threshold or less.

According to an aspect of the disclosure, in the information processing device, the damage generated in the vehicle is at least one of a deformation position and a deformation amount of the vehicle.

According to an aspect of the disclosure, in the information processing device, the control variable corresponding to the damage generated in the vehicle is at least one of a collision angle and a vehicle speed of the vehicle.

According to an embodiment of the disclosure, a vehicle including the information processing device is provided.

According to an embodiment of the disclosure, there is provided a program for causing a computer to function as the information processing device.

According to an aspect of the disclosure, there is provided an information processing device including a processor, in which the processor acquires detection information obtained by detecting a surrounding situation of a moving object, point information obtained by regarding an imaged object as a point, and identification information for identifying the object, calculates a control variable from a correlation between a variable related to the surrounding situation of the moving object calculated from the detection information and the control variable inferred by using the variable, and controls autonomous driving of the moving object on the basis of the control variable, the point information, and the identification information.

**In** the information processing device, a coefficient of the variable for the control variable may be set in advance, and the processor may calculate the control variable by using the coefficient.

**In** any of the information processing devices, the processor may execute a process of inferring the control variable in a second cycle longer than a first cycle of acquiring the detection information.

**In** any of the information processing devices, the processor may execute a process of calculating the control variable in a third cycle shorter than the second cycle.

**In** any of the information processing devices, the processor may infer the control variable through multivariate analysis according to an integration method using deep learning.

**In** any of the information processing devices, the processor may acquire the point information and the identification information from different processors.

According to an aspect of the disclosure, there is provided an information processing method of causing a computer to execute acquiring detection information obtained by detecting a surrounding situation of a moving object, point information obtained by regarding an imaged object as a point, and identification information for identifying the object; calculating a control variable from a correlation between a variable related to the surrounding situation of the moving object calculated from the detection information and the control variable inferred by using the variable; and controlling autonomous driving of the moving object on the basis of the control variable, the point information, and the identification information.

According to an aspect of the disclosure, there is provided a program for causing a computer to execute acquiring detection information obtained by detecting a surrounding situation of a moving object, point information obtained by regarding an imaged object as a point, and identification information for identifying the object; calculating a control variable from a correlation between a variable related to the surrounding situation of the moving object calculated from the detection information and the control variable inferred by using the variable; and controlling autonomous driving of the moving object on the basis of the control variable, the point information, and the identification information.

According to an aspect of the disclosure, there is provided an information processing device including a processor, in which the processor acquires detection information from a detection unit that detects a surrounding situation of a moving object in a second cycle shorter than a first cycle of imaging surroundings of the moving object, divides a period in which a collision of an obstacle with the moving object based on the detection information is predictable into a plurality of periods, and calculates a control variable for controlling autonomous driving of the moving object by using a plurality of input parameters based on the detection information in each of the plurality of periods according to a time series of the plurality of periods.

In the information processing device, in a case in which the control variable is calculated in a second or subsequent period of the plurality of periods, the processor may calculate the control variable by reducing the number of input parameters compared with the number of input parameters in a previous period.

According to an aspect of the disclosure, there is provided an information processing method of causing a computer to execute processing of acquiring detection information from a detection unit that detects a surrounding situation of a moving object in a second cycle shorter than a first cycle of imaging surroundings of the moving object; dividing a period in which a collision of an obstacle with the moving object based on the detection information is predictable into a plurality of periods; and calculating a control variable for controlling autonomous driving of the moving object by using a plurality of input parameters based on the detection information in each of the plurality of periods according to a time series of the plurality of periods.

According to an aspect of the disclosure, there is provided a program for causing a computer to execute processing of acquiring detection information from a detection unit that detects a surrounding situation of a moving object in a second cycle shorter than a first cycle of imaging surroundings of the moving object; dividing a period in which a collision of an obstacle with the moving object based on the detection information is predictable into a plurality of periods;

and calculating a control variable for controlling autonomous driving of the moving object by using a plurality of input parameters based on the detection information in each of the plurality of periods according to a time series of the plurality of periods.

According to an aspect of the disclosure, there is provided an information processing device including a processor, in which the processor acquires detection information from a detection unit that detects a surrounding situation of a moving object in a second cycle shorter than a first cycle of imaging surroundings of the moving object, calculates a distance between the moving object and an obstacle on the basis of the detection information, and predicts approach of the obstacle on the basis of the distance and a predetermined margin.

In the information processing device, the margin may be determined in advance for each occupant of the moving object.

In any of the information processing devices, the margin may be determined in advance for each age of the occupant.

In any of the information processing devices, the processor may change the margin according to a movement speed of the moving object or the obstacle.

In any of the information processing devices, the processor may change the margin according to a braking distance of the moving object or the obstacle.

In any of the information processing devices, the processor may control autonomous driving of the moving object on the basis of the predicted result.

According to an aspect of the disclosure, there is provided an information processing method of causing a computer to execute processing of acquiring detection information from a detection unit that detects a surrounding situation of a moving object in a second cycle shorter than a first cycle of imaging surroundings of the moving object; calculating a distance between the moving object and an obstacle on the basis of the detection information; and predicting approach of the obstacle on the basis of the distance and a predetermined margin.

According to an aspect of the disclosure, there is provided a program for causing a computer to execute processing of acquiring detection information from a detection unit that detects a surrounding situation of a moving object in a second cycle shorter than a first cycle of imaging surroundings of the moving object; calculating a distance between the moving object and an obstacle on the basis of the detection information; and predicting approach of the obstacle on the basis of the distance and a predetermined margin.

According to an aspect of the disclosure, there is provided an information processing device including a processor, in which the processor acquires detection information from a detection unit that detects a surrounding situation of a moving object in a second cycle shorter than a first cycle of imaging surroundings of the moving object, predicts a collision of an obstacle with the moving object on the basis of the detection information, and calculates a control variable for controlling autonomous driving of the moving object such that the obstacle will collide with a predetermined portion of the moving object in a case in which the predicted result indicates an unavoidable collision.

**In** the above information processing device, the processor may set, as the predetermined portion, a portion in which damage generated in a case in which the obstacle collides with the moving object satisfies a predetermined standard.

**In** any of the information processing devices, the portion in which the damage satisfies the predetermined standard may be a portion in which a rigidity of the moving object is a predetermined threshold or more.

**In** any of the information processing devices, the portion in which the damage satisfies the predetermined standard may be a portion in which a distance from an engine, a motor, or a battery mounted on the moving object is a predetermined threshold or more.

**In** any of the information processing devices, the portion in which the damage satisfies the predetermined standard may be a portion in which a distance from an occupant in the moving object is a predetermined threshold or more.

**In** any of the information processing devices, the processor may receive an input of a design drawing/document related to the moving object, and specify a portion in which the damage satisfies a predetermined standard on the basis of the design drawing/document.

According to an aspect of the disclosure, there is provided an information processing method of causing a computer to execute processing of acquiring detection information from a detection unit that detects a surrounding situation of a moving object in a second cycle shorter than a first cycle of imaging surroundings of the moving object; predicting a collision of an obstacle with the moving object on the basis of the detection information; and calculating a control variable for controlling autonomous driving of the moving object such that the obstacle will collide with a predetermined portion of the moving object in a case in which the predicted result indicates an unavoidable collision.

According to an aspect of the disclosure, there is provided a program for causing a computer to execute processing of acquiring detection information from a detection unit that detects a surrounding situation of a moving object in a second cycle shorter than a first cycle of imaging surroundings of the moving object; predicting a collision of an obstacle with the moving object on the basis of the detection information; and calculating a control variable for controlling autonomous driving of the moving object such that the obstacle will collide with a predetermined portion of the moving object in a case in which the predicted result indicates an unavoidable collision.

An information processing device according to the disclosure includes a processor, in which the processor acquires detection information from a detection unit that detects a surrounding situation of a moving object in a second cycle shorter than a first cycle of imaging surroundings of the moving object, calculates a control variable for controlling autonomous driving of the moving object on the basis of the detection information, and in a case in which the control variable for reducing damage generated in the vehicle in an unavoidable collision is calculated, provides a notification to a set contact address.

According to an information processing method of the disclosure, a computer executes processing of acquiring detection information from a detection unit that detects a surrounding situation of a moving object in a second cycle shorter than a first cycle of imaging surroundings of the moving object; calculating a control variable for controlling autonomous driving of the moving object on the basis of the detection information; and in a case in which the control variable for reducing damage generated in the vehicle in an unavoidable collision is calculated, providing a notification to a set contact address.

A program of the disclosure causes a computer to execute processing of acquiring detection information from a detection unit that detects a surrounding situation of a moving object in a second cycle shorter than a first cycle of imaging surroundings of the moving object; calculating a control variable for controlling autonomous driving of the moving object on the basis of the detection information; and in a case in which the control variable for reducing damage generated in the moving object in an unavoidable collision is calculated, providing a notification to a set contact address.

According to an aspect of the disclosure, there is provided an information processing device including an acquisition unit that acquires a plurality of information related to a vehicle from a detection unit including a sensor that detects a surrounding situation of the vehicle; a calculation unit that calculates an index value related to the surrounding situation of the vehicle from the plurality of acquired information, and calculates a control variable for controlling a behavior of the vehicle from the calculated index value; a control unit that controls the behavior of the vehicle on the basis of the calculated control variable, in which the calculation unit predicts a collision of a target object with the vehicle on the basis of the plurality of acquired information, and in a case in which the predicted result indicates an unavoidable collision, the calculation unit calculates a control variable such that damage generated in the vehicle is damage that is a predetermined threshold or less in the unavoidable collision and a re-collision in which the vehicle collides with another target object after the collision.

In any of the information processing devices, the acquisition unit may acquire information regarding the surrounding situation of the vehicle from another vehicle that is a collision target object.

In any of the information processing devices, the acquisition unit may acquire information regarding the surrounding situation of the vehicle from an external device installed on a traveling path on which the vehicle travels.

In any of the information processing devices, the calculation unit may calculate the control variable from the index value through multivariate analysis according to an integration method using deep learning.

In any of the information processing devices, the damage generated in the vehicle may be at least one of a deformation position and a deformation amount of the vehicle.

In any of the information processing devices, a control variable corresponding to the damage generated in the vehicle may be at least one of a collision angle and a vehicle speed of the vehicle.

According to an aspect of the disclosure, there is provided a vehicle including the information processing device; the sensor that is connected to the information processing device and detects the surrounding situation of the vehicle; and a reception unit that receives the plurality of information from the external device.

The above summary of the disclosure does not enumerate all the necessary features of the disclosure. A subcombination of these feature groups may also be included in the disclosure.

## BRIEF DESCRIPTION OF DRAWINGS

Fig. 1 is a schematic diagram showing an example of a vehicle equipped with a central brain.

Fig. 2 is a block diagram showing an example of an information processing device according to a first embodiment of the disclosure.

Fig. 3 is a block diagram showing an example of an information processing device according to a second embodiment of the disclosure.

Fig. 4 is a conceptual diagram showing an example of a configuration of an inference unit included in an information processing device according to a third embodiment of the disclosure.

Fig. 5 is a conceptual diagram showing an example of processing content of an information acquisition unit, the inference unit, and a driving control unit included in the information processing device according to the third embodiment of the disclosure.

Fig. 6 is a flowchart showing an example of a flow of a traveling speed control process according to the third embodiment of the disclosure.

Fig. 7 is a conceptual diagram showing an example of a configuration of an inference unit included in an information processing device according to a fourth embodiment of the disclosure.

Fig. 8 is a conceptual diagram showing an example of processing content of an information acquisition unit, the inference unit, and a driving control unit included in the information processing device according to the fourth embodiment of the disclosure.

Fig. 9 is a flowchart showing an example of a flow of a traveling speed control process strategy update process according to the fourth embodiment of the disclosure.

Fig. 10 is a conceptual diagram showing a modification example of the configuration of the information processing device according to the fourth embodiment of the disclosure.

Fig. 11 is a diagram schematically showing risk prediction capability of AI in ultra-high performance autonomous driving according to a fifth embodiment of the disclosure.

Fig. 12 is a diagram schematically showing an example of a network configuration in a vehicle according to the fifth embodiment of the disclosure.

Fig. 13 is a flowchart executed by a central brain according to the fifth embodiment of the disclosure.

Fig. 14 is a first explanatory diagram for describing an example of autonomous driving control performed by the central brain according to the fifth embodiment of the disclosure.

Fig. 15 is a second explanatory diagram for describing an example of autonomous driving control performed by the central brain according to the fifth embodiment of the disclosure.

Fig. 16 is a third explanatory diagram for describing an example of autonomous driving control performed by the central brain according to the fifth embodiment of the disclosure.

Fig. 17 is a fourth explanatory diagram for describing an example of autonomous driving control performed by the central brain according to the fifth embodiment of the disclosure.

Fig. 18 is a fifth explanatory diagram for describing an example of autonomous driving control performed by the central brain according to the fifth embodiment of the disclosure.

Fig. 19 is a sixth explanatory diagram for describing an example of autonomous driving control performed by the central brain according to the fifth embodiment of the disclosure and is a schematic diagram showing a state in which another vehicle is traveling around a vehicle.

Fig. 20 is a block diagram showing an example of a configuration of an information processing device including the central brain according to the fifth embodiment of the disclosure.

Fig. 21 is a flowchart executed by the central brain according to the fifth embodiment of the disclosure.

Fig. 22 is a schematic diagram showing an example of a vehicle equipped with a central brain according to a sixth embodiment of the disclosure.

Fig. 23 is a first block diagram showing an example of a configuration of an information processing device according to the sixth embodiment of the disclosure.

Fig. 24 is a second block diagram showing an example of a configuration of an information processing device according to a seventh embodiment of the disclosure.

Fig. 25 is an explanatory diagram for describing an example of point information output from a MoPU.

Fig. 26 is a third block diagram showing an example of a configuration of an information processing device according to a tenth embodiment of the disclosure.

Fig. 27 is a fourth block diagram showing an example of a configuration of an information processing device according to an eleventh embodiment of the disclosure.

Fig. 28 is an explanatory diagram for describing an example of association between point information and label information.

Fig. 29 is an explanatory diagram for describing a schematic configuration of a vehicle.

Fig. 30 is a block diagram showing an example of a functional configuration of a cooling execution device.

Fig. 31 is a fifth block diagram showing an example of a configuration of an information processing device according to a fourteenth embodiment of the disclosure.

Fig. 32 is a sixth block diagram showing an example of a configuration of an information processing device according to the fourteenth embodiment of the disclosure.

Fig. 33 is a diagram schematically showing coordinate detection in time series of an object.

Fig. 34 is a seventh block diagram showing an example of a configuration of an information processing device according to a fifteenth embodiment of the disclosure.

Fig. 35A is an explanatory diagram for describing an image of an object captured by an event camera.

Fig. 35B is an explanatory diagram for describing an image of an object captured by the event camera.

Fig. 35C is an explanatory diagram for describing an image of an object captured by the event camera.

Fig. 36 is a schematic diagram showing a state in which another vehicle is traveling around the vehicle.

Fig. 37 is a flowchart executed by a central brain according to a twentieth embodiment of the disclosure.

Fig. 38 is a flowchart executed by a central brain according to a twenty-first embodiment of the disclosure.
Fig. 39 is a configuration diagram of a vehicle system according to a twenty-first embodiment of the disclosure.
Fig. 40 is a flowchart executed by the central brain according to the twenty-first embodiment of the disclosure.
Fig. 41 is a block diagram showing an example of an information processing device according to a twenty-second embodiment of the disclosure.
Fig. 42 is a block diagram showing an example of an information processing device according to a twenty-third embodiment of the disclosure.
Fig. 43 is a diagram for describing a state of controlling a speed (acceleration/deceleration) of a vehicle according to a relationship of y=ax".
Fig. 44 is a block diagram schematically showing an example of a hardware configuration of a computer that functions as an information processing device.

DESCRIPTION OF EMBODIMENTS

The disclosure will be more fully understood from the following detailed description. Further scope of application of the present application will be apparent from the following detailed description. However, the detailed description and the specific illustrative examples are preferred embodiments of the disclosure and are described for purposes of explanation only. From this detailed description, various changes and modifications will be apparent to those skilled in the art within the spirit and scope of the disclosure.

The applicant does not intend to present any of the described embodiments to the public, and among the disclosed modifications and alternatives, modifications and alternatives that may not be included in the scope of the claims are also included in the invention under the doctrine of equivalents.

Hereinafter, the disclosure will be described through embodiments, but the following embodiments are not intended to limit the objects described in the claims. Not all combinations of features described in the embodiments are essential for solving the problems of the disclosure.

(First Embodiment)

An information processing device of the disclosure may obtain an index value necessary for driving control with high accuracy on the basis of a lot of information related to the control of a vehicle. Therefore, at least a part of the information processing device of the disclosure may be mounted on a vehicle to realize control of the vehicle.

The information processing device of the disclosure can provide a traveling system that can realize autonomous driving in real time on the basis of data obtained by various sensor inputs in AI/multivariate analysis/goal seek/strategy planning/optimal probability solution/optimal speed solution/optimal course management/edge based on Level 6, and is adjusted on the basis of a delta optimal solution.

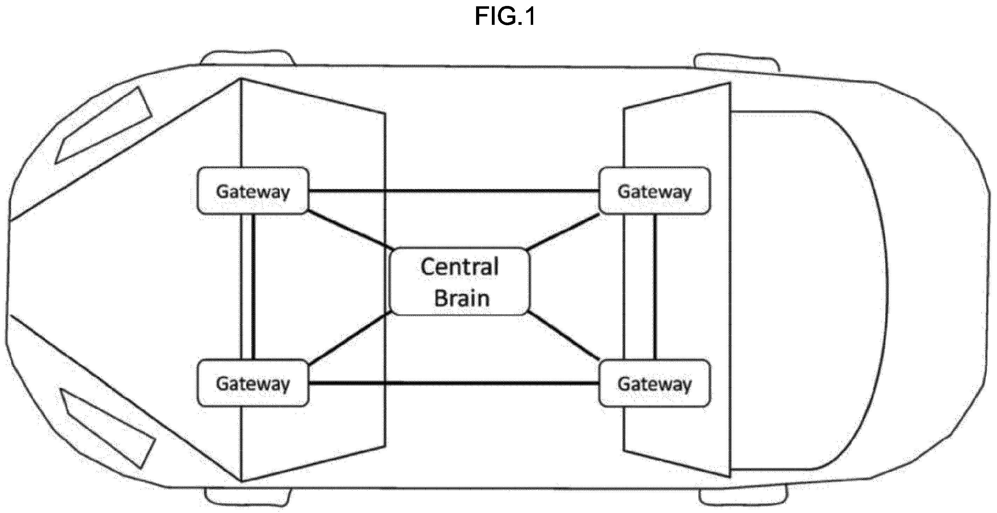

Fig. 1 is a schematic diagram showing an example of a vehicle equipped with a central brain. The central brain may be an example of an information processing device 1 according to the present embodiment. In the central brain, as shown in Fig. 1, a plurality of gateways may be communicatively connected. The central brain according to the embodiment can realize autonomous driving at Level 6 on the basis of a plurality of information acquired via the gateways.

"Level 6" is a level representing autonomous driving, and corresponds to a level higher than Level 5 representing fully autonomous driving. Level 5 represents fully autonomous driving, but is the same level as human driving, and there is still a probability that an accident or the like will occur. Level 6 represents a level higher than Level 5, and corresponds to a level at which a probability of the occurrence of an accident is lower than Level 5.

The calculation power at Level 6 (that is, the calculation power used to realize Level 6) is about 1000 times the calculation power at Level 5 (that is, the calculation power used to realize Level 5). Therefore, high-performance driving control that cannot be realized at Level 5 can be realized.

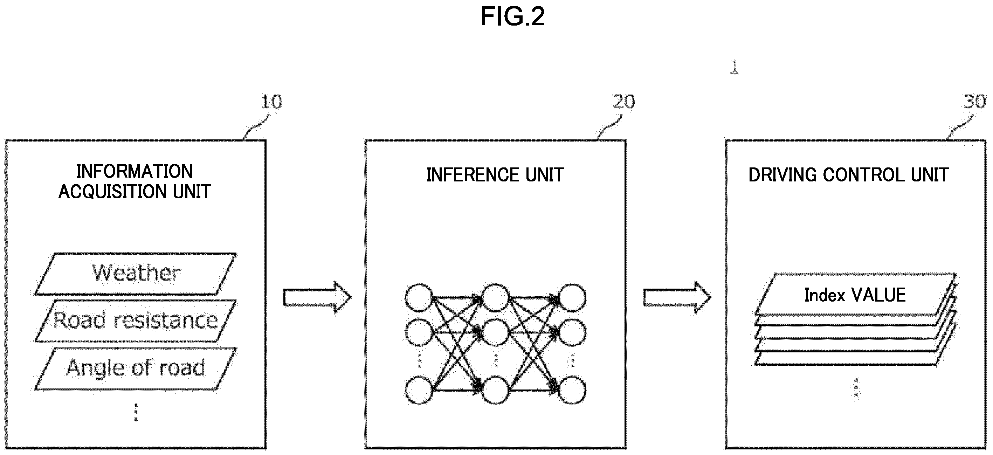

Fig. 2 is a block diagram showing an example of an information processing device according to the first embodiment of the disclosure. The information processing device 1 according to the embodiment includes at least an information acquisition unit 10 capable of acquiring a plurality of information related to a vehicle, an inference unit 20 that infers a plurality of index values from the plurality of information acquired by the information acquisition unit 10, and a driving control unit 30 that executes driving control of the vehicle on the basis of the plurality of index values.

The information acquisition unit 10 can acquire various types of information related to the vehicle. The information acquisition unit 10 may include, for example, communication means for acquiring information that can be acquired from sensors attached to various places of the vehicle, a server (not shown), or the like via a network. Examples of the sensors included in the information acquisition unit 10 include a radar, a LiDAR, a high-pixel/telephoto/ultra-wide angle/360 degrees/high-performance camera, a vision recognition, a microsound sensor, an ultrasonic sensor, a vibration sensor, an infrared sensor, an ultraviolet sensor, an electromagnetic wave sensor, a temperature sensor, a humidity sensor, a spot AI weather forecast, a material sensor, an inclination sensor, a high-precision multi-channel GPS, and/or a low-altitude satellite information. Alternatively, long tail incident AI data and the like can be exemplified. The long tail incident AI data is trip data of an automobile (that is, an automobile in which a device (here, as an example, the information processing device 1) capable of realizing the calculation power at Level 5 is mounted) mounted at Level 5.

Examples of the information that can be acquired by the plurality of types of sensors include a temperature and a material of the ground (for example, a road), an outside temperature, a ground inclination (tilt), a frozen state and a moisture amount of the road, a material and a wear state of each tire, an air pressure, a road width, the presence or absence of passing prohibition, the presence or absence of an oncoming vehicle, the vehicle type information of preceding and following vehicles, cruising states of these vehicles, and/or surrounding situations (birds, animals, soccer balls, accident vehicles, earthquakes, fires, winds, typhoons, heavy rain, light rain, snowstorm, and/or fog, etc.). In the embodiment, using the calculation power at Level 6 enables the detection thereof to be performed every nanosecond.

It should be particularly noted that the above information acquisition unit 10 includes a vehicle lower sensor provided in a lower portion of the vehicle and capable of detecting the temperature, a material, and a tilt of the ground on which the vehicle is traveling. The independent smart tilt can be executed by using the vehicle lower sensor.

The inference unit 20 may be capable of inferring an indexed value related to control of the vehicle from a plurality of information acquired by the information acquisition unit 10 by using machine learning, more specifically, deep learning. In other words, the inference unit 20 may be configured by artificial intelligence (AI).

The inference unit 20 can obtain an accurate index value by performing multivariate analysis (see, for example, Formula (2)) based on an integration method as shown in the following Formula (1) by using the calculation power used for realizing Level 6 (hereinafter, also referred to as "calculation power at Level 6") on data and long tail incident AI data for every nanosecond collected by many sensor groups and the like in the information acquisition unit 10. More specifically, while obtaining an integral value of various delta values having ultra-high resolution with the calculation power at Level 6, an indexed value of each variable is obtained at an edge level and in real time, and a result (that is, an index value that is an indexed value of each variable) occurring in the next nanosecond can be obtained with the highest probability theoretical value. In order to realize this, for example, an integral value obtained by time-integrating a delta value (for example, a minute time change value) of a function (in other words, a function indicating a behavior of each variable) capable of specifying each of variables (for example, a plurality of information acquired by the information acquisition unit 10) such as an air resistance, a road resistance, a road element (for example, dirt), and a slip coefficient is input to a deep learning model (for example, a trained model obtained by performing deep learning on a neural network) of the inference unit 20. The deep learning model of the inference unit 20 outputs an index value (for example, an index value having the highest certainty factor (that is, an evaluation value)) corresponding to the input integral value. The output of the index value is performed in units of nanoseconds.

[Math. 1]

$$V = \int_a^b f(A)dt$$

[Math. 2]

$$V_n = DL(f(A,B,C,D,\ldots,N)(dA_n/dt))$$

As an example, in Formula (1), "f(A)" is an expression in which a function indicating a behavior of each of variables such as an air resistance, a road resistance, a road element (for example, dirt), and a slip coefficient is expressed in a simplified manner. As an example, Formula (1) is a formula indicating the time integral v of "f (A)" from the time point a to the time point b. In the formula, DL represents deep learning (for example, a deep learning model optimized by performing deep learning on a neural network), dAn/dt represents a delta value of f(A, B, C, D, ..., N), A, B, C, D,..., and N represent an air resistance, a road resistance, a road element (for example, dirt), a slip coefficient, and the like, f(A, B, C, D, ..., N) represents a function indicating behaviors of A, B, C, D,..., and N, and Vn represents a value (that is, an index value) output from the deep learning model optimized by performing deep learning on the neural network.

Here, a form example in which an integral value obtained by time-integrating the delta value of the function is input to the deep learning model of the inference unit 20 is described, but this is merely an example. For example, an integral value (for example, a result occurring in the next nanosecond) obtained by time-integrating a delta value of a function indicating a behavior of each of variables such as an air resistance, a road resistance, a road element, and a slip coefficient may be inferred by the deep learning model of the inference unit 20, and as an inference result, an integral value having the highest certainty factor (that is, an evaluation value) may be acquired by the inference unit 20 every nanosecond.

Here, a form example in which an integral value is input to the deep learning model or an integral value is output from the deep learning model is described, but this is merely an example, and the technology of the disclosure can be established without using an integral value. For example, at least one index value may be inferred by a deep learning model optimized by performing deep learning on a neural network by using training data in which values corresponding to A, B, C, D,..., and N are used as example data and values corresponding to at least one index value (for example, the result occurring in the next nanosecond) are used as correct answer data.

An indexed value (that is, an index value) of each variable obtained by the inference unit 20 can be further refined by increasing the number of times of deep learning. For example, it is possible to calculate a more accurate index value by using enormous data such as a tire, rotation of a motor, a steering angle, a material of a road, weather, an influence of dust or at the time of secondary curved deceleration, slip, steering for collapse of balance or re-acquisition, and a speed control method, or long tail incident AI data.

The driving control unit 30 may execute driving control of the vehicle on the basis of the plurality of index values specified by the inference unit 20. The driving control unit 30 may be capable of realizing autonomous driving control of the vehicle. Specifically, it is possible to acquire a result that occurs in the next nanosecond from a plurality of index values with the highest probability theoretical value and perform the driving control of the vehicle in consideration of the probability theoretical value. That is, the driving control unit 30 may acquire an index value having the highest certainty factor (that is, an evaluation value) as a result of occurrence in the next nanosecond from the plurality of index values, and execute the driving control of the vehicle according to the acquired index value.

According to the information processing device 1 having the above-described configuration, since analysis and inference of information can be performed by using the calculation power at Level 6 that is extremely larger than the calculation power at Level 5, it is possible to perform detailed analysis at a level that is not compared with the related art. This enables vehicle control for safe autonomous driving. The multivariate analysis using the above AI can produce a value difference of 1000 times compared to the world at Level 5.

(Second Embodiment)

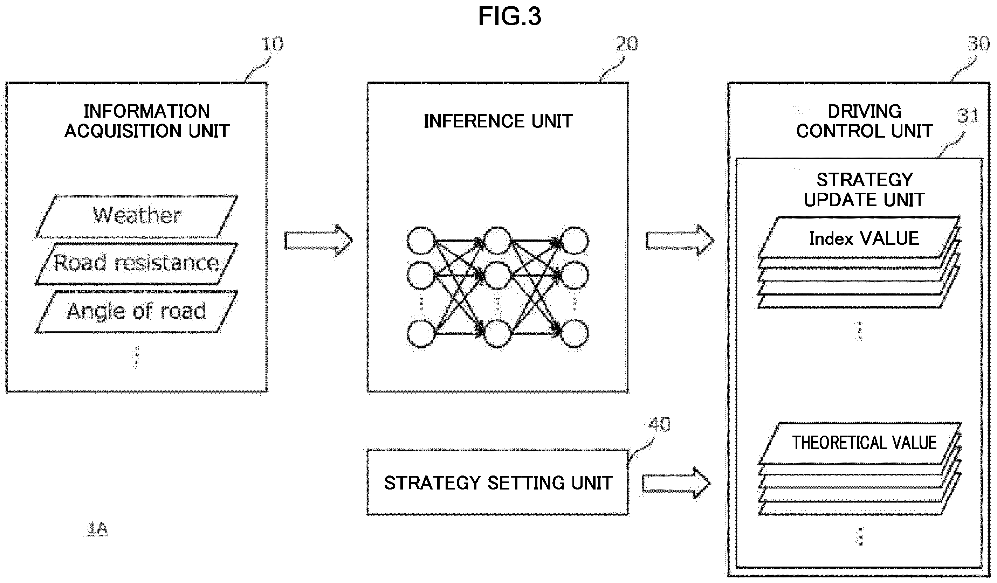

Fig. 3 is a block diagram showing an example of an information processing device according to a second embodiment of the disclosure. An information processing device 1A according to the embodiment is different from the information processing device 1 in that the information processing device 1A according to the embodiment includes a strategy setting unit 40 that sets a travel strategy for a vehicle to reach a destination, in addition to the constituents of the information processing device 1 according to the first embodiment described above.

The strategy setting unit 40 may set a travel strategy from a current location to a destination on the basis of information regarding the destination input by an occupant or the like of a vehicle, traffic information between the current location and the destination, or the like. In this case, information at that time at which the strategy setting is calculated, that is, data currently acquired by the information acquisition unit 10 may be considered. This is to calculate a more realistic theoretical value by taking into consideration not only simple calculation of a route to a destination but also a surrounding situation at that moment. The travel strategy may include at least one theoretical value of an optimal route to a destination (also referred to as a strategy route), a traveling speed, a tilt, and braking. Preferably, the travel strategy may include all theoretical values of the optimal route, the travel speed, the tilt, and the braking described above.

The plurality of theoretical values configuring the travel strategy set by the strategy setting unit 40 can be used for autonomous driving control in the driving control unit 30. In addition thereto, the driving control unit 30 preferably includes a strategy update unit 31 capable of updating the travel strategy on the basis of differences between the plurality of index values (for example, an index value indicating a traveling speed, an index value indicating a tilt, and an index value indicating a brake control value) inferred by the inference unit 20 and respective theoretical values (for example, a theoretical value of the traveling speed, a theoretical value of the tilt, and a theoretical value of the brake control value) set by the strategy setting unit 40.

An index value inferred by the inference unit 20 is detected while the vehicle is traveling, specifically, while the vehicle is actually traveling. For example, the index value is inferred on the basis of a friction coefficient. Therefore, by considering this index value, the strategy update unit 31 can cope with the momentary change at the time of passing through the strategy route. Specifically, the strategy update unit 31 calculates a difference (delta value) between the theoretical value and the index value included in the travel strategy, and can thus derive an optimal solution again and reformulate the strategy route. A first example of the optimal solution is an index value used instead of a theoretical value. A second example of the optimal solution is an adjusted index value used instead of a theoretical value. A third example of the optimal solution is a solution obtained by performing regression analysis using at least one theoretical value and at least one index value. A fourth example of the optimal solution is a statistical value (for example, a median value and/or an average value) obtained from a theoretical value and an index value. Which of the first to fourth examples is derived as an optimal solution by the strategy update unit 31 may be determined according to a magnitude of a difference, for example. An optimal solution is not limited to the first to fourth examples, and may be an optimal solution obtained by using other methods.

The strategy update unit 31 derives the optimal solution again as described above, and thus it is possible to realize almost all autonomous driving control without slipping, for example. That is, in a case in which autonomous driving control in which the vehicle slips when autonomous driving control is performed only according to a theoretical value is performed, and autonomous driving control in which a vehicle does not slip with a margin on the safety side when autonomous driving control is performed only according to an index value is performed, an index value adjusted by subtracting the margin is used as a theoretical value by the driving control unit 30, whereby the closest autonomous driving control in which the vehicle does not slip is realized. Since the calculation power at Level 6 described above can be used in such an update process, correction and fine adjustment can be performed in units of nanoseconds, and more precise traveling control can be realized.

In a case in which the information acquisition unit 10 includes the above-described vehicle lower sensor, the vehicle lower sensor also detects the temperature, a material, and the like of the ground, so that it is possible to cope with the momentary change at the time of passing through the strategy route. An independent smart tilt can also be implemented in calculating a travel course included in the travel strategy. Even in a case in which another information is detected (for example, flying tires, fragments, or animals), it is possible to recalculate an optimal travel course at an instant and perform optimal course management by coping with the momentary change at the time of passing through the strategy route.

(Third Embodiment)

In a third embodiment described below, an information processing device and the like capable of, during traveling, analyzing the influence of elements such as air resistance and/or friction generated while an autonomous driving vehicle is traveling on a road will be mainly described.

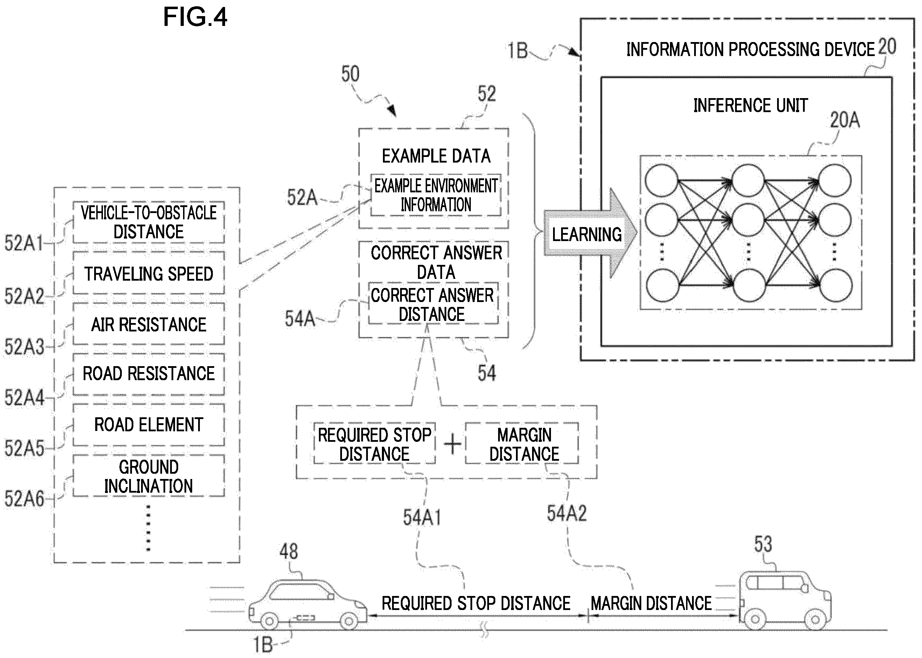

Fig. 4 is a conceptual diagram showing an example of a configuration of an inference unit 20 included in an information processing device 1B according to the third embodiment of the disclosure.

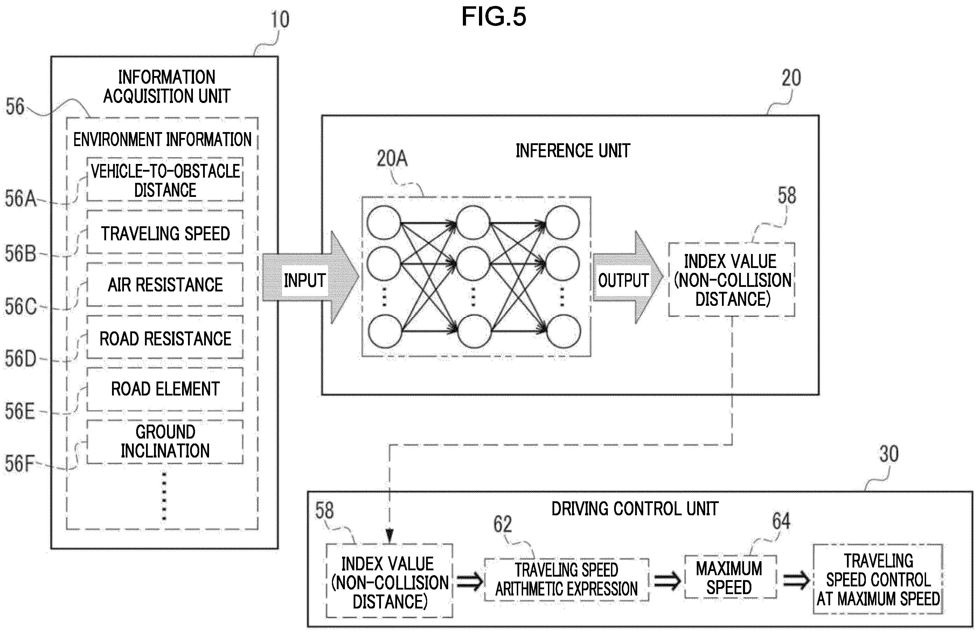

In the example shown in Fig. 4, the information processing device 1B is mounted on a vehicle 48. The inference unit 20 included in the information processing device 1B includes a deep learning model 20A. The deep learning model 20A is a trained model optimized by performing deep learning using a plurality of training data 50 on a neural network. The inference unit 20 uses the deep learning model 20A to infer a plurality of index values from environment information 56 (see Fig. 5).

The training data 50 is a data set including example data 52 and correct answer data 54. The example data 52 includes example environment information 52A. The example environment information 52A is information obtained by assuming the environment information 56 (see Fig. 5) acquired by the information acquisition unit 10. For example, the example environment information 52A is information including a vehicle-to-obstacle distance 52A1, a traveling speed 52A2, an air resistance 52A3, a road resistance 52A4, a road element 52A5, a ground inclination 52A6, and the like. Here, the air resistance 52A3 corresponds to the air resistance exemplified in the first embodiment, the road resistance 52A4 corresponds to the road resistance exemplified in the first embodiment, the road element 52A5 corresponds to the road element exemplified in the first embodiment, and the ground inclination 52A6 corresponds to the tilt exemplified in the first embodiment. The vehicle-to-obstacle distance 52A1 is a distance between the vehicle 48 and an obstacle in a traveling direction of the vehicle 48 (in the example shown in Fig. 4, a vehicle 53 immediately in front of the vehicle 48). The traveling speed 52A2 is a traveling speed of the vehicle 48.

The correct answer data 54 is correct answer data (that is, an annotation) for the example data 52. The correct answer data 54 has a correct answer distance 54A. The correct answer distance 54A is an example of a "first distance" according to the technology of the disclosure.

The correct answer distance 54A is a distance obtained by combining a required stop distance 54A1 and a margin distance 54A2. The required stop distance 54A1 is a distance required for the vehicle 48 to stop without colliding with the vehicle 53 between the vehicle 48 and the vehicle 53. The vehicle 53 is an obstacle in the traveling direction of the vehicle 48, and is traveling in front of the vehicle 48. In the example shown in Fig. 4, the vehicle 53 traveling in front of the vehicle 48 is exemplified, but the technology of the disclosure is not limited thereto, and an obstacle may be the vehicle 53 stopped in front of the vehicle 48, a pedestrian existing in front of the vehicle 48, or the like as long as an obstacle exists in the traveling direction of the vehicle 48.

The margin distance 54A2 is a distance (for example, a distance of about several meters) excessively determined in order to increase reliability for avoiding a collision between the vehicle 48 and the vehicle 53.

Fig. 5 is a conceptual diagram showing an example of processing content of the information acquisition unit 10, the inference unit 20, and the driving control unit 30 included in the information processing device 1B according to the third embodiment.

The information acquisition unit 10 acquires the environment information 56 in the same manner as in the first embodiment. The environment information 56 is information including a vehicle-to-obstacle distance 56A, a traveling speed 56B, an air resistance 56C, a road resistance 56D, a road element 56E, a ground inclination 56F, and the like.

The inference unit 20 inputs the environment information 56 acquired by the information acquisition unit 10 to the deep learning model 20A. As a result, the deep learning model 20A outputs an index value 58 corresponding to the environment information 56 (that is, an index value related to the correct answer distance 54A corresponding to the environment information 56). The inference unit 20 acquires the index value 58 output from the deep learning model 20A. The index value 58 is an index value inferred by the deep learning model 20A as a non-collision distance. The non-collision distance is, for example, a distance at which the vehicle 48 and an obstacle in the traveling direction of the vehicle 48 (in the example shown in Fig. 4, the vehicle 53) do not collide with each other. The index value 58 may be an index value obtained by performing multivariate analysis using the integration method described in the first embodiment. Note that the index value 58 is an example of a "first index value" according to the technology of the disclosure.

The driving control unit 30 calculates a maximum speed 62 at which the vehicle 48 does not collide with an obstacle (for example, a vehicle or a pedestrian existing in front of the vehicle 48) in the traveling direction from the index value 58 acquired by the inference unit 20 by using a traveling speed arithmetic expression 60. The traveling speed arithmetic expression 60 is an arithmetic expression having the index value 58 as an independent variable and the maximum speed 62 as a dependent variable. The maximum speed 62 is a maximum speed within a range of a legal speed or lower and a front vehicle speed or lower. The front vehicle speed is a traveling speed of another vehicle traveling in front of the vehicle 48 (for example, one preceding vehicle in the traveling direction of the vehicle 48). For example, the front vehicle speed is acquired by the information acquisition unit 10 or the like. The driving control unit 30 calculates the maximum speed 62 with reference to the front vehicle speed acquired by information acquisition unit 10 or the like.

The driving control unit 30 executes driving control of the vehicle on the basis of the plurality of index values inferred by the inference unit 20. The driving control includes traveling speed control. The traveling speed control is control of a traveling speed of the vehicle 48, and is executed on the basis of the index value 58. The traveling speed control includes control for causing the vehicle 48 to travel at the maximum speed 62. That is, the driving control unit 30 controls a drive system (for example, a power source that transmits power to the wheels) of the vehicle 48 so that the vehicle 48 travels at the maximum speed 62 calculated on the basis of the index value 58.

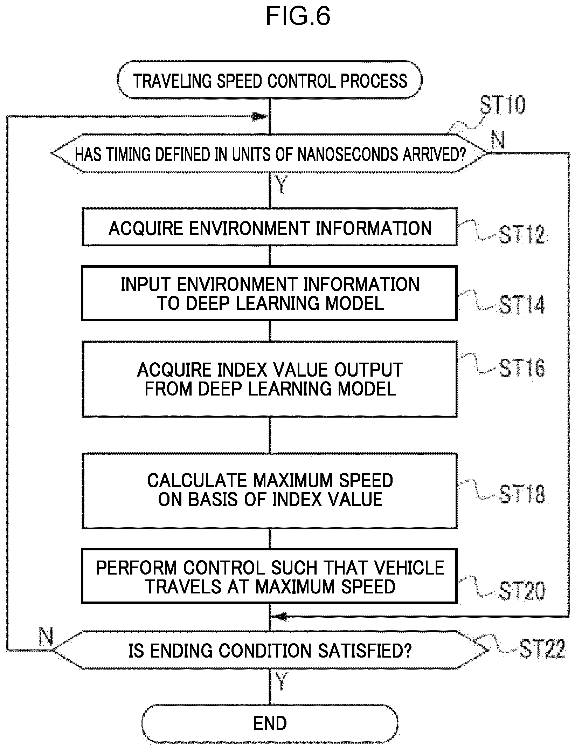

Fig. 6 is a flowchart showing an example of a flow of a traveling speed control process executed by the information processing device 1B.

In the traveling speed control process shown in Fig. 6, first, in step ST10, the information acquisition unit 10 determines whether or not a timing defined in units of nanoseconds has arrived (for example, whether or not a nanosecond has elapsed). In a case in which the timing defined in units of nanoseconds has not arrived in step ST10, the determination is negative, and the traveling speed control process proceeds to step ST22. In step ST10, in a case in which the timing defined in units of nanoseconds has arrived, the determination is positive, and the traveling speed control process proceeds to step ST12.

In step ST12, the information acquisition unit 10 acquires the environment information 56. After the process in step ST12 is executed, the traveling speed control process proceeds to step ST14.

In step ST14, the inference unit 20 inputs the environment information 56 acquired by the information acquisition unit 10 in step ST12 to the deep learning model 20A. In response to this, the deep learning model 20A outputs the index value 58 corresponding to the input environment information 56. After the process in step ST14 is executed, the traveling speed control process proceeds to step ST16.

In step ST16, the inference unit 20 acquires the index value 58 output from the deep learning model 20A. After the process in step ST16 is executed, the traveling speed control process proceeds to step ST18.

In step ST18, the driving control unit 30 calculates the maximum speed 62 from the index value 58 acquired by the inference unit 20 in step ST16 by using the traveling speed arithmetic expression 60. After the process in step ST18 is executed, the traveling speed control process proceeds to step ST20.

In step ST20, the driving control unit 30 controls the drive system of the vehicle 48 to cause the vehicle 48 to travel at the maximum speed 62 calculated in step ST18. After the process in step ST20 is executed, the traveling speed control process proceeds to step ST22.

In step ST22, the driving control unit 30 determines whether or not a condition for ending the traveling speed control process is satisfied. As an example of the condition for ending the traveling speed control process, there is a condition that an instruction to end the traveling speed control process is given to the information processing device 1B. In a case in which the condition for ending the traveling speed control process is not satisfied in step ST22, the determination is negative, and the traveling speed control process proceeds to step ST10. In a case in which the condition for ending the traveling speed control process is satisfied in step ST22, the determination is positive, and the traveling speed control process is ended.

As described above, in the third embodiment, the inference unit 20 infers the index value 58 related to the correct answer distance 54A including the required stop distance 54A1 required for the vehicle 48 to stop without colliding with an obstacle between the obstacle in the traveling direction of the vehicle 48 and the vehicle 48. The driving control unit 30 controls a traveling speed of the vehicle 48 on the basis of the index value 58. Therefore, the vehicle 48 can travel to a destination safely and in a short time.

In the third embodiment, the index value 58 is inferred in units of nanoseconds, and the maximum speed 62 is calculated on the basis of the index value 58. The maximum speed 62 is the maximum speed at which the vehicle 48 does not collide with an obstacle, and the driving control unit 30 controls the drive system of the vehicle 48 to cause the vehicle 48 to travel at the maximum speed 62. Therefore, the vehicle 48 can travel to a destination safely and in the shortest time.

In the third embodiment, the maximum speed 62 is calculated within a range of a legal speed or lower and a front vehicle speed or lower. Therefore, the vehicle 48 can travel to the destination safely and in the shortest time while complying with the legal speed.

In the third embodiment, a distance obtained by combining the required stop distance 54A1 and the margin distance 54A2 is used as the correct answer distance 54A. Therefore, the possibility of collision between the vehicle 48 and the vehicle 53 can be reduced compared with a case in which only the required stop distance 54A1 is used as the correct answer distance 54A.

In the third embodiment, the index value inferred as the non-collision distance by the deep learning model 20A has been exemplified as an example of the index value 58, but the technology of the disclosure is not limited thereto. For example, as the index value 58, an index value indicating the maximum speed 62 may be inferred by the deep learning model 20A. In this case, for example, the drive system of the vehicle 48 may be controlled by the driving control unit 30 so that the vehicle 48 travels at the maximum speed 62 indicated by the index value 58.

In the third embodiment, the example in which the maximum speed 62 is calculated has been described, but this is merely an example, and a speed higher than a designated speed and lower than the maximum speed 62 may be calculated. Instead of the speed, a rotational spin speed of a wheel may be calculated, and information regarding the speed (that is, a parameter used to control the speed of the vehicle 48) may be calculated.

In the third embodiment, the correct answer distance 54A is a distance obtained by combining the required stop distance 54A1 and the margin distance 54A2. However, this is merely an example, and only the required stop distance 54A1 may be used as the correct answer distance 54A.

(Fourth Embodiment)

In a fourth embodiment described below, an information processing device and the like capable of realizing highly accurate autonomous driving in consideration of an actual environment in which a vehicle travels and reaches a destination will be mainly described.

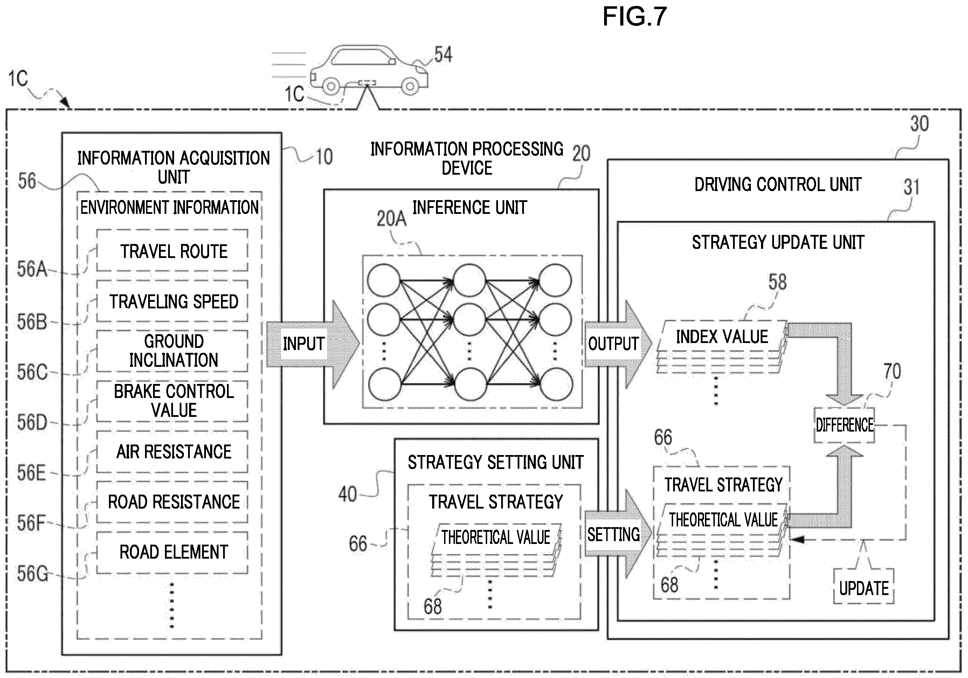

Fig. 7 is a conceptual diagram showing an example of a configuration of an information processing device 1C according to the fourth embodiment of the disclosure.

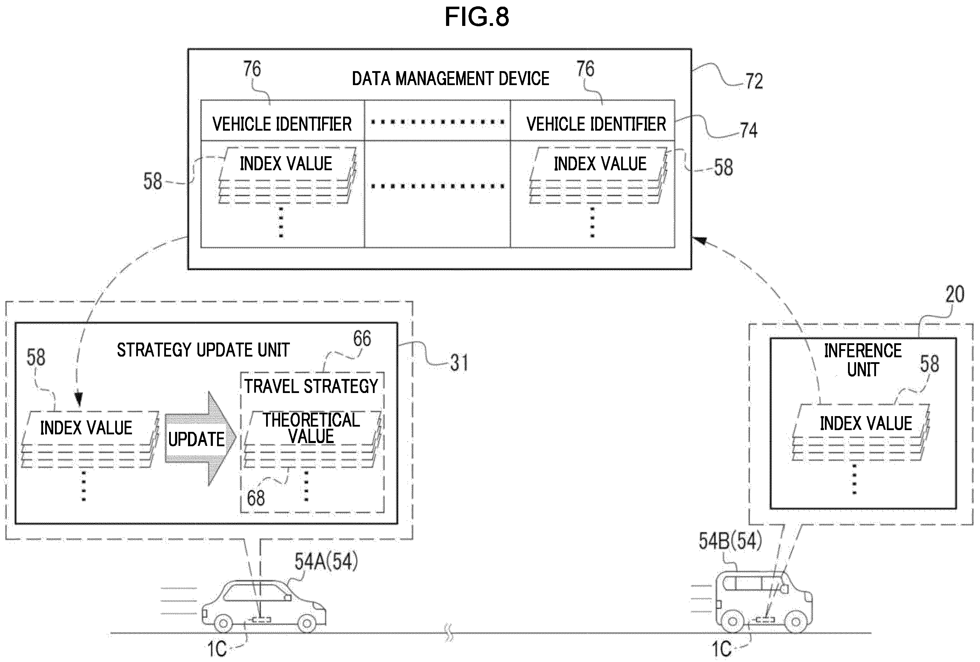

The information processing device 1C is mounted on a plurality of vehicles 54 (see also Fig. 8). Similarly to the first embodiment, the information processing device 1C includes an information acquisition unit 10, an inference unit 20, a driving control unit 30, and a strategy setting unit 40. The driving control unit 30 includes a strategy update unit 31. Although the strategy update unit 31 is shown as a part of the driving control unit 30 in the example shown in Fig. 7, this is merely an example, and the strategy update unit 31 may be provided outside the driving control unit 30.

The information acquisition unit 10 acquires the environment information 56 in the same manner as in the first embodiment. The environment information 56 is information including a travel route 56A which is a route on which the vehicle 54 travels (for example, a route on which the vehicle 54 travels, the route being defined by coordinates), a traveling speed 56B which is a speed at which the vehicle 54 is traveling, a ground inclination 56C corresponding to the tilt described in the first embodiment, a brake control value 56D (in other words, a parameter for controlling the brake), an air resistance 56E, a road resistance 56F, a road element 56G, and the like.

The inference unit 20 includes a deep learning model 20A. The deep learning model 20A is a trained model optimized by performing deep learning using a plurality of training data on a neural network. The inference unit 20 uses the deep learning model 20A to infer a plurality of index values from the environment information 56.

The training data used for performing deep learning on the deep learning model 20A is a data set including example data and correct answer data (that is, an annotation) for the example data. The example data is data obtained by assuming the environment information 56, and the correct answer data is data obtained by assuming a plurality of index values 58.

The inference unit 20 inputs the environment information 56 acquired by the information acquisition unit 10 to the deep learning model 20A. As a result, the deep learning model 20A outputs a plurality of index values 58 (that is, a plurality of control values used for autonomous driving control of the vehicle 54) corresponding to the environment information 56.

The strategy update unit 31 acquires the plurality of index values 58 output from the deep learning model 20A. The strategy setting unit 40 sets a travel strategy 66 until the vehicle 54 reaches a destination. Here, the setting of the travel strategy 66 indicates, for example, a process of assigning the travel strategy 66 to the strategy update unit 31.

The travel strategy 66 includes a plurality of theoretical values 68. The plurality of theoretical values 68 include a theoretical value of a route (for example, a route assumed as a route on which the vehicle 54 travels, the route being defined by coordinates) until the vehicle 54 reaches the destination, a theoretical value of a traveling speed until the vehicle 54 reaches the destination, a theoretical value of an inclination of the ground until the vehicle 54 reaches the destination, and a theoretical value of a brake control value until the vehicle 54 reaches the destination.

The strategy update unit 31 updates the travel strategy 66 on the basis of the travel strategy 66 set by the strategy setting unit 40 and the plurality of index values 58 output from the inference unit 20. For example, the strategy update unit 31 updates the travel strategy 66 by updating the plurality of theoretical values 68 on the basis of differences 70 between the plurality of theoretical values 68 and the plurality of index values 58 included in the travel strategy 66.

The update of the theoretical value 68 indicates, in other words, derivation of an optimal solution. A first example of the optimal solution is an index value 58 used instead of the theoretical value 68. A second example of the optimal solution is an adjusted index value 58 used instead of the theoretical value 68. A third example of the optimal solution is a solution obtained by performing regression analysis using at least one theoretical value 68 and at least one index value 58. A fourth example of the optimal solution is a statistical value (for example, a median value and/or an average value) obtained from the theoretical value 68 and the index value 58. Which of the first to fourth examples is derived as an optimal solution by the strategy update unit 31 may be determined according to a magnitude of the difference 70, for example. An optimal solution is not limited to the first to fourth examples, and may be an optimal solution obtained by using other methods.

Here, the differences 70 between the plurality of theoretical values 68 and the plurality of index values 58 include a difference between the theoretical value 68 and the index value 58 for each of a plurality of items (for example, a route until the vehicle 54 reaches a destination, a traveling speed until the vehicle 54 reaches the destination, an inclination of the ground until the vehicle 54 reaches the destination, and a brake control value until the vehicle 54 reaches the destination).

Note that the difference 70 is an example of "a result of comparing a plurality of theoretical values with a plurality of index values" according to the technology of the disclosure. Although the difference 70 is exemplified here, this is merely an example, and a difference may be, for example, a ratio of the other to one of the theoretical value 68 and the index value 58, or any value that can specify the degree of difference between a plurality of theoretical values and a plurality of index values.

The driving control unit 30 executes driving control of the vehicle 54 according to the travel strategy 66 (for example, a plurality of updated theoretical values 68) updated by the strategy update unit 31.

Fig. 8 is a conceptual diagram showing an example of a mode in which the travel strategy 66 of a first vehicle 54A among the plurality of vehicles 54 on which the information processing device 1C according to the fourth embodiment of the disclosure is mounted is updated on the basis of the plurality of index values 58 inferred by the second vehicle 54B.

The first vehicle 54A and a second vehicle 54B are traveling toward the same destination, and the second vehicle 54B precedes the first vehicle 54A with respect to the destination. That is, the second vehicle 54B arrives at the destination earlier than the first vehicle 54A.

Data regarding the plurality of vehicles 54 is collected and managed by a data management device 72. The data management device 72 is wirelessly communicatively connected to the plurality of information processing devices 1C mounted on the plurality of vehicles 54. An example of the data management device 72 is a server.

The data management device 72 constructs a database 74 on the basis of various types of information obtained from the information processing devices 1C of the respective vehicles 54. The database 74 includes a vehicle identifier 76 that is an identifier that can identify the vehicle 54 and a plurality of index values 58. In the database 74, a vehicle identifier 76 and a plurality of index values 58 (that is, the plurality of index values 58 inferred by the inference unit 20 included in the information processing device 1C of the vehicle 54 specified from the corresponding vehicle identifier 76) are associated with each vehicle 54.

Before the first vehicle 54A reaches the destination and while the first vehicle 54A is traveling, the strategy update unit 31 included in the information processing device 1C of the first vehicle 54A (hereinafter, referred to as a "strategy update unit 31 of the first vehicle 54A") acquires, from the data management device 72, a plurality of index values 58 inferred by the inference unit 20 included in the information processing device 1C of the second vehicle 54B (hereinafter, referred to as an "inference unit 20 of the second vehicle 54B").

For example, in response to a request from the strategy update unit 31 of the first vehicle 54A, the data management device 72 acquires a plurality of index values 58 corresponding to the second vehicle 54B from the database 74, and transmits the plurality of index values 58 acquired from the database 74 to the strategy update unit 31 of the first vehicle 54A. The strategy update unit 31 of the first vehicle 54A receives the plurality of index values 58 transmitted from the data management device 72, and updates the travel strategy 66 on the basis of the received plurality of index values 58.

For example, the travel strategy 66 is updated by updating the plurality of theoretical values 68 on the basis of a result of comparing the plurality of theoretical values 68 included in the travel strategy 66 with the plurality of received index values 58. Here, the theoretical value 68 may be updated, for example, in the same manner as in the first to fourth examples described above.

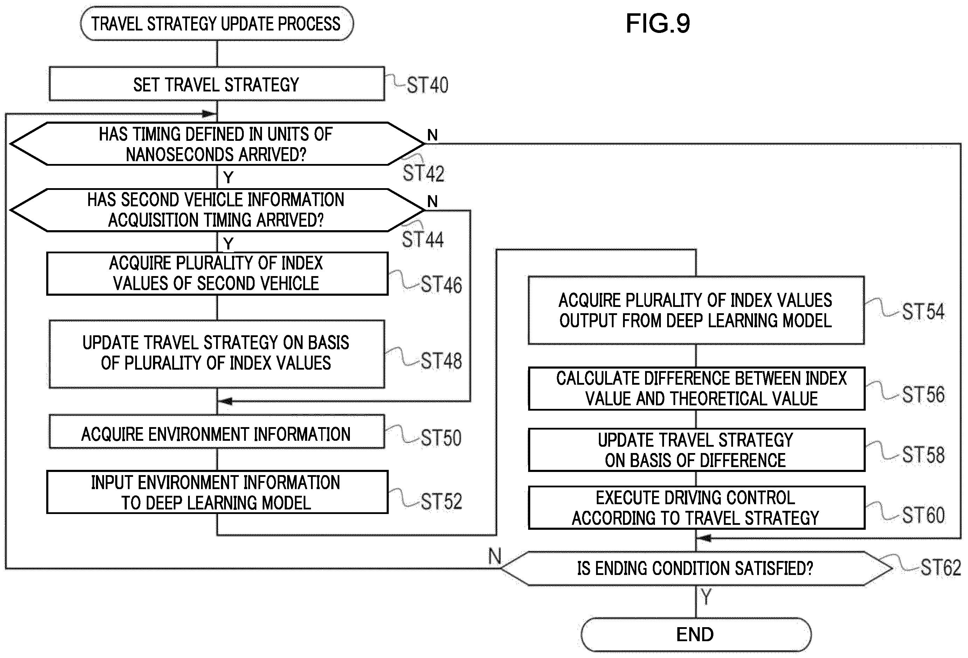

Fig. 9 is a flowchart showing an example of a flow of a travel strategy update process executed by the information processing device 1C of the first vehicle 54A.

In the travel strategy update process shown in Fig. 9, in step ST30, the strategy setting unit 40 sets the travel strategy 66 for the strategy update unit 31. After the process in step ST30 is executed, the travel strategy update process proceeds to step ST32.

In step ST32, the strategy update unit 31 determines whether or not a timing defined in units of nanoseconds has arrived (for example, whether or not a nanosecond has elapsed). In a case in which the timing defined in units of nanoseconds has not arrived in step ST32, the determination is negative, and the travel strategy update process proceeds to step ST32. In a case in which the timing defined in units of nanoseconds has arrived in step ST32, the determination is positive, and the travel strategy update process proceeds to step ST34.

In step ST34, the strategy update unit 31 determines whether or not a second vehicle information acquisition timing has arrived. The second vehicle information acquisition timing is a timing at which the strategy update unit 31 acquires the plurality of index values 58 inferred by the inference unit 20 of the second vehicle 54B. A first example of the second vehicle information acquisition timing is a timing that satisfies a condition that the index value 58 related to the second vehicle 54B has been updated, the index value 58 being stored in the database 74. A second example of the second vehicle information acquisition timing is a timing that satisfies a condition that a predetermined time (for example, several seconds) has elapsed since the process in step ST32 was executed.

In step ST34, in a case in which the second vehicle information acquisition timing has not arrived, the determination is negative, and the travel strategy update process proceeds to step ST40. In a case in which the second vehicle information acquisition timing has arrived in step ST34, the determination is positive, and the travel strategy update process proceeds to step ST36.

In step ST36, the strategy update unit 31 acquires a plurality of index values 58 related to the second vehicle 54B (that is, the plurality of index values 58 associated with the vehicle identifier 76 that can specify the second vehicle 54B) from the data management device 72. After the process in step ST36 is executed, the travel strategy update process proceeds to step ST38.

In step ST38, the strategy update unit 31 updates the travel strategy 66 on the basis of the plurality of index values 58 acquired from the data management device 72 in step ST36. That is, the plurality of theoretical values 68 included in the travel strategy 66 are updated on the basis of the plurality of index values 58 acquired from the data management device 72. After the process in step ST38 is executed, the travel strategy update process proceeds to step ST40.

In step ST40, the information acquisition unit 10 acquires the environment information 56. After the process in step ST32 is executed, the travel strategy update process proceeds to step ST42.

In step ST42, the inference unit 20 inputs the environment information 56 acquired by the information acquisition unit 10 in step ST40 to the deep learning model 20A. In response to this, the deep learning model 20A outputs the index value 58 corresponding to the input environment information 56. After the process in step ST42 is executed, the travel strategy update process proceeds to step ST44.

In step ST44, the strategy update unit 31 acquires a plurality of index values 58 output from the deep learning model 20A. After the process in step ST44 is executed, the travel strategy update process proceeds to step ST46.

In step ST46, the strategy update unit 31 calculates the differences 70 between the plurality of index values 58 and the plurality of theoretical values 68 included in the travel strategy 66. After the process in step ST46 is executed, the travel strategy update process proceeds to step ST48.

In step ST48, the strategy update unit 31 updates the travel strategy 66 by updating the plurality of theoretical values 68 included in the travel strategy 66 on the basis of the differences 70 calculated in step ST46. After the process in step ST48 is executed, the travel strategy update process proceeds to step ST50.

In step ST50, the driving control unit 30 executes driving control of the vehicle 54 according to the travel strategy 66 updated in step ST48. After the process in step ST40 is executed, the travel strategy update process proceeds to step ST42.

In step ST52, the strategy update unit 31 determines whether or not a condition for ending the travel strategy update process is satisfied. As an example of the condition for ending the travel strategy update process, there is a condition that an instruction to end the travel strategy update process is given to the information processing device 1C. In a case in which the condition for ending the travel strategy update process is not satisfied in step ST52, the determination is negative, and the travel strategy update process proceeds to step ST32. In a case in which the condition for ending the travel strategy update process is satisfied in step ST52, the determination is positive, and the travel strategy update process is ended.

As described above, in the fourth embodiment, the information processing device 1C is mounted on a plurality of vehicles 54 including the first vehicle 54A and the second vehicle 54B, and the information processing device 1C includes the information acquisition unit 10, the inference unit 20, the driving control unit 30, the strategy update unit 31, and the strategy setting unit 40 described in the first and second embodiments. Before the first vehicle 54A reaches a destination, the strategy update unit 31 updates the travel strategy 66 set by the strategy setting unit 40 on the basis of the plurality of index values 58 inferred by the inference unit 20 of the second vehicle 54B preceding the first vehicle 54A with respect to the destination. As a result, the information processing device 1C of the first vehicle 54A can obtain the travel strategy 66 according to an actual environment until reaching the destination. As a result, it is possible to realize highly accurate autonomous driving in consideration of the actual environment until the first vehicle 54A travels to reach the destination.

In the fourth embodiment, the plurality of index values 58 (that is, the plurality of index values 58 inferred by the inference unit 20 of the second vehicle 54B) used for updating the travel strategy 66 are acquired by the strategy update unit 31 of the first vehicle 54A before the first vehicle 54A reaches the destination and while the first vehicle 54A is traveling. Therefore, before first vehicle 54A travels to reach the destination and while first vehicle 54A is traveling, it is possible to realize highly accurate autonomous driving in consideration of the actual environment until first vehicle 54A travels to reach the destination.

In the fourth embodiment, the plurality of index values 58 (that is, the plurality of index values 58 inferred by the inference unit 20 of the second vehicle 54B) used for updating the travel strategy 66 are acquired by the strategy update unit 31 of the first vehicle 54A before the second vehicle 54B reaches the destination. Therefore, compared with a case in which the plurality of index values 58 inferred by the inference unit 20 of the second vehicle 54B are acquired by the strategy update unit 31 of the first vehicle 54A after the second vehicle 54B reaches the destination, the strategy update unit 31 of the first vehicle 54A can update the travel strategy 66 earlier.

In the fourth embodiment, before the first vehicle 54A reaches the destination, the strategy update unit 31 updates the plurality of theoretical values 68 included in the travel strategy 66 set by the strategy setting unit 40 on the basis of the plurality of index values 58 inferred by the inference unit 20 of the second vehicle 54B preceding the first vehicle 54A with respect to the destination. The driving control unit 30 of the first vehicle 54A executes driving control of the first vehicle 54A according to the plurality of theoretical values 68 updated by the strategy update unit 31. As a result, compared with a case in which the plurality of theoretical values 68 included in the travel strategy 66 are always constant, it is possible to realize highly accurate autonomous driving in consideration of the actual environment until the first vehicle 54A travels to reach the destination.

In the fourth embodiment, the data management device 72 collects and manages a plurality of index values 58 from a plurality of vehicles 54. The strategy update unit 31 of the first vehicle 54A updates the travel strategy 66 on the basis of the plurality of index values 58 acquired from the data management device 72. Therefore, the driving control unit 30 can execute the autonomous driving of the first vehicle 54A according to the travel strategy 66 updated on the basis of the plurality of index values 58 obtained from the designated vehicle 54 (for example, the second vehicle 54B) among the plurality of vehicles 54.

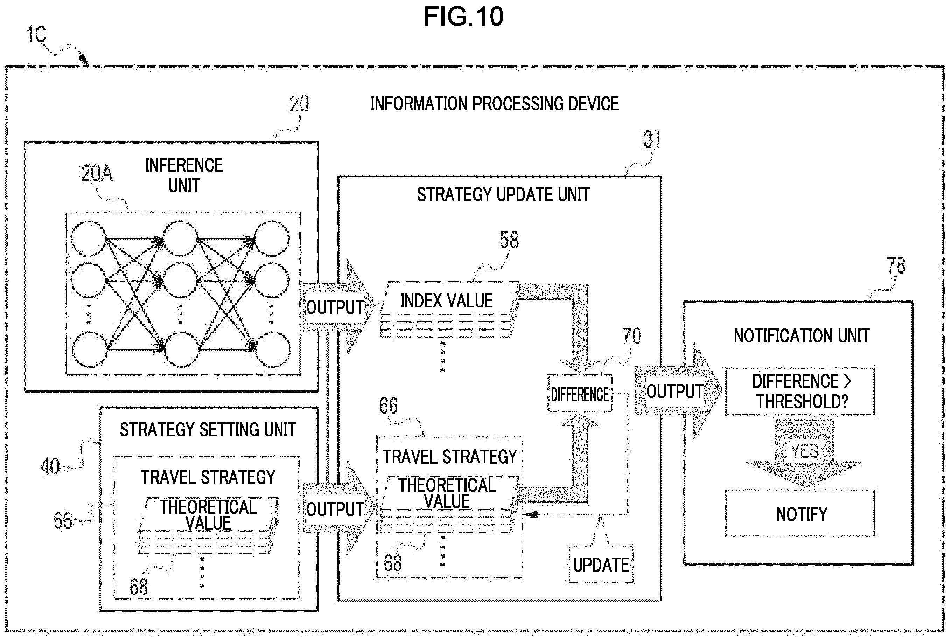

In the fourth embodiment, the form example in which the difference 70 is used for updating the travel strategy 66 has been described, but an application of the difference 70 is not limited thereto. For example, as shown in Fig. 10, the information processing device 1C may further include a notification unit 78, and the notification unit 78 may provide a notification according to the difference 70. For example, the notification unit 78 determines whether or not the difference 70 exceeds a threshold, and notifies that the difference 70 exceeds the threshold in a case in which the difference 70 exceeds the threshold. The threshold may be a fixed value (for example, a default value) or a variable value that is changed in accordance with an instruction given from a user or the like to the information processing device 1C. The notification is realized by, for example, visible display using a display and/or sound output using a sound reproducing device.

The notification need not be provided every time the difference 70 is calculated, and the notification may be provided in a case in which the number of times the difference 70 exceeds the threshold (for example, the number of times the difference 70 has continuously exceeded the threshold) exceeds a predetermined number of times (for example, the number of times determined in accordance with an instruction given from the user or the like to the information processing device 1C), or the notification may be provided in a case in which the number of times the difference 70 exceeds the threshold within a predetermined period (for example, a period determined in accordance with an instruction given from the user or the like to the information processing device 1C) exceeds a predetermined number of times.

The difference 70 used for comparison with the threshold may be a difference between the theoretical value 68 and the index value 58 for one item among a plurality of items (for example, a route until the vehicle 54 reaches a destination, a traveling speed until the vehicle 54 reaches the destination, an inclination of the ground until the vehicle 54 reaches the destination, and a brake control value until the vehicle 54 reaches the destination), or may be a difference between the theoretical value 68 and the index value 58 for each of the plurality of items.

**In** each of the above embodiments, a difference (for example, difference 70) between the theoretical value 68 and the index value 58 has been exemplified, but this is merely an example, and a value that can specify a result of comparing the theoretical value 68 with the index value 58. Examples of the value that can specify a result of comparing the theoretical value 68 with the index value 58 include, in addition to the difference, a ratio of the other to one of the theoretical value 68 and the index value 58.

In the fourth embodiment, the form example has been described in which the strategy update unit 31 of the first vehicle 54A acquires a plurality of index values 58 corresponding to the second vehicle 54B before the second vehicle 54B reaches a destination, but this is merely an example. For example, the strategy update unit 31 of the first vehicle 54A may acquire a plurality of index values 58 corresponding to the second vehicle 54B after the second vehicle 54B reaches the destination.

In the fourth embodiment, the form example has been described in which the strategy update unit 31 of the first vehicle 54A acquires a plurality of index values 58 corresponding to the second vehicle 54B from the data management device 72, but the technology of the disclosure is not limited thereto. For example, the strategy update unit 31 of the first vehicle 54A may acquire a plurality of index values 58 inferred by the inference unit 20 from the information processing device 1C of the second vehicle 54B by performing direct communication between the information processing device 1C of the first vehicle 54A and the information processing device 1C of the second vehicle 54B. For example, every time the index value 58 is inferred by the inference unit 20 of the second vehicle 54B (for example, every time index value 58 corresponding to the second vehicle 54B is updated in the data management device 72), the index value 58 inferred by the inference unit 20 of the second vehicle 54B may be acquired by the strategy update unit 31 of the first vehicle 54A and used for updating the travel strategy 66.

In the fourth embodiment described above, the form example has been described in which the plurality of theoretical values 68 include a theoretical value of a route until the vehicle 54 reaches a destination, a theoretical value of a traveling speed until the vehicle 54 reaches the destination, a theoretical value of an inclination of the ground until the vehicle 54 reaches the destination, and a theoretical value of a brake control value until the vehicle 54 reaches the distribution, but this is merely an example. For example, the plurality of theoretical values 68 may include at least one of a theoretical value of a route until the vehicle 54 reaches a destination, a theoretical value of a traveling speed until the vehicle 54 reaches the destination, a theoretical value of an inclination of the ground until the vehicle 54 reaches the destination, and a theoretical value of a brake control value until the vehicle 54 reaches the destination.

In the fourth embodiment, the form example has been described in which while the first vehicle 54A is traveling, the plurality of index values 58 used for updating the travel strategy 66 are acquired by the strategy update unit 31 of the first vehicle 54A, but the technology of the disclosure is not limited thereto. For example, a plurality of index values 58 used for updating the travel strategy 66 may be acquired by the strategy update unit 31 of the first vehicle 54A before the first vehicle 54A reaches the destination and while the first vehicle 54A stops. As a result, even in a case in which the first vehicle 54A stops before reaching the destination, it is possible to realize highly accurate autonomous driving in consideration of an actual environment until the first vehicle 54A travels to reach the destination.

In the fourth embodiment, the form example has been described in which the index value 58 inferred by the inference unit 20 of the second vehicle 54B is directly used for updating the travel strategy 66 of the first vehicle 54A, but this is merely an example. For example, the index value 58 (that is, the index value 58 inferred by the inference unit 20 of the second vehicle 54B) may be adjusted according to an adjustment value (for example, a weight) determined according to the reliability with respect to the index value 58 inferred by the inference unit 20 of the second vehicle 54B, and the theoretical value 68 may be updated on the basis of the adjusted index value 58 as in the fourth embodiment.

For example, the reliability of the index value 58 inferred by the inference unit 20 of the second vehicle 54B differs, in a case in which the first vehicle 54A and the second vehicle 54B pass through the same point (hereinafter, referred to as a "first point"), depending on a time interval between a time point at which the index value 58 is inferred by the inference unit 20 of the second vehicle 54B at the time of traveling through the first point and a time point at which the first vehicle 54A travels through the first point. For example, the longer the time interval between the time point at which the index value 58 is inferred by the inference unit 20 of the second vehicle 54B at the time of traveling through the first point and the time point at which the first vehicle 54A travels through the first point, the lower the reliability of the index value 58 inferred by the inference unit 20 of the second vehicle 54B. Conversely, the shorter the time interval between the time point at which the index value 58 is inferred by the inference unit 20 of the second vehicle 54B at the time of traveling through the first point and the time point at which the first vehicle 54A travels through the first point, the higher the reliability of the index value 58 inferred by the inference unit 20 of the second vehicle 54B.

Therefore, when the theoretical value 68 is updated, as the time interval is longer, the strategy update unit 31 of the first vehicle 54A adjusts the index value 58 by using an adjustment value that reduces the influence of the index value 58 (for example, the index value 58 inferred by the inference unit 20 of the second vehicle 54B at the time of traveling through the first point) on the theoretical value 68, and updates the theoretical value 68 on the basis of the adjusted index value 58. When the theoretical value 68 is updated, as the time interval is shorter, the strategy update unit 31 of the first vehicle 54A adjusts the index value 58 by using an adjustment value that increases the influence of the index value 58 (for example, the index value 58 inferred by the inference unit 20 of the second vehicle 54B at the time of traveling through the first point) on the theoretical value 68, and updates the theoretical value 68 on the basis of the adjusted index value 58.

Here, the time interval between a time point at which the index value 58 is inferred by the inference unit 20 of the second vehicle 54B at the time of traveling through the first point and a time point at which the first vehicle 54A travels through the first point is exemplified, but this is merely an example. For example, the index value 58 (that is, the index value 58 inferred by the inference unit 20 of the second vehicle 54B) may be adjusted according to an adjustment value (for example, a weight) determined according to a difference between an external environment in a case in which the second vehicle 54B travels through the first point and an external environment in a case in which the first vehicle 54A travels through the first point, and the theoretical value 68 may be updated on the basis of the adjusted index value 58 in the same manner as in the fourth embodiment.

In this case, for example, in a case in which the external environment when the second vehicle 54B travels through the first point and the external environment when the first vehicle 54A travels through the first point are exactly the same, an adjustment value is unnecessary (that is, adjustment of the index value 58 is unnecessary). The index value 58 (that is, the index value 58 inferred by the inference unit 20 of the second vehicle 54B) may be adjusted with a larger adjustment value as the degree of difference between the external environment in a case in which the second vehicle 54B travels through the first point and the external environment in a case in which the first vehicle 54A travels through the first point becomes larger, and the theoretical value 68 may be updated on the basis of the adjusted index value 58 in the same manner as in the fourth embodiment.

The external environment is an environment outside the vehicle 54. Examples of the external environment include weather conditions. The weather conditions include, for example, the degree of rainfall, the degree of snowfall, the temperature of the outside air, the humidity of the outside air, a wind speed, and/or a wind direction. The degree of difference between the external environment in a case in which the second vehicle 54B travels through the first point and the external environment in a case in which the first vehicle 54A travels through the first point may be specified, for example, from the degree of difference (for example, a difference or a ratio) between a weather condition related index value (that is, the index value 58 related to a weather condition) inferred by the inference unit 20 of the first vehicle 54A and a weather condition related index value inferred by the inference unit 20 of the second vehicle 54B.

(Fifth Embodiment)

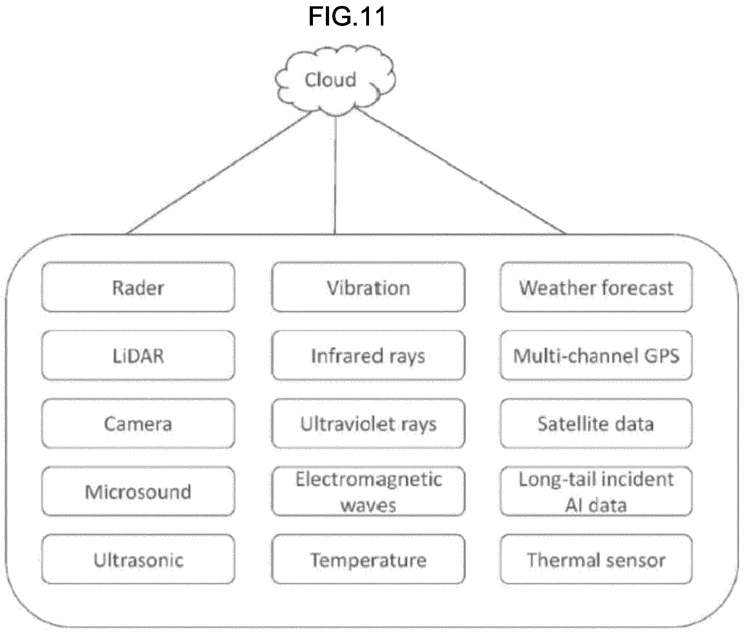

Fig. 11 schematically shows risk prediction capability of AI in ultra-high performance autonomous driving according to a fifth embodiment of the disclosure. In the embodiment, a plurality of types of sensor information from a plurality of types of sensors as detection units are converted into AI data and accumulated in a cloud. The AI predicts and determines the best mix of situations every nanosecond and optimizes an operation of a vehicle 2012.

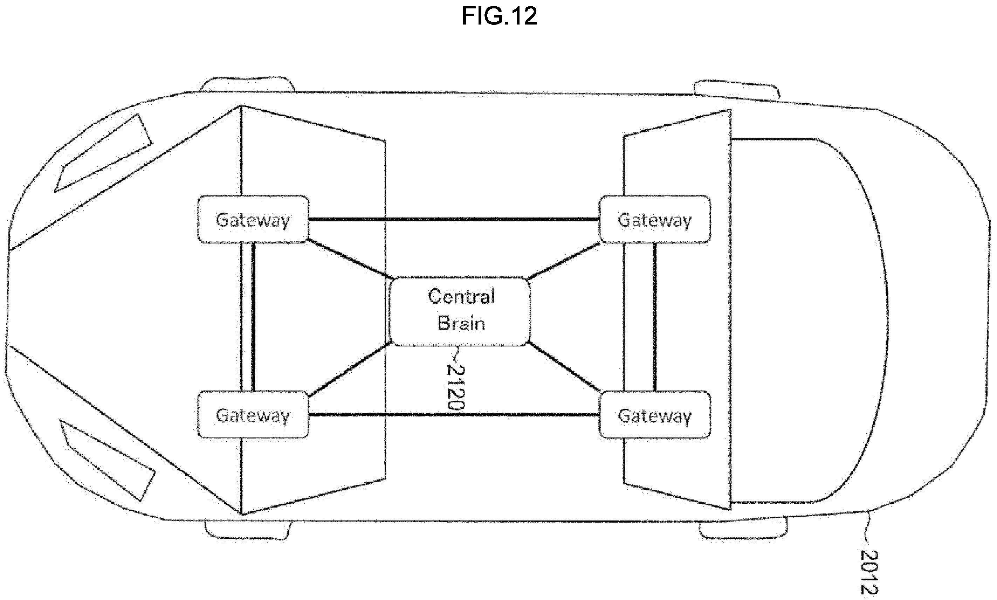

Fig. 12 is a schematic diagram showing an example of the vehicle 2012 on which a central brain 120 is mounted. The central brain 2120 may be an example of an information processing device 1D according to the embodiment. As shown in Fig. 12, in the central brain 2120, a plurality of gateways may be communicatively connected. The central brain 2120 according to the embodiment can realize autonomous driving at Level 6 on the basis of a plurality of information acquired via the gateways. The central brain 2120 is an example of an information processing device.

As shown in Fig. 12, a plurality of gateways are communicatively connected to the central brain 2120. The central brain 2120 is connected to an external cloud via the gateway. The central brain 2120 is configured to be able to access an external cloud via the gateway. On the other hand, due to the presence of the gateway, the central brain 2120 is configured to be not able to be directly accessed from the outside.

The central brain 2120 outputs a request signal to a server every time a prescribed time elapses. Specifically, the central brain 2120 outputs a request signal indicating an inquiry to the server every nanosecond.

Examples of the sensor provided in the vehicle 2012 used in the embodiment include a radar, a LiDAR, a high-pixel/telephoto/ultra-wide angle/360 degrees/high-performance camera, vision recognition, microsound, ultrasonic, vibration, infrared, ultraviolet, electromagnetic wave, temperature, humidity, spot AI weather forecast, high-precision multi-channel GPS, low-altitude satellite information, and long tail incident AI data. The long tail incident AI data is trip data of an automobile in which a function capable of realizing autonomous driving at Level 5 is installed.

The sensor includes a sensor that detects a surrounding situation of the vehicle. The sensor that detects a surrounding situation of the vehicle detects the surrounding situation of the vehicle in a second cycle shorter than a first cycle in which the surroundings of the vehicle are captured by a camera or the like as a cycle of detecting the surrounding situation of the vehicle.

Examples of the sensor information incorporated from the plurality of types of sensors include movement of the centroid of the weight, a material of a road, the outside air temperature, the outside air humidity, vertical and lateral inclination angles of a slope, freezing of a road, a moisture amount, a material of each tire, a wear situation, an air pressure, a road width, the presence or absence of passing prohibition, the vehicle type information of an oncoming vehicle and front and rear vehicles, cruising states of these vehicles, and surrounding situations (birds, animals, soccer balls, accident vehicles, earthquakes, fire, winds, typhoons, heavy rain, light rain, snowstorm, fog, and the like). In the embodiment, detection of such information is performed every nanosecond.

The central brain 2120 functioning as an example of the information processing device according to the embodiment includes at least respective functions of an acquisition unit capable of acquiring a plurality of information related to a vehicle, a calculation unit that calculates a control variable from the plurality of information acquired by the acquisition unit, and a control unit that executes driving control of the vehicle on the basis of the control variable.

For example, the central brain 2120 functions to calculate a wheel speed and an inclination of each of four wheels of the vehicle, and control variables for controlling the wheel speed, the inclination, and a suspension for each suspension that supports the wheel by using one or more sensor information detected by the above sensors. Inclinations of the wheel include both an inclination of the wheel with respect to an axis horizontal to the road and an inclination of the wheel with respect to an axis vertical to the road.

Here, as the one or more sensor information, sensor information from a sensor that detects a surrounding situation of the vehicle can be applied. In a case in which a plurality of sensor information are used as one or more sensor information, a predetermined number of sensor information may be applied. The predetermined number is, for example, three. Index values for controlling the wheel speed, the inclination, and the suspension are calculated on the basis of three sensor information. The number of index values calculated from a combination of the three sensor information is, for example, three. The index values for controlling the wheel speed, the inclination, and the suspension include, for example, an index value calculated from information regarding an air resistance in the sensor information, an index value calculated from information regarding a road resistance in the sensor information, and an index value calculated from information regarding a slip coefficient in the sensor information.

The index values calculated for each piece of sensor information or each of different combinations of a plurality of sensor information are aggregated to calculate control variables for controlling the wheel speed, the inclination, and the suspension. For example, an index value is calculated from sensor information of a sensor that detects a surrounding situation of the vehicle, and a control variable is calculated. In a case in which a plurality of sensor information are used, for example, a plurality of index values are calculated from a combination of sensors 1, 2, and 3, a plurality of index values are calculated from a combination of sensors 4, 5, and 6, a plurality of index values are calculated from a combination of the sensors 1, 3, and 7, and control variables are calculated by aggregating the index values. As described above, a predetermined number, for example, 300 index values are calculated while changing a combination of sensor information, and a control variable is calculated. Specifically, the calculation unit may be capable of calculating a control variable from sensor information by using machine learning, more specifically, deep learning. **In** other words, the calculation unit that calculates an index value and a control variable may be configured by artificial intelligence (AI).

The calculation unit can obtain an accurate control variable by performing multivariate analysis (see, for example, Formula (2)) according to an integration method as shown in the following Formula (1) on data collected every nanosecond from many sensor groups and the like by using the calculation power at Level 6. More specifically, while obtaining an integral value of delta values of various ultra-high resolutions with the calculation power at Level 6, an index value of each variable is obtained at an edge level and in real time, and a result occurring in the next nanosecond can be obtained as the highest probability theoretical value.

[Math. 1]

$$\mathrm{V} = \int_a^b f(A)dt$$

[Math. 2]

$$V_n = DL(f(A,B,C,D,\ldots,N)(dA_n/dt))$$

DL in the formula indicates deep learning, and A, B, C,..., and N are index values calculated from sensor information, and indicate, for example, an index value calculated from an air resistance, an index value calculated from a road resistance, an index value calculated from a road element, and an index value calculated from a slip coefficient. In a case in which the number of index values calculated while changing a combination of the predetermined number of sensor information is 300, the number of index values of A to N in the formula is also 300, and 300 index values are aggregated.

Although the wheel speed (V) is calculated in the above Formula (2), control variables for controlling an inclination (a steering angle or a camber angle) and a suspension are similarly calculated.

More specifically, regarding an inclination (steering angle R), an accurate control variable can be obtained by performing multivariate analysis (for example, see Formula (4)) according to an integration method as shown in Formula (3) below.

[Math. 3]

$$\mathrm{R} = \int_a^b f(A)dt$$

[Math. 4]

$$R_n = DL(f(A,B,C,D,\ldots,N)(dA_n/dt))$$

Regarding an inclination (camber angle C), an accurate control variable can be obtained by performing multivariate analysis (for example, see Formula (6)) according to an integration method as shown in Formula (5) below.

[Math. 5]

$$C = \int_a^b f(A)dt$$

[Math. 6]

$$C_n = DL(f(A,B,C,D,\ldots,N)(dA_n/dt))$$

Regarding a suspension S, an accurate control variable can be obtained by performing multivariate analysis (for example, see Formula (8)) according to an integration method as shown in Formula (7) below.

[Math. 7]

$$S = \int_a^b f(A)dt$$

[Math. 8]

$$S_n = DL(f(A,B,C,D,\ldots,N)(dA_n/dt))$$

Specifically, the central brain 2120 calculates a total of 16 control variables for controlling wheel speeds of the respective four wheels, inclinations (steering angles or camber angles) of the respective four wheels with respect to the axis horizontal to the road, inclinations (steering angles or camber angles) of the respective four wheels with respect to the axis vertical to the road, and suspensions supporting the respective four wheels. **In** the embodiment, the above-described 16 control variables are calculated every nanosecond. The wheel speed of each of the four wheels may also be referred to as a "rotational speed of the in-wheel motor mounted on each of the four wheels". The inclination (steering angle) of each of the four wheels with respect to the axis horizontal to the road may also be referred to as a "horizontal angle of each of the four wheels".

The inclination (camber angle) of each of the four wheels with respect to the axis vertical to the road may be referred to as a "vertical angle of each of the four wheels". The suspension (a coil spring or a shock absorber) that determines a position of the wheel with respect to the road may be referred to as an "attenuation amount that absorbs the impact received from the road in each of the four wheels".

For example, in a case in which the vehicle travels on a mountain road, the control variable has a numerical value for performing optimum steering in accordance with the mountain road, and in a case in which the vehicle is parked in a parking lot, the control variable has a numerical value for traveling at an optimum angle in accordance with the parking lot.

In the embodiment, the central brain 2120 calculates a total of 16 control variables for controlling wheel speeds of the respective four wheels, inclinations (steering angles) of the respective four wheels with respect to the axis horizontal to the road, inclinations (camber angles) of the respective four wheels with respect to the axis vertical to the road, and suspensions supporting the respective four wheels. However, this calculation does not need to be performed by the central brain 2120, and a dedicated anchor chip for calculating the control variables may be separately provided. Also in this case, DL in Formula (2) represents deep learning, and A, B, C,..., and N represent index values calculated from sensor information. In a case in which the number of indexes to be aggregated is 300 as described above, the number of indexes in such a formula is also 300.

In the embodiment, the central brain 2120 functions as a control unit that controls autonomous driving in units of nanoseconds on the basis of the control variables calculated above. Specifically, the central brain 2120 controls the in-wheel motors mounted on the four wheels on the basis of the 16 control variables described above, thereby controlling a wheel speed and an inclination (a steering angle or a camber angle) of each of the four wheels of the vehicle 2012, and a suspension supporting each of the four wheels to perform autonomous driving.

For an index value calculated from sensor information, a control variable may be calculated by calculating an index value from sensor information of one sensor, for example, a sensor that detects a surrounding situation of the vehicle.

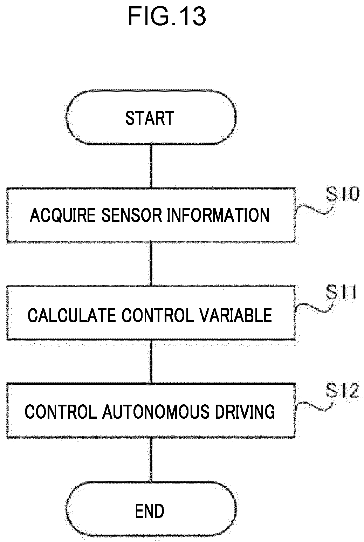

The central brain 120 repeatedly executes the flowchart shown in Fig. 13.

In step S10, the central brain 120 acquires sensor information including road information detected by the sensor. The central brain 120 proceeds to step S11. The process in step S10 is an example of the function of the acquisition unit.

In step S11, the central brain 2120 calculates the 16 control variables on the basis of the sensor information acquired in step S10. The central brain 120 proceeds to step S12. The process in step S11 is an example of the function of the calculation unit.

In step S12, the central brain 120 controls autonomous driving on the basis of the control variables calculated in step S11. The central brain 2120 ends the process in the flowchart. The process in step S12 is an example of the function of the control unit.

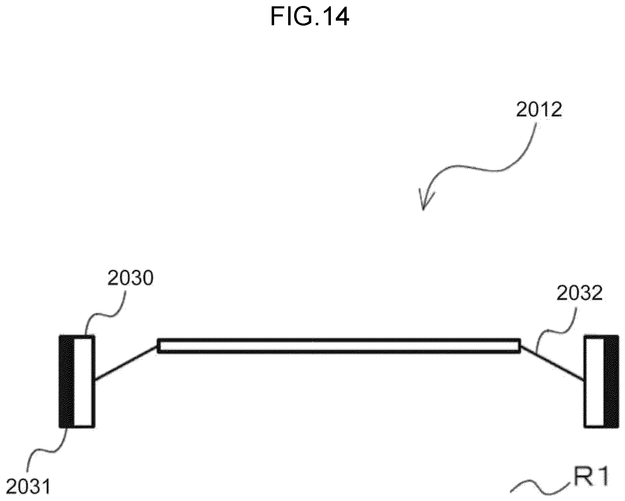

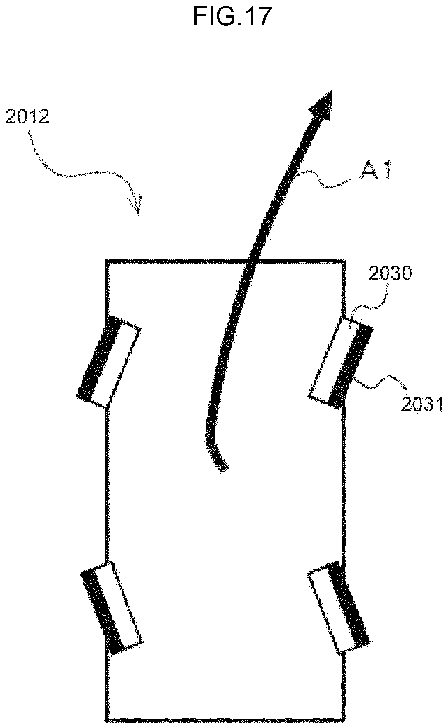

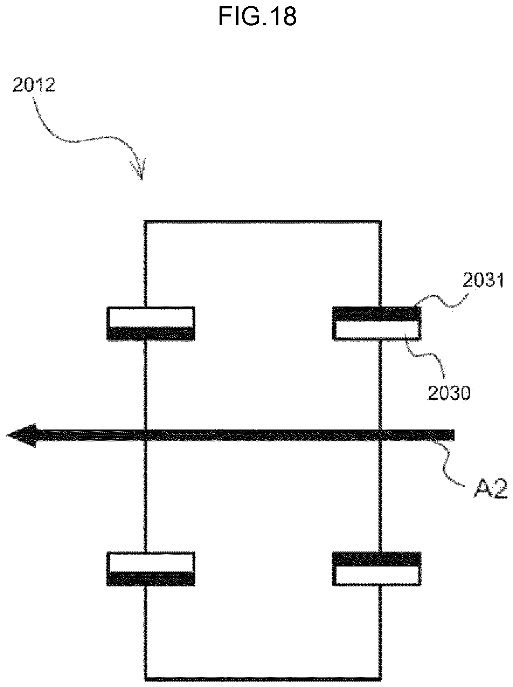

Figs. 14 to 18 are explanatory diagrams for describing an example of autonomous driving control performed by the central brain 120. Figs. 14 to 16 are explanatory diagrams of a viewpoint of the vehicle 2012 as viewed from the front, and Figs. 17 and 18 are explanatory diagrams of a viewpoint of the vehicle 2012 as viewed from below.

Fig. 14 shows a case in which the vehicle 2012 is traveling on a flat road R1. The central brain 2120 controls in-wheel motors 2031 respectively mounted on four wheels 2030 on the basis of the 16 control variables calculated in accordance with the road R1, thereby controlling a wheel speed and an inclination (a steering angle or a camber angle) of each of the four wheels 2030 and a suspension 2032 supporting each of the four wheels 2030 to perform autonomous driving.

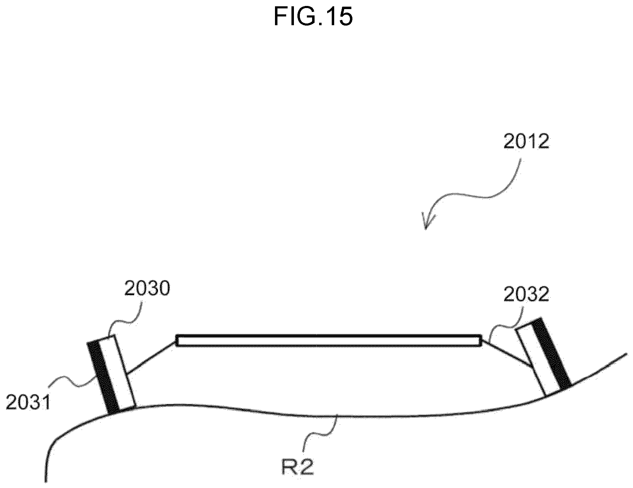

Fig. 15 shows a case in which the vehicle 2012 is traveling on a mountain road R2. The central brain 2120 controls the in-wheel motors 2031 respectively mounted on the four wheels 2030 on the basis of the 16 control variables calculated in accordance with the mountain road R2, thereby controlling a wheel speed and an inclination (a steering angle or a camber angle) of each of the four wheels 2030 and the suspension 2032 supporting each of the four wheels 2030 to perform autonomous driving.

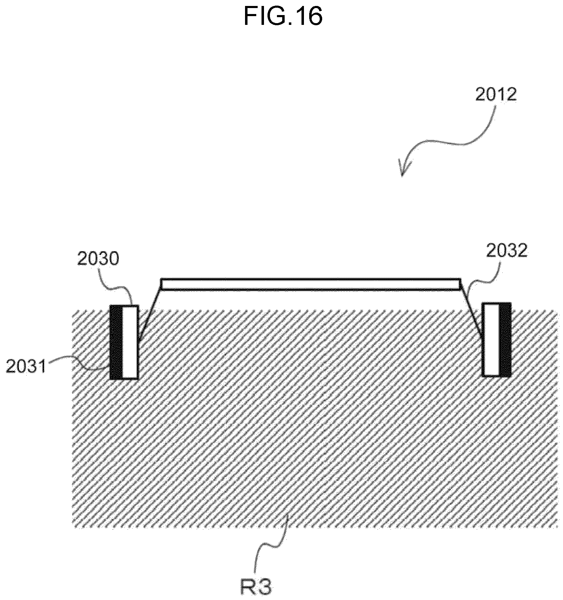

Fig. 16 shows a case in which the vehicle 2012 is traveling in a puddle R3. The central brain 2120 controls the in-wheel motors 2031 respectively mounted on the four wheels 2030 on the basis of the 16 control variables calculated in accordance with the puddle R3, thereby controlling a wheel speed and an inclination (a steering angle or a camber angle) of each of the four wheels 2030 and the suspension 2032 supporting each of the four wheels 2030 to perform autonomous driving.

Fig. 17 shows a case in which the vehicle 2012 is curving in a direction indicated by an arrow A1. The central brain 120 controls the in-wheel motors 2031 respectively mounted on the four wheels 2030 on the basis of the 16 control variables calculated in accordance with the entering curved road, thereby controlling a wheel speed and an inclination (a steering angle or a camber angle) of each of the four wheels 2030 and the suspension 2032 (not shown) supporting each of the four wheels 2030 to perform autonomous driving.

Fig. 18 shows a case in which the vehicle 2012 is moving in parallel in a direction indicated by an arrow A2. The central brain 2120 controls the in-wheel motors 2031 respectively mounted on the four wheels 2030 on the basis of the 16 control variables calculated in accordance with the parallel movement in the direction indicated by the arrow A2, thereby controlling a wheel speed and an inclination (a steering angle or a camber angle) of each of the four wheels 2030 and the suspension 2032 (not shown) supporting each of the four wheels 2030 to perform autonomous driving.

The states (inclinations) of the wheels 2030 and the suspensions 2032 shown in Figs. 14 to 18 are merely examples, and it goes without saying states of the wheel 2030 and the suspension 2032 different from the states shown in the respective drawings may occur.

Here, an in-wheel motor mounted on a conventional vehicle can independently control each drive wheel, but the vehicle cannot control the in-wheel motor by analyzing a road situation or the like. Therefore, in the vehicle, for example, in a case in which the vehicle is traveling on a mountain road, a puddle, or the like, appropriate autonomous driving based on a road situation or the like cannot be performed. However, according to the vehicle 2012 of the embodiment, it is possible to perform autonomous driving in which a speed, steering, and the like are controlled in accordance with an environment such as a road situation on the basis of the configuration described above.

Incidentally, while the vehicle is traveling, an obstacle may approach the vehicle. In this case, the vehicle preferably travels while changing a behavior of the vehicle in order to avoid contact with or collision with the obstacle. Examples of the obstacle include other vehicles other than the own vehicle that is traveling, wall surfaces, guard rails, curbstones, and other installed objects. In the following description, a case in which another vehicle approaching the vehicle 2012 is applied as an example of the obstacle will be described. The obstacle is an example of a target object.

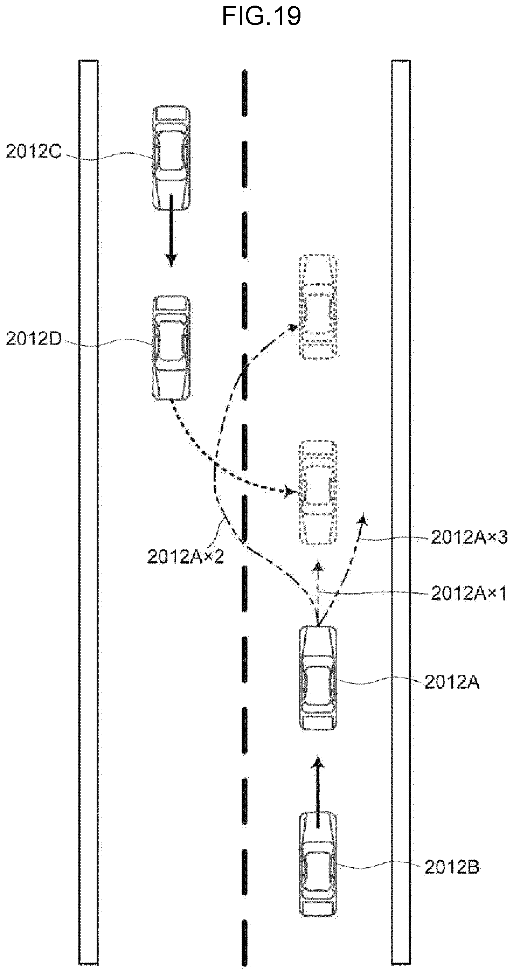

Fig. 19 is a diagram schematically showing a state in which other vehicles 2012B, 2012C, and 2012D are traveling around an own vehicle 2012A, in which the own vehicle 2012A is the vehicle 2012 traveling on a road with two opposite lanes. In the example in the drawing, another vehicle 2012B is traveling following the own vehicle 2012A, still another vehicle 2012D is traveling ahead in the opposite lane, and yet still another vehicle 2012C is traveling following the vehicle 2012D.

The central brain 2120 of the own vehicle 2012A controls the in-wheel motors 2031 respectively mounted on the four wheels 2030 on the basis of the above-described control variables calculated in accordance with a state of traveling on a traveling path that changes from moment to moment, thereby controlling a wheel speed and an inclination (a steering angle or a camber angle) of each of the four wheels 2030, and the suspension 2032 supporting each of the four wheels 2030 to perform autonomous driving. The central brain 2120 detects behaviors of the other vehicles 2012B, 2012C, and 2012D around the own vehicle 2012A by using the sensors and acquires the behaviors as sensor information.

The central brain 2120 has a function of predicting a collision including contact with an obstacle serving as a target object with respect to the own vehicle from the acquired sensor information in order to travel while avoiding at least the obstacle. As shown in Fig. 19, in a case in which the vehicle 2012D is predicted to enter in front of the own vehicle 2012A from the sensor information, the central brain 2120 calculates a control variable indicating a behavior of the own vehicle 2012A capable of avoiding at least contact with the vehicle 2012D.

For example, in the example shown in Fig. 19, the own vehicle 2012A collides with the vehicle 2012D on a route 2012Ax1 on which the own vehicle 2012A is traveling in the current traveling state. Therefore, the central brain 2120 calculates routes such as routes 2012Ax2 and 2012Ax3 for avoiding a collision with the vehicle 2012D, selects one of the routes, and calculates a control variable. In selection of a route, a route providing (for example, a minimum value of) a control variable in which a load caused by the control variable in the own vehicle 2012A is smaller than a prescribed value is selected.

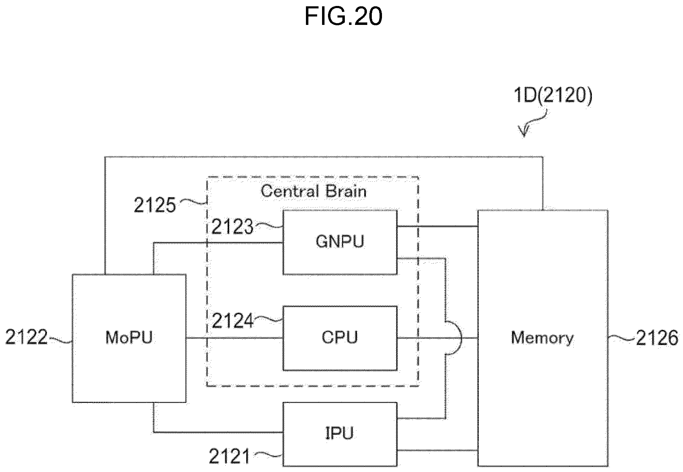

The central brain 2120 capable of realizing the above-described autonomous driving will be further described. The central brain 2120 is configured as an information processing device 1D shown in Fig. 20. The central brain 2120 described above is a processing device in a broad sense that functions as an information processing device including a gateway, and the central brain 2125 described below is a processing device in a narrow sense in a case in which functions are classified for each processor.

Fig. 20 is a block diagram showing an example of a configuration of the information processing device 1D including a central brain according to the fifth embodiment. The information processing device 1D includes an image processing unit (IPU) 2121, a motion processing unit (MoPU) 2122, a central brain 2125, and a memory 2126. The central brain 2125 includes a graphics neural network processing unit (GNPU) 2123 and a central processing unit (CPU) 2124.

The IPU 2121 may be embedded in an ultra-high-definition camera (not shown) installed in the vehicle. The IPU 2121 performs prescribed image processing such as Bayer transformation, demosaic, denoising, and sharpening on an image of an object present around the vehicle, and outputs the processed image of the object at a frame rate of, for example, 10 frames/second and a resolution of 12 million pixels. The image output from the IPU 2121 is supplied to the central brain 2125 and the memory 2126.

The MoPU 2122 may be built into a low-resolution camera that is separate from the ultra-high-definition camera installed in the vehicle. The MoPU 2122 outputs motion information indicating a motion of the imaged object at a frame rate of 1920 frames/second, for example. That is, the frame rate of the output of the MoPU 2122 is 100 times the frame rate of the output of the IPU 2121. The MoPU 2122 outputs, as motion information, vector information of motion along a prescribed coordinate axis of a point indicating a presence position of the object. That is, the motion information output from the MoPU 2122 does not include information necessary for identifying what the imaged object is (for example, whether the object is a person or an obstacle), and includes only information indicating the motion (a moving direction and a movement speed) of a center point (or a centroid point) of the object on coordinate axes (an x-axis, a y-axis, and a z-axis). The image output from the MoPU 2122 is supplied to the central brain 2125 and the memory 2126. Since the motion information does not include image information, an amount of information transferred to the central brain 2125 and the memory 2126 can be reduced.

The embodiment includes a first processor that outputs a captured image of an object at a first frame rate, and a second processor that outputs motion information indicating a motion of the imaged object at a second frame rate higher than the first frame rate. That is, the detection unit that images the surroundings of the vehicle in a first cycle that is a cycle of detecting a surrounding situation of the vehicle of the embodiment is an example of a "first processor", and the IPU 2121 is an example of a "first processor". The detection unit including a sensor that detects a surrounding situation of the vehicle in the second cycle shorter than the first cycle of the embodiment is an example of a "second processor", and the MoPU 2122 is an example of a "second processor".

The central brain 2125 executes driving control of the vehicle on the basis of the image output from the IPU 2121 and the motion information output from the MoPU 2122. For example, the central brain 2125 recognizes the type of an object (a person, an animal, a road, a signal, a sign, a pedestrian crossing, an obstacle, a building, and the like) present around the vehicle on the basis of the image output from the IPU 2121. The central brain 2125 recognizes a motion of the object that is around the vehicle and of which the type has been recognized, on the basis of the motion information output from the MoPU 2122. The central brain 2125 performs, for example, control (speed control) of a motor for driving wheels, brake control, and steering wheel control on the basis of the recognized information. In the central brain 2125, the GNPU 2123 may perform processing related to image recognition, and the CPU 2124 may perform processing related to vehicle control.

In general, an ultra-high-definition camera is used to perform image recognition in autonomous driving. It is possible to recognize the type of an object included in an image captured by the high-definition camera from the image. However, this is not sufficient for autonomous driving of the times of Level 6. In the times of Level 6, it is also necessary to recognize a motion of an object. Recognizing a motion of an object enables, for example, an avoidance operation in which a vehicle traveling through autonomous driving avoids an obstacle to be performed with higher accuracy. However, a high-definition camera can acquire only about 10 frames per second, and it is difficult to analyze a motion of an object. On the other hand, a camera equipped with the MoPU 2122 has a low resolution, but can output at a high frame rate of 1920 frames/second, for example.

Therefore, in the technology of the embodiment, two independent processors of the IPU 2121 and the MoPU 2122 are used. The high-definition camera (IPU 2121) has a role of acquiring image information necessary for recognizing the type of an identified object, and the MoPU 2122 has a role of detecting a motion of the object. The MoPU 2122 regards an object as a point, and analyzes in which direction on the x axis, the y axis, and the z axis the coordinates of the point move and at what speed. Since the detection of the entire contour of an object and the type of the object can be performed from an image from the high-definition camera, it is possible to know how the entire object behaves as long as the MoPU 2122 knows how the center point of the object moves.

According to the method of analyzing only a movement and a speed of the center point of an object, it is possible to greatly reduce an amount of information transferred to the central brain 2125 and greatly reduce an amount of calculation in the central brain 2125 compared with the case of determining how the entire image of the object moves. For example, in a case in which an image of 1000 pixels ×1000 pixels is transmitted to the central brain 2125 at a frame rate of 1920 frames/second, in a case in which color information is included, data of 4 billion bits/second is transmitted to the central brain 2125. Since the MoPU 2122 transmits only motion information indicating a motion of the center point of the object, an amount of data transferred to the central brain 2125 can be compressed to 20,000 bits/second. That is, the amount of data transferred to the central brain 2125 is compressed to 1/200,000.

As described above, by using the low-frame-rate and high-resolution image output from the IPU 2121 and the high-frame-rate and light motion information output from the MoPU 2122 in combination, it is possible to realize object recognition including the motion of the object with a small amount of data.

In a case in which one MoPU 2122 is used, it is possible to acquire vector information of a motion of a point indicating a presence position of an object along each of two coordinate axes (an x-axis and a y-axis) in a three-dimensional orthogonal coordinate system. By utilizing the principle of a stereo camera, two MoPUs 2122 may be used to output vector information of a motion of a point indicating a presence position of an object along each of three coordinate axes (an x-axis, a y-axis, and a z-axis) in a three-dimensional orthogonal coordinate system. The z-axis is an axis along the depth method (traveling of a vehicle).

In the embodiment, as a cycle of detecting a surrounding situation of vehicle 2012 as sensor information, the surrounding situation of the vehicle can be detected in a second cycle shorter than a first cycle in which the surroundings of the vehicle are imaged by a camera or the like. That is, at Level 5 described above, the surrounding situation can be detected twice in 0.3 seconds by a camera or the like, but in the embodiment, the surrounding situation can be detected 576 times at Level 6. An index value and a control variable can be calculated every 576 times of detection of the surrounding situation, and a behavior of the vehicle can be controlled so that the vehicle can travel faster and safer than in the autonomous driving executed at Level 5.

In the above description, a collision is avoided by selecting a route, but the disclosure is not limited thereto. For example, in a case in which it is difficult for the own vehicle 2012A to avoid a collision with another vehicle, it is possible to calculate a control variable that reduces damage generated in the vehicle in an unavoidable collision. That is, the central brain 2120 may calculate, as the control variable, a control variable corresponding to damage that is generated in the vehicle in the unavoidable collision and is a predetermined threshold or less. Therefore, the above-described calculation unit predicts a collision of a target object with the vehicle 2012 on the basis of a plurality of acquired sensor information, and in a case in which a predicted result indicates an unavoidable collision, the calculation unit calculates, as the control variable, a control variable corresponding to damage that is generated in the vehicle in the unavoidable collision and is a predetermined threshold or less. As the damage generated in the vehicle, at least one of a deformation position and a deformation amount of the vehicle can be applied. At least one of a vehicle collision angle and a vehicle speed can be applied as the control variable corresponding to the damage generated in the vehicle.

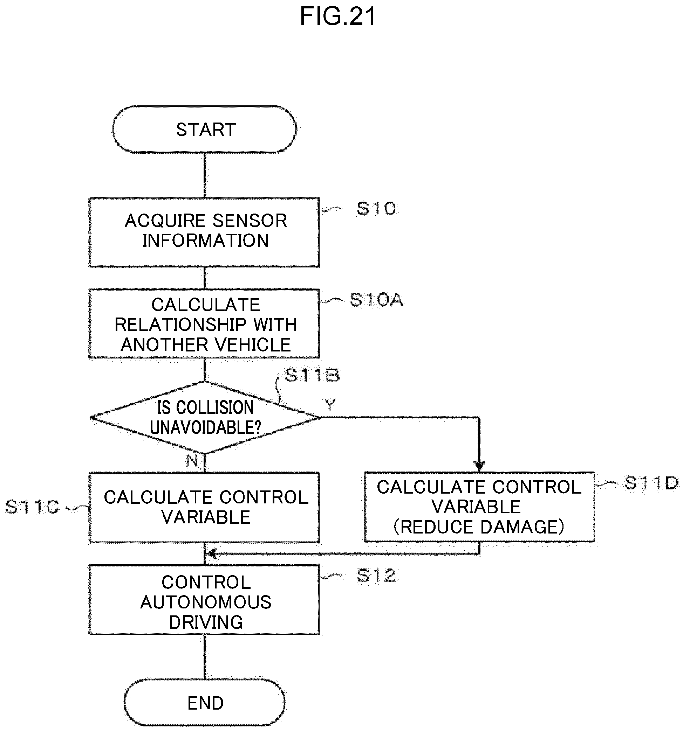

Fig. 21 is a flowchart showing an example of a flow of processing in the central brain 2120 that enables reduction of damage generated in the vehicle 2012 in an unavoidable collision. In Fig. 21, the process in step S11 shown in Fig. 13 is executed instead of steps S11A to 11D. The central brain 2120 can repeatedly execute the process shown in Fig. 21 instead of the process shown in Fig. 13.

In step S11A, the central brain 2120 calculates a relationship between the own vehicle and another vehicle. Specifically, in step S11A, a collision of a target object (for example, another vehicle) with the vehicle 2012 is predicted on the basis of sensor information, and it is determined whether a determination result based on the prediction is an unavoidable collision. In step S11B, it is determined whether a determination result based on the prediction is an unavoidable collision. In a case in which the determination is positive in step S11B, the process proceeds to step S11D, and in a case in which the determination is negative, a control variable is calculated in step S11C as in step S11 in Fig. 13 described above. In step S11D, as described above, the control variable for reducing the damage generated in the vehicle in the unavoidable collision is calculated, and the process proceeds to step S12.

The processes in steps S11A, S11B, S11C, and S11D are not limited to being executed in the above-described order. For example, after the process in step S11C, the processes in steps S11B and S11D may be executed. Specifically, first, in step S11C, a collision of another vehicle with the vehicle 2012 is predicted, and a control variable indicating a relationship in which a risk is minimized with respect to a correlation between the own vehicle and the other vehicle is calculated. Examples of the relationship in which a risk is minimized include a relationship including contact and collision and a relationship that is less likely to be a relationship including contact and collision among relationships in which the relationship is avoided. That is, a control variable having the lowest collision risk is calculated. Next, in step S11B, a collision of another vehicle with the vehicle 2012 is predicted, and it is determined whether or not a behavior of the vehicle 2012 according to the calculated control variable cannot avoid the collision as a predicted result. In this case, in a case in which the determination is negative in step S11B, the process may proceed directly to step S12. On the other hand, in a case in which the determination is positive, in step S11D, a control variable capable of further reducing the collision risk is calculated as the control variable calculated in step S11C. Specifically, at least one of a collision angle and a vehicle speed of the vehicle is calculated, in which the collision angle and the vehicle speed reduce damage generated in the vehicle due to the contact or the collision between the own vehicle and another vehicle.

A control variable related to a speed of the vehicle 2012 may be selected by applying a total of 30 patterns by setting 10 patterns for each of large, medium, and small (L, M, S) for the acceleration side, and applying a total of 30 patterns by setting 10 patterns for each of large, medium, and small (L, M, S) for the deceleration side. In this case, a relationship between the own vehicle and the other vehicle changes from moment to moment, and in a state in which the own vehicle and the other vehicle approach each other, the distance is reduced in the approaching direction. Therefore, options for selecting a pattern are reduced from moment to moment, the processing time for selection can be reduced, and adjustment of the delta difference is reduced.

Although the case in which the vehicle 2012D is applied as another vehicle for the own vehicle 2012A has been described above, a control variable for reducing the collision risk for another vehicle may be calculated for at least one of the other vehicles 2012B, 2012C, and 2012D around the own vehicle 2012A described above and all the other vehicles.

Therefore, the central brain 2120 controls the in-wheel motor 2031 mounted on each of the four wheels 2030, for example, on the basis of the control variable calculated in accordance with the prediction of the collision including contact, thereby controlling a wheel speed and an inclination (a steering angle or a camber angle) of each of the four wheels 2030 and the suspension 2032 supporting each of the four wheels 2030, so that it is possible to avoid the collision or reduce the damage generated in the vehicle at the time of the collision and perform the autonomous driving.

(Sixth Embodiment)

Incidentally, in a case in which an autonomous driving function is provided, it is necessary to derive a control variable for controlling autonomous driving by processing information from various sensors. However, in the conventional autonomous driving, there is a problem that a calculation amount and a calculation time necessary for deriving a control variable increase. Therefore, an information processing device or the like capable of deriving a control variable without executing a control variable inference process every time will be described below.

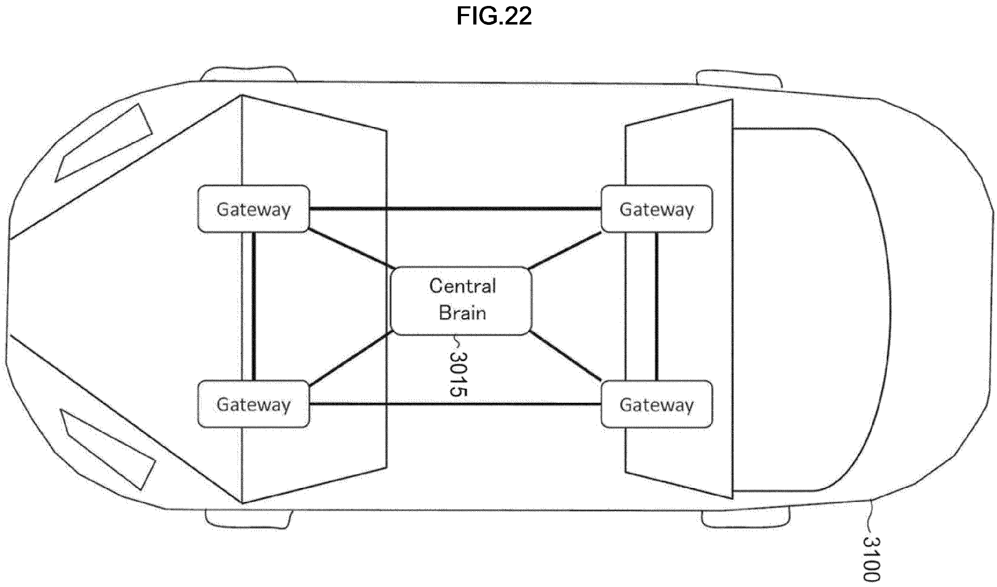

Fig. 22 is a schematic diagram showing an example of a vehicle 3100 equipped with a central brain 3015. A plurality of gateways are communicatively connected to the central brain 3015. The central brain 3015 is connected to an external cloud server via the gateway. The central brain 3015 is configured to be able to access an external cloud server via the gateway. On the other hand, due to the presence of the gateway, the central brain 3015 is configured to be not able to be directly accessed from the outside.

The central brain 3015 outputs a request signal to the cloud server every time a prescribed time elapses. Specifically, the central brain 3015 outputs a request signal indicating an inquiry to the cloud server every nanosecond. As an example, the central brain 3015 controls the autonomous driving at Level 6 on the basis of a plurality of information acquired via the gateway.

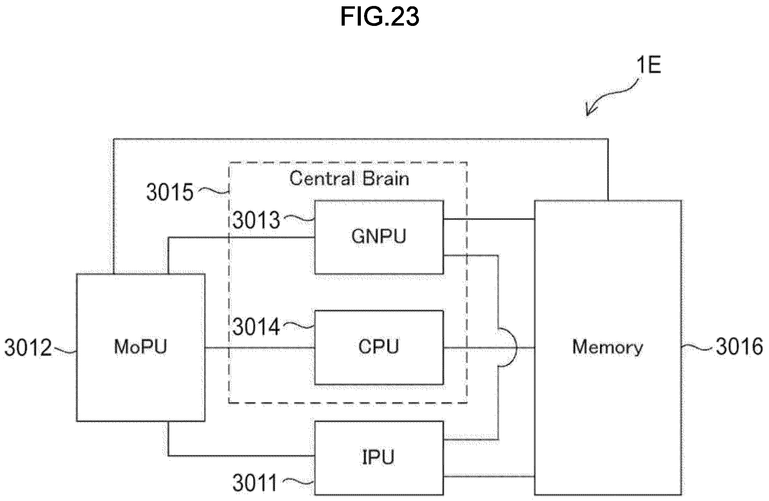

Fig. 23 is a first block diagram showing an example of a configuration of an information processing device 1E. The information processing device 1E includes an image processing unit (IPU) 3011, a motion processing unit (MoPU) 3012, the central brain 3015, and a memory 3016. The central brain 3015 includes a graphics neural network processing unit (GNPU) 3013 and a central processing unit (CPU) 3014.

The IPU 3011 is built in an ultra-high-definition camera (not shown) installed in the vehicle 3100. The IPU 3011 performs prescribed image processing such as Bayer transformation, demosaic, denoising, and sharpening on an image of an object present around the vehicle 3100, captured by the ultra-high-definition camera, and outputs the processed image of the object at a frame rate of 10 frames/second and a resolution of 12 million pixels, for example. The IPU 3011 outputs identification information for identifying the imaged object from the image of the object captured by the ultra-high-definition camera. The identification information is information necessary for identifying the type of the imaged object (for example, whether the object is a person or an obstacle). In the embodiment, the IPU 3011 outputs label information (for example, information indicating whether the imaged object is a dog, a cat, or a bear) indicating the type of the imaged object as the identification information. The IPU 3011 outputs position information indicating a position of the imaged object in a camera coordinate system of the ultra-high-definition camera. The image, the label information, and the position information output from the IPU 3011 are supplied to the central brain 3015 and the memory 3016. The IPU 3011 is an example of a "second processor", and the ultra-high-definition camera is an example of a "second camera".

The MoPU 3012 is built in another camera (not shown) different from the ultra-high-definition camera installed in the vehicle 3100. The MoPU 3012 outputs, for example, at a frame rate of 100 frames/second or more, point information in which an imaged object is set as a point from an image of the object captured at a frame rate of 100 frames/second or more by another camera facing in a direction corresponding to the ultra-high-definition camera. The point information output from the MoPU 3012 is supplied to the central brain 3015 and the memory 3016. As described above, the image used by the MoPU 3012 to output the point information and the image used by the IPU 3011 to output the identification information are images captured by another camera and the ultra-high-definition camera facing the corresponding direction. Here, the "corresponding direction" is a direction in which an imaging range of another camera and an imaging range of the ultra-high-definition camera overlap. In the above case, another camera images an object in a direction overlapping the imaging range of the ultra-high-definition camera. Imaging of an object using the ultra-high-definition camera and another camera facing the corresponding direction is realized, for example, by obtaining a correspondence relationship of a camera coordinate system between the ultra-high-definition camera and another camera in advance.

For example, the MoPU 3012 outputs, as the point information, coordinate values of at least two coordinate axes of a point indicating the presence position of the object in the three-dimensional orthogonal coordinate system. The coordinate values indicate a center point (or a centroid point) of the object as an example. The MoPU 3012 outputs, as coordinate values of the two coordinate axes, a coordinate value (hereinafter, an "x coordinate value") of an axis (x-axis) in a width direction and a coordinate value (hereinafter, a "y coordinate value") of an axis (y-axis) in a height direction in the three-dimensional orthogonal coordinate system. The x-axis is an axis in a vehicle width direction of the vehicle 3100, and the y-axis is an axis in a height direction of the vehicle 3100.

With the above configuration, since the point information for 1 second output from the MoPU 3012 includes the x coordinate value and the y coordinate value for 100 frames or more, it is possible to ascertain a motion (a moving direction and a movement speed) of the object on the x-axis and the y-axis in the three-dimensional orthogonal coordinate system on the basis of the point information. That is, the point information output from the MoPU 3012 includes position information indicating the position of the object and motion information indicating the motion of the object in the three-dimensional orthogonal coordinate system.

As described above, the point information output from the MoPU 3012 does not include information necessary for identifying the type of the imaged object (for example, whether the object is a person or an obstacle), and includes only information indicating the motion (a moving direction and a movement speed) on the x-axis and the y-axis of the center point (or a centroid point) of the object. Since the point information output from the MoPU 3012 does not include image information, an amount of data to be output to the central brain 3015 and the memory 3016 can be dramatically reduced. The MoPU 3012 is an example of a "first processor", and another camera is an example of a "first camera".

As described above, in the embodiment, the frame rate of the other camera incorporating the MoPU 3012 is higher than the frame rate of the ultra-high-definition camera incorporating the IPU 3011. Specifically, the frame rate of the other camera is 100 frames/second or more, and the frame rate of the ultra-high-definition camera is 10 frames/second. That is, the frame rate of the other camera is 10 times or more the frame rate of the ultra-high-definition camera.

The central brain 3015 associates the point information output from the MoPU 3012 with the label information output from the IPU 3011. For example, due to the frame rate difference between the other camera and the ultra-high-definition camera, the central brain 3015 acquires point information regarding an object, but does not acquire label information in some cases. In this state, the central brain 3015 recognizes an x coordinate value and a y coordinate value of the object on the basis of the point information, but does not recognize the type of the object.

Thereafter, in a case in which label information regarding the object is acquired, the central brain 3015 derives the type (for example, a person) of the label information. The central brain 3015 associates the label information with the point information acquired above. As a result, the central brain 3015 recognizes the x coordinate value and the y coordinate value of the object on the basis of the point information, and recognizes the type of the object. The central brain 3015 is an example of a "third processor".

Here, in a case in which there are a plurality of objects such as an object A and an object B imaged by the ultra-high-definition camera and another camera, the central brain 3015 associates point information and label information for each object as follows. Due to the frame rate difference between the other camera and the ultra-high-definition camera, the central brain 3015 acquires point information (hereinafter, "point information A" and "point information B") regarding the object A and the object B, but does not acquire label information in some cases. In this state, the central brain 3015 recognizes an x coordinate value and a y coordinate value of the object A on the basis of the point information A and recognizes an x coordinate value and a y coordinate value of the object B on the basis of the point information B, but does not recognize the types of these objects.

Thereafter, in a case in which one piece of label information is acquired, the central brain 3015 derives the type (for example, a person) of the one piece of label information. The central brain 3015 specifies point information to be associated with the one piece of label information on the basis of position information output from the IPU 3011 together with the one piece of label information and position information included in the acquired point information A and point information B. For example, the central brain 3015 specifies point information including position information indicating a position closest to the position of the object indicated by the position information output from the IPU 3011, and associates the point information with the one piece of label information. In a case in which the point information specified above is the point information A, the central brain 3015 associates the one piece of label information with the point information A, recognizes the x coordinate value and the y coordinate value of the obj ect A on the basis of the point information A, and recognizes the type of the object A.

As described above, in a case in which there are a plurality of objects imaged by the ultra-high-definition camera and another camera, the central brain 3015 associates the point information and the label information on the basis of the position information output from the IPU 3011 and the position information included in the point information output from the MoPU 3012.

The central brain 3015 recognizes an object (a person, an animal, a road, a signal, a sign, a pedestrian crossing, an obstacle, a building, or the like) present around the vehicle 3100 on the basis of the image and the label information output from the IPU 3011. The central brain 3015 recognizes a position and a motion of the object that is present around the vehicle 3100 and of which the type is recognized, on the basis of the point information output from the MoPU 3012. On the basis of the recognized information, the central brain 3015 performs, for example, control (speed control) of a motor for driving wheels, brake control, and steering wheel control, and controls autonomous driving of the vehicle 3100. For example, the central brain 3015 controls the autonomous driving of the vehicle 3100 to avoid collision with the object on the basis of the position information and the motion information included in the point information output from the MoPU 3012. In the central brain 3015, the GNPU 13 may perform processing related to image recognition, and the CPU 3014 may perform processing related to vehicle control.

In general, an ultra-high-definition camera is used to perform image recognition in autonomous driving. Here, it is possible to recognize the type of an object included in an image is from the image captured by the ultra-high-definition camera. However, this is not sufficient for autonomous driving of the times of Level 6. In the times of Level 6, it is also necessary to recognize a motion of an object with higher accuracy. By recognizing the motion of the object with higher accuracy with the MoPU 3012, for example, an avoidance operation in which the vehicle 3100 traveling through autonomous driving avoids an obstacle can be performed with higher accuracy. However, the ultra-high-definition camera can acquire images at only about 10 frames per second, and the accuracy of analyzing a motion of an object is lower than that of a camera equipped with the MoPU 3012. On the other hand, the camera equipped with the MoPU 3012 can output at a high frame rate of 100 frames/second, for example.

Therefore, the information processing device 1E according to the sixth embodiment includes two independent processors such as the IPU 3011 and the MoPU 3012. The information processing device 1E gives a role of acquiring information necessary for identifying the type of an imaged object to the IPU 3011 built in the ultra-high-definition camera, and a role of detecting a position and a motion of the object to the MoPU 3012 built in another camera. The MoPU 3012 regards the imaged object as a point, and analyzes in which direction and at what speed on at least the x-axis and the y-axis in the three-dimensional orthogonal coordinate system the coordinates of the point move. Since detection of the entire contour of the object and the type of the object can be performed on the basis of an image from the ultra-high-definition camera, the MoPU 3012 can ascertain, for example, how the entire object behaves as long as how the center point of the object moves.

According to the method of analyzing only a motion and a speed of a center point of an object, it is possible to greatly reduce an amount of data to be output to the central brain 3015 and greatly reduce an amount of calculation in the central brain 3015 compared with the case of determining how the entire image of the object moves. For example, in a case in which an image of 1000 pixels ×1000 pixels is output to the central brain 3015 at a frame rate of 1000 frames/second, when color information is included, data of 4 billion bits/second is output to the central brain 3015. Since the MoPU 3012 outputs only the point information indicating the motion of the center point of the object, an amount of data to be output to the central brain 3015 can be compressed to 20,000 bits/second. That is, an amount of data to be output to the central brain 3015 is compressed to 1/200,000.

As described above, by using a low-frame-rate and high-resolution image and label information output from the IPU 3011 and a high-frame-rate and light point information output from the MoPU 3012 in combination, it is possible to realize object recognition including a motion of an object with a small amount of data.

In the information processing device 1E, the central brain 3015 associates the point information output from the MoPU 3012 with the label information output from the IPU 3011, so that it is possible to ascertain information regarding the type of the object and how the object is moving.

(Seventh Embodiment)

Next, a seventh embodiment of the disclosure will be described while omitting or simplifying a portion overlapping the sixth embodiment.

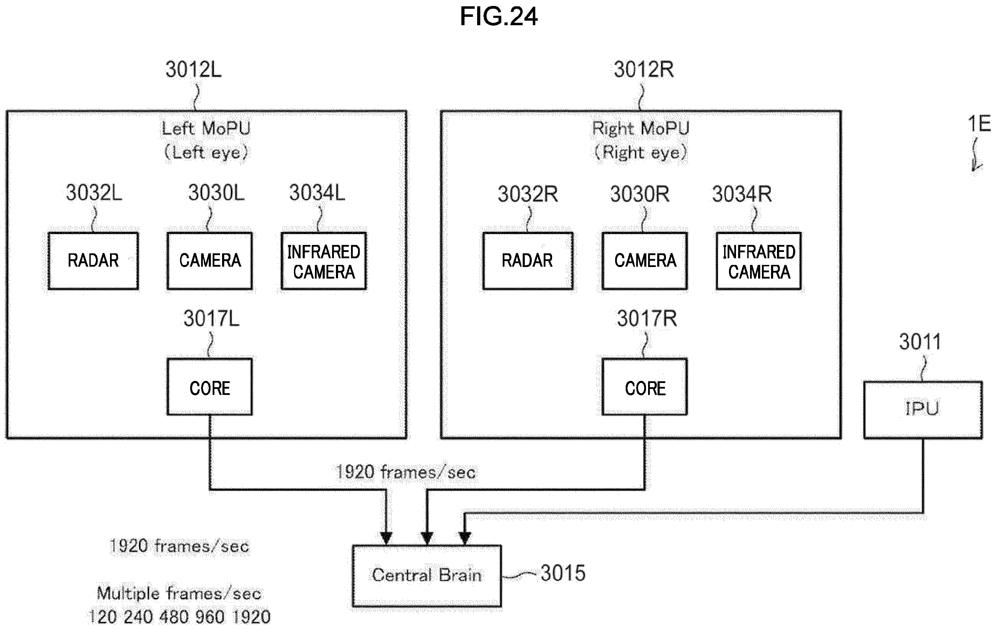

Fig. 24 is a second block diagram showing an example of a configuration of the information processing device 1E according to the seventh embodiment. As shown in Fig. 24, the information processing device 1E mounted on the vehicle 3100 includes a MoPU 3012L corresponding to a left eye, a MoPU 3012R corresponding to a right eye, an IPU 3011, and a central brain 3015.

The MoPU 3012L includes a camera 3030L, a radar 3032L, an infrared camera 3034L, and a core 3017L. The MoPU 3012R includes a camera 3030R, a radar 3032R, an infrared camera 3034R, and a core 3017R. In the following description, the MoPU 3012L and the MoPU 3012R will be referred to as "MoPU 3012" in a case in which the MoPUs are not distinguished, the camera 3030L and the camera 3030R will be referred to as a "camera 3030" in a case in which the cameras are not distinguished, the radar 3032L and the radar 3032R will be referred to as "radar 3032" in a case in which the radars are not distinguished, the infrared camera 3034L and the infrared camera 3034R will be referred to as "infrared camera 3034" in a case in which the infrared cameras are not distinguished, and the core 3017L and the core 3017R will be referred to as "core 3017" in a case in which the cores are not distinguished.

The camera 3030 included in the MoPU 3012 images an object at a larger number of frames (120, 240, 480, 960, or 1920 frames/second) than that of an ultra-high-definition camera (for example, 10 frames/second) included in the IPU 3011. The frame rate of the camera 3030 is variable. The camera 3030 is an example of a "first camera".

The radar 3032 included in the MoPU 3012 acquires a radar signal that is a signal based on a reflected wave of an electromagnetic wave applied to an object from the object. The infrared camera 3034 included in the MoPU 3012 is a camera that captures an infrared image.

The core 3017 (for example, it is configured by one or more CPUs) included in the MoPU 3012 extracts a feature point for each image of one frame captured by the camera 3030, and outputs an x coordinate value and a y coordinate value of an object in the three-dimensional orthogonal coordinate system as point information. The core 3017 uses, for example, a center point (centroid point) of an object extracted from an image as a feature point. The point information output from the core 3017 includes position information and motion information similarly to the above embodiment.

The IPU 3011 includes an ultra-high-definition camera (not shown), and outputs an image of an object captured by the ultra-high-definition camera, label information indicating the type of the object, and position information indicating a position of the object in a camera coordinate system of the ultra-high-definition camera.

The central brain 3015 acquires the point information output from the MoPU 3012, and the image, the label information, and the position information output from the IPU 3011. The central brain 3015 associates label information regarding an object present at a position where the position information included in the point information output from the MoPU 3012 and the position information output from the IPU 3011 correspond to each other with the point information. As a result, the information processing device 1E can associate the information indicating the type of the object indicated by the label information with the position and the motion of the object indicated by the point information.

Here, the MoPU 3012 changes the frame rate of the camera 3030 according to a prescribed factor. In the embodiment, the MoPU 3012 changes the frame rate of the camera 3030 according to a score related to an external environment as an example of the prescribed factor. In this case, the MoPU 3012 calculates a score related to the external environment for the vehicle 3100, and changes the frame rate of the camera 3030 according to the calculated score. The MoPU 3012 outputs a control signal for capturing an image at the changed frame rate to the camera 3030. As a result, the camera 3030 captures an image at the frame rate indicated by the control signal. With this configuration, according to the information processing device 1E, an image of an object can be captured at a frame rate suitable for an external environment.

The information processing device 1E mounted on the vehicle 3100 includes a plurality of types of sensors (not shown). The MoPU 3012 calculates a risk level related to the motion of the vehicle 3100 as a score related to the external environment for the vehicle 3100 on the basis of sensor information (for example, movement of the centroid of the weight, a material of a road, the outside air temperature, the outside air humidity, vertical and lateral inclination angles of a slope, freezing of a road, a moisture amount, a material of each tire, a wear situation, an air pressure, a road width, the presence or absence of passing prohibition, the vehicle type information of an oncoming vehicle and front and rear vehicles, cruising states of these vehicles, and surrounding situations (birds, animals, soccer balls, accident vehicles, earthquakes, fire, winds, typhoons, heavy rain, light rain, snowstorm, fog, and the like)) incorporated from a plurality of types of sensors and point information. The risk level indicates the degree of how dangerous a place the vehicle 3100 will travel in the future. In this case, the MoPU 3012 changes the frame rate of the camera 3030 according to the calculated risk level. The vehicle 3100 is an example of a "moving object". With this configuration, according to the information processing device 1E, the frame rate of the camera 3030 can be changed according to the risk level related to the movement of the vehicle 3100. The sensor is an example of a "detection unit", and the sensor information is an example of "detection information".

For example, the MoPU 3012 increases the frame rate of the camera 3030 as the calculated risk level becomes higher. In a case in which the calculated risk level is less than a first threshold, the MoPU 3012 changes the frame rate of the camera 3030 to 120 frames/second. The MoPU 3012 changes the frame rate of the camera 3030 to any one of 240, 480, and 960 frames/second in a case in which the calculated risk level is from the first threshold to less than a second threshold. The MoPU 3012 changes the frame rate of the camera 3030 to 1920 frames/second in a case in which the calculated risk level is the second threshold or more. The MoPU 3012 may cause the camera 3030 to capture an image at a selected frame rate and also output a control signal to the radar 3032 and the infrared camera 3034 to acquire a radar signal and capture an infrared image with a numerical value corresponding to the frame rate in a case in which the risk level is any of the above.

For example, the MoPU 3012 decreases the frame rate of the camera 3030 as the calculated risk level becomes lower. In a state in which the frame rate of the camera 3030 is set to 1920 frames/second, the MoPU 3012 changes the frame rate of the camera 3030 to any one of 240, 480, and 960 frames/second in a case in which the calculated risk level is from the first threshold to less than the second threshold. The MoPU 3012 changes the frame rate of the camera 3030 to 120 frames/second in a case in which the calculated risk level is less than the first threshold in a state in which the frame rate of the camera 3030 is set to 1920 frames/second. In a state where the frame rate of the camera 3030 is set to any of 240,480,960 frames/second, the MoPU 3012 changes the frame rate of the camera 3030 to 120 frames/second in a case in which the calculated risk level is less than the first threshold. In this case, similarly to the above, the control signal may be output to the radar 3032 and the infrared camera 3034 so as to acquire the radar signal and capture the infrared image with the numerical value corresponding to the changed frame rate of the camera 3030.

The MoPU 3012 may calculate the risk level by using big data regarding travel known before the vehicle 3100 travels, such as long tail incident artificial intelligence (AI) data (for example, trip data of the vehicle in which the autonomous driving control scheme of Level 5 is implemented) or map information as information for predicting the risk level.

In the above description, the risk level is calculated as a score related to the external environment, but an index serving as the score related to the external environment is not limited to the risk level. For example, the MoPU 3012 may calculate a score related to the external environment different from the risk level on the basis of a moving direction, a speed, or the like of an object captured in the camera 3030, and change the frame rate of the camera 3030 according to the score. Hereinafter, a case in which the MoPU 3012 calculates a speed score that is a score related to a speed of an object captured in the camera 3030 and changes the frame rate of the camera 3030 according to the speed score will be described. As an example, the speed score is set to become higher as a speed of an object becomes higher and lower as the speed of the object becomes lower. The MoPU 3012 increases the frame rate of the camera 3030 as the calculated speed score becomes higher, and decreases the frame rate of the camera 3030 as the calculated speed score becomes lower. Therefore, the MoPU 3012 changes the frame rate of the camera 3030 to 1920 frames/second in a case in which the calculated speed score becomes a threshold or more because the speed of the object is high. The MoPU 3012 changes the frame rate of the camera 3030 to 120 frames/second in a case in which the calculated speed score is less than the threshold because the speed of the object is slow. In this case, similarly to the above, the control signal may be output to the radar 3032 and the infrared camera 3034 so as to acquire the radar signal and capture the infrared image with the numerical value corresponding to the changed frame rate of the camera 3030.

Next, a case in which the MoPU 3012 calculates a direction score that is a score related to a moving direction of an object captured in the camera 3030 and changes the frame rate of the camera 3030 according to the direction score will be described. As an example, the direction score is set to become higher when a moving direction of the object is a direction approaching a road, and to become lower when the moving direction is a direction away from the road. The MoPU 3012 increases the frame rate of the camera 3030 as the calculated direction score becomes higher, and decreases the frame rate of the camera 3030 as the calculated direction score becomes lower. Specifically, the MoPU 3012 specifies a moving direction of the object by using AI or the like, and calculates the direction score on the basis of the specified moving direction. The MoPU 3012 changes the frame rate of the camera 3030 to 1920 frames/second in a case in which the calculated direction score is a threshold or more because the moving direction of the object is a direction approaching the road. The MoPU 3012 changes the frame rate of the camera 3030 to 120 frames/second in a case in which the calculated direction score is less than the threshold because the moving direction of the object is a direction away from the road. In this case, similarly to the above, the control signal may be output to the radar 3032 and the infrared camera 3034 so as to acquire the radar signal and capture the infrared image with the numerical value corresponding to the changed frame rate of the camera 3030.

The MoPU 3012 may output point information only for an object for which a calculated score related to the external environment is a prescribed threshold or more. In this case, for example, the MoPU 3012 may determine whether or not to output point information regarding the object according to a moving direction of the object captured in the camera 3030. For example, the MoPU 3012 need not output point information regarding an object having a low influence on traveling of the vehicle 3100. Specifically, the MoPU 3012 calculates a moving direction of an object captured in the camera 3030, and does not output point information regarding an object such as a pedestrian moving away from a road. On the other hand, the MoPU 3012 outputs point information regarding an object approaching the road (for example, an object such as a pedestrian who is likely to jump out onto the road). With this configuration, according to the information processing device 1E, it is not necessary to output point information regarding an object having a low influence on traveling of the vehicle 3100.

In the above description, the case in which the MoPU 3012 calculates the risk level has been exemplified, but the disclosed technology is not limited to this aspect. For example, the central brain 3015 may calculate the risk level instead of the MoPU 3012. In this case, the central brain 3015 calculates the risk level related to movement of the vehicle 3100 as a score related to the external environment for the vehicle 3100 on the basis of the sensor information incorporated from the plurality of types of sensors and the point information output from the MoPU 3012. The central brain 3015 outputs an instruction to change the frame rate of the camera 3030 according to the calculated risk level to the MoPU 3012.

In the above description, the case in which the MoPU 3012 outputs the point information on the basis of the image captured by the camera 3030 has been exemplified, but the disclosed technology is not limited to this aspect. For example, the MoPU 3012 may output the point information on the basis of a radar signal and an infrared image instead of the image captured by the camera 3030. The MoPU 3012 can derive an x coordinate value and a y coordinate value of the object from the infrared image of the object captured by the infrared camera 3034, similarly to the image captured by the camera 3030. The radar 3032 can acquire three-dimensional point cloud data of an object based on a radar signal. That is, the radar 3032 can detect a z-axis coordinate in the three-dimensional orthogonal coordinate system. Here, the z-axis is an axis set in a depth direction of an object and a traveling direction of the vehicle 3100, and hereinafter, a coordinate value of the z-axis is referred to as a "z coordinate value". In this case, the MoPU 3012 uses the principle of a stereo camera to derive coordinate values of three coordinate axes (the x-axis, the y-axis, and the z-axis) of an object as point information by combining an x coordinate value and a y coordinate value of the object imaged by the infrared camera 3034 at the same timing as the timing at which the radar 3032 acquires three-dimensional point cloud data of the object with a z coordinate value of the object indicated by the three-dimensional point cloud data. The MoPU 3012 outputs the derived point information to the central brain 3015.

In the above description, the case in which the MoPU 3012 derives the point information has been exemplified, but the disclosed technology is not limited to this aspect. For example, the central brain 3015 may derive the point information instead of the MoPU 3012. The central brain 3015 derives the point information, for example, by combining information detected by the camera 3030L, the camera 3030R, the radar 3032, and the infrared camera 3034. As a specific example, the central brain 3015 performs triangulation on the basis of an x coordinate value and a y coordinate value of an object imaged by the camera 3030L and an x coordinate value and a y coordinate value of the object imaged by the camera 3030R, thereby deriving coordinate values of three coordinate axes (the x-axis, the y-axis, and the z-axis) of the object as point information.

In the above description, a case has been exemplified where the central brain 3015 controls the autonomous driving of the vehicle 3100 on the basis of the image and the label information output from the IPU 3011 and the point information output from the MoPU 3012, but the disclosed technology is not limited to this aspect. For example, the central brain 3015 may control an action of a robot on the basis of the information output from the IPU 3011 and the MoPU 3012. The robot may be a humanoid smart robot that performs work instead of a human. In this case, the central brain 3015 controls an action of arms, palms, fingers, feet, and the like of the robot on the basis of the information output from the IPU 3011 and the MoPU 3012, and causes the robot to perform actions such as grasping, gripping, holding, shouldering, carrying, moving, throwing, kicking, and avoiding an object. In a case in which the central brain 3015 controls the action of the robot, the IPU 3011 and the MoPU 3012 may be mounted at positions of the right eye and the left eye of the robot. That is, the IPU 3011 and the MoPU 3012 for the right eye may be mounted on the right eye, and the IPU 3011 and the MoPU 3012 for the left eye may be mounted on the left eye.

(Eighth Embodiment)

Next, an eighth embodiment of the disclosure will be described while omitting or simplifying a portion overlapping the sixth and seventh embodiments.

As an example, an information processing device 1E according to the eighth embodiment has the configuration shown in Fig. 23 similar to that of the sixth embodiment.

The MoPU 3012 according to the eighth embodiment outputs, as point information, coordinate values of at least two diagonal points of vertices of a polygon surrounding a contour of an object recognized from an image captured by another camera. Similarly to the sixth embodiment, the coordinate values are an x coordinate value and a y coordinate value of the object in the three-dimensional orthogonal coordinate system.

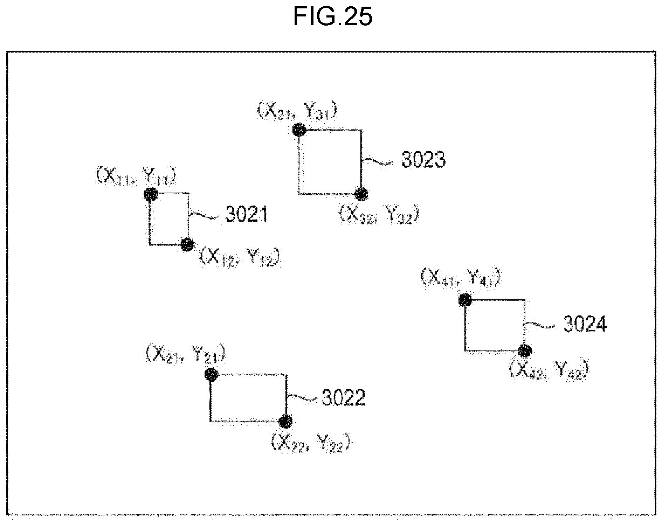

Fig. 25 is an explanatory diagram for describing an example of point information output from the MoPU 3012. Fig. 25 shows bounding boxes 3021, 3022, 3023, and 3024 in which the MoPU 3012 surrounds a contour of each of four objects included in an image captured by another camera with a rectangle. Fig. 25 exemplifies an aspect in which the MoPU 3012 outputs, as point information, coordinate values of two diagonal points of vertexes of the rectangular bounding boxes 3021, 3022, 3023, and 3024 surrounding the contours of the objects. As described above, the MoPU 3012 may regard an object not as a point but as an object having a certain size.

In a case in which the object is regarded as an object having a certain size, the MoPU 3012 may output, as point information, coordinate values of a plurality of vertices of a polygon surrounding the contour of the object, instead of coordinate values of two diagonal points of vertices of the polygon surrounding the contour of the object recognized from an image captured by another camera. For example, taking Fig. 25 as an example, the MoPU 3012 may output coordinate values of all four vertexes of the bounding boxes 3021, 3022, 3023, and 3024 surrounding the contour of the object with a rectangle as point information.

(Ninth Embodiment)

Next, a ninth embodiment of the disclosure will be described while omitting or simplifying a portion overlapping the sixth to eighth embodiments.

As an example, an information processing device 1E according to the ninth embodiment has the configuration shown in Fig. 23 similar to that of the sixth embodiment.

The vehicle 3100 on which the information processing device 1E according to the ninth embodiment is mounted includes a sensor including at least one of a radar, a LiDAR, a high-pixel/telephoto/ultra-wide angle/360 degrees/high-performance camera, a vision sensor, a sound sensor, an ultrasonic sensor, a vibration sensor, an infrared sensor, an ultraviolet sensor, a radio wave sensor, a temperature sensor, and a humidity sensor. Examples of the sensor information incorporated from the sensor by the information processing device 1E include movement of the centroid of the weight, a material of a road, the outside air temperature, the outside air humidity, vertical and lateral inclination angles of a slope, freezing of a road, a moisture amount, a material of each tire, a wear situation, an air pressure, a road width, the presence or absence of passing prohibition, the vehicle type information of an oncoming vehicle and front and rear vehicles, cruising states of these vehicles, and surrounding situations (birds, animals, soccer balls, accident vehicles, earthquakes, fire, winds, typhoons, heavy rain, light rain, snowstorm, fog, and the like). The sensor is an example of a "detection unit", and the sensor information is an example of "detection information".

The central brain 3015 according to the ninth embodiment calculates a control variable for controlling autonomous driving of the vehicle 3100 on the basis of sensor information detected by a sensor. The central brain 3015 acquires sensor information every nanosecond. Specifically, the central brain 3015 calculates control variables for controlling a wheel speed and an inclination of each of the four wheels of the vehicle 3100 and suspensions that support the wheels. Inclinations of the wheel include both an inclination of the wheel with respect to an axis horizontal to the road and an inclination of the wheel with respect to an axis vertical to the road. In this case, the central brain 3015 calculates a total of 16 control variables for controlling respective wheel speeds of the four wheels, respective inclinations of the four wheels with respect to an axis horizontal to the road, respective inclinations of the four wheels with respect to an axis vertical to the road, and the respective suspensions supporting the four wheels.

The central brain 3015 controls the autonomous driving of the vehicle 3100 on the basis of the control variables calculated above, the point information output from the MoPU 3012, and the label information output from the IPU 3011. Specifically, the central brain 3015 controls the in-wheel motors mounted on the four wheels on the basis of the 16 control variables described above, thereby controlling a wheel speed and an inclination of each of the four wheels of the vehicle 3100 and the suspension supporting each of the four wheels to perform autonomous driving. The central brain 3015 recognizes a position and a motion of an object of which the type is recognized and that is present around the vehicle 3100 on the basis of the point information and the label information, and controls the autonomous driving of the vehicle 3100 to avoid, for example, collision with the object on the basis of the recognized information. Since the central brain 3015 controls the autonomous driving of the vehicle 3100 as described above, for example, in a case in which the vehicle 3100 travels on a mountain road, it is possible to perform optimal steering in accordance with the mountain road, and in a case in which the vehicle 3100 is parked in a parking lot, it is possible to travel at an optimal angle in accordance with the parking lot.

Here, the central brain 3015 may be capable of inferring a control variable from the sensor information and information that can be acquired from a server or the like (not shown) via a network by using machine learning, more specifically, deep learning. In other words, the central brain 3015 may be configured by AI.

The central brain 3015 can obtain a control variable by performing multivariate analysis (see, for example, Formula (2)) according to an integration method as shown in the following Formula (1) by using the calculation power (hereinafter, also referred to as "calculation power at Level 6") that is a calculation power for the sensor information and the long-tail incident AI data every nanosecond and is used to realize Level 6. More specifically, while obtaining an integral value of delta values having various ultra-high resolutions with the calculation power at Level 6, each control variable is obtained at an edge level and in real time, and a result (that is, each control variable) occurring in the next nanosecond can be acquired with the highest probability theoretical value. **In** order to realize this, for example, an integral value obtained by time-integrating a delta value (for example, a minute time change value) of a function (in other words, a function indicating a behavior of each variable) capable of specifying each variable (for example, sensor information and information that can be acquired via a network) such as an air resistance, a road resistance, a road element (for example, dirt), and a slip coefficient is input to a deep learning model (for example, a trained model obtained by performing deep learning on a neural network) of the central brain 3015. The deep learning model of the central brain 3015 outputs a control variable (for example, a control variable with the highest certainty factor (that is, an evaluation value)) corresponding to the input integral value. The output of the control variable is performed in units of nanoseconds.

[Math. 1]

$$V = \int_a^b f(A)dt$$

[Math. 2]

$$V_n = DL(f(A,B,C,D,\ldots,N)(dA_n/dt))$$

As an example, in Formula (1), "f(A)" is an expression in which a function indicating a behavior of each variable such as an air resistance, a road resistance, a road element (for example, dirt), and a slip coefficient is expressed in a simplified manner. As an example, Formula (1) is a formula indicating the time integral v of "f (A)" from the time point a to the time point b. In Formula (2), DL represents deep learning (for example, a deep learning model optimized by performing deep learning on a neural network), dAn/dt represents a delta value of f(A, B, C, ..., N), A, B, C,..., and N represent an air resistance, a road resistance, a road element (for example, dirt), a slip coefficient, and the like, f(A, B, C, ..., N) represents a function indicating behaviors of A, B, C,..., and N, and Vn represents a value (control variable) output from the deep learning model optimized by performing deep learning on the neural network.

Here, a form example in which an integral value obtained by time-integrating a delta value of a function is input to the deep learning model of the central brain 3015 is described, but this is merely an example. For example, an integral value (for example, a result occurring in the next nanosecond) obtained by time-integrating a delta value of a function indicating a behavior of each of variables such as an air resistance, a road resistance, a road element, and a slip coefficient may be inferred by the deep learning model of the central brain 3015, and as an inference result, an integral value having the highest certainty factor (that is, an evaluation value) may be acquired by the central brain 3015 every nanosecond.

Here, a form example in which an integral value is input to the deep learning model or an integral value is output from the deep learning model is described, but this is merely an example, and the technology of the disclosure can be established without using an integral value. For example, at least one control variable may be inferred by a deep learning model optimized by performing deep learning on a neural network by using training data in which values corresponding to A, B, C,..., and N are used as example data and values corresponding to at least one control variable (for example, the result occurring in the next nanosecond) are used as correct answer data.

The control variable obtained by the central brain 3015 can be further refined by increasing the number of times of deep learning. For example, it is possible to calculate a more accurate control variable by using enormous data such as a tire, rotation of a motor, a steering angle, a material of a road, weather, an influence of dust or at the time of secondary curved deceleration, slip, steering for collapse of balance or re-acquisition, and a speed control method, or long tail incident AI data.

(Tenth Embodiment)

Next, a tenth embodiment of the disclosure will be described while omitting or simplifying a portion overlapping the sixth to ninth embodiments.

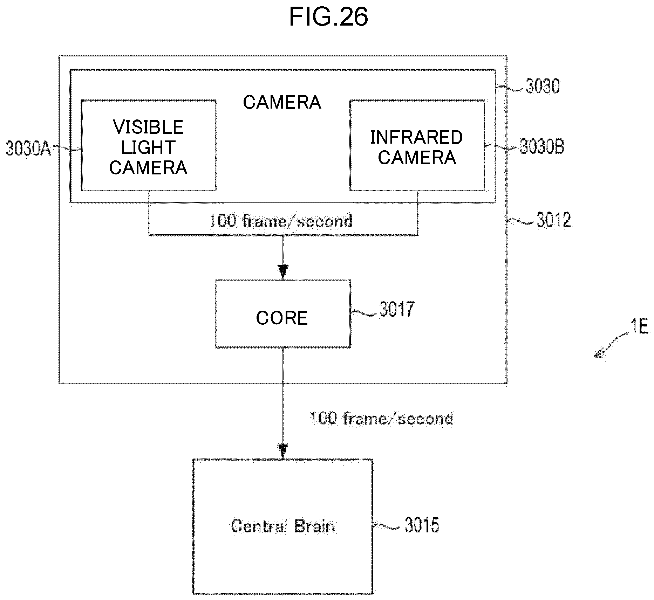

Fig. 26 is a third block diagram showing an example of a configuration of an information processing device 1E according to the tenth embodiment. Fig. 26 shows only a partial configuration of the information processing device 1E.

As shown in Fig. 26, in the MoPU 3012, a visible light image and an infrared image of an object captured by the camera 3030 are input to the core 3017 at a frame rate of 100 frames/second or more. The camera 3030 includes a visible light camera 3030A capable of capturing a visible light image of an object and an infrared camera 3030B capable of capturing an infrared image of an object. The core 3017 outputs point information to the central brain 3015 on the basis of at least one of the input visible light image and infrared image.

Here, in a case in which the object can be identified from the visible light image of the object captured by the visible light camera 3030A, the core 3017 outputs the point information on the basis of the visible light image. On the other hand, in a case in which an object cannot be identified from the visible light image due to a prescribed factor, the core 3017 outputs the point information on the basis of the infrared image of the object captured by the infrared camera 3030B. For example, it is assumed that the core 3017 cannot identify an object from the visible light image due to the influence of darkness as a prescribed factor. In this case, the core 3017 detects the heat of the object by using the infrared camera 3030B, and outputs point information of the object on the basis of the infrared image which is the detection result. The present invention is not limited thereto, and the core 3017 may output the point information on the basis of the visible light image and the infrared image.

The MoPU 3012 synchronizes a timing at which the visible light camera 3030A captures a visible light image with a timing at which the infrared camera 3030B captures an infrared image. Specifically, the MoPU 3012 outputs a control signal to the cameras 3030 to capture a visible light image and an infrared image at the same timing. As a result, the number of images per second captured by the visible light camera 3030A and the number of images per second captured by the infrared camera 3030B are synchronized with each other (for example, 1920 frames/second).

(Eleventh Embodiment)

Next, an eleventh embodiment of the disclosure will be described while omitting or simplifying a portion overlapping the sixth to tenth embodiments.

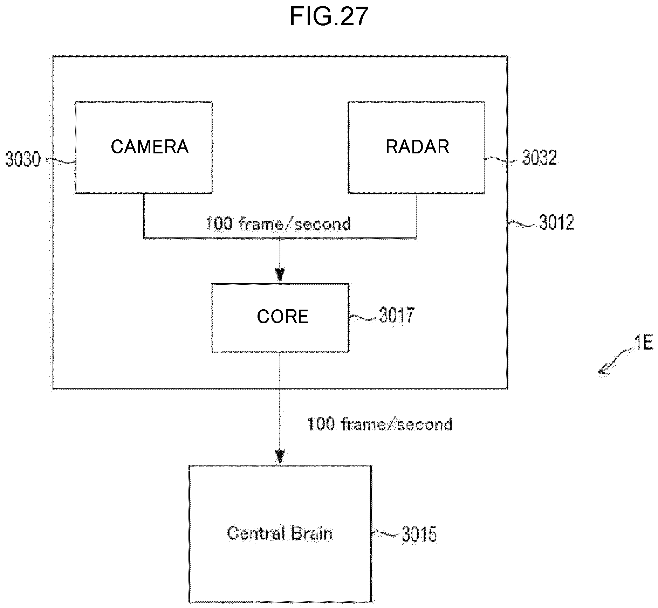

Fig. 27 is a fourth block diagram showing an example of a configuration of an information processing device 1E according to the eleventh embodiment. Fig. 27 shows only a partial configuration of the information processing device 1E.
As shown in Fig. 27, in the MoPU 3012, an image of an object captured by the camera 3030 and a radar signal based on a reflected wave of an electromagnetic wave emitted to the object by the radar 3032 from the object are input to the core 3017 at a frame rate of 100 frames/second or more. The core 3017 outputs point information to the central brain 3015 on the basis of the input image of the object and the radar signal. The core 3017 can derive an x coordinate value and a y coordinate value of the object from the input image of the object. As described above, the radar 3032 can acquire three-dimensional point cloud data of the object based on the radar signal and detect a coordinate of the z-axis in the three-dimensional orthogonal coordinate system. In this case, the core 3017 uses the principle of a stereo camera to combine the x coordinate value and the y coordinate value of the object imaged by the camera 3030 at the same timing as the timing at which the radar 3032 acquires the three-dimensional point cloud data of the object with the z coordinate value of the object indicated by the three-dimensional point cloud data, thereby deriving coordinate values of three coordinate axes (the x-axis, the y-axis, and the z-axis) of the object as point information. The image of the object input to the core 3017 may include at least one of a visible light image and an infrared image.
The MoPU 3012 synchronizes a timing at which the camera 3030 captures an image with a timing at which the radar 3032 acquires three-dimensional point cloud data of an object based on a radar signal. Specifically, the MoPU 3012 outputs a control signal to the camera 3030 and the radar 3032 to capture an image and acquire three-dimensional point cloud data of the object at the same timing. As a result, the number of images per second captured by the camera 3030 is synchronized with the number of three-dimensional point cloud data per second acquired by the radar 3032 (for example, 1920 frames/second). As described above, the number of images per second captured by the camera 3030 and the number of three-dimensional point cloud data per second acquired by the radar 3032 are larger than the frame rate of the ultra-high-definition camera included in the IPU 3011, that is, the number of images per second captured by the ultra-high-definition camera.

(Twelfth Embodiment)

Next, a twelfth embodiment of the disclosure will be described while omitting or simplifying a portion overlapping the sixth to eleventh embodiments.
As an example, an information processing device 1E according to the twelfth embodiment has the configuration shown in Fig. 23 similar to that of the sixth embodiment.
The central brain 3015 according to the twelfth embodiment associates point information output from the MoPU 3012 at the same timing as the timing at which the IPU 3011 outputs label information with the label information. In a case in which new point information is output from the MoPU 3012 after the point information and the label information are associated with each other, the central brain 3015 also associates the new point information with the label information. The new point information is point information of the same object as the object indicated by the point information associated with the label information, and is one or a plurality of point information from when the association is performed to when the next label information is output. In the twelfth embodiment, similarly to the above embodiments, the frame rate of another camera incorporating the MoPU 3012 is 100 frames/second or more (for example, 1920 frames/second), and the frame rate of the ultra-high-definition camera incorporating the IPU 3011 is 10 frames/second.

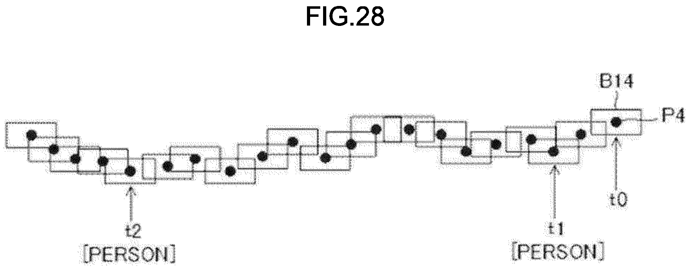

Fig. 28 is an explanatory diagram for describing an example of association between point information and label information. In the following description, the number of point information per second output from the MoPU 3012 will be referred to as an "output rate of point information", and the number of label information per second output from the IPU 3011 will be referred to as an "output rate of label information".
Fig. 28 shows a time series of an output rate of the point information P4 of an object B14. The output rate of the point information P4 of the object B14 is 1920 frames/second. The point information P4 moves from right to left in the drawing. The output rate of the label information of the object B14 is 10 frames/second, which is lower than the output rate of the point information P4.
First, at time point t0, the label information of the object B14 is not output from the IPU 3011. Therefore, at time point t0, the central brain 3015 recognizes coordinate values (position information) of the object B14 on the basis of the point information P4, but does not recognize the type of the object B14.
Next, at time point t1, label information of the object B14 is output from the IPU 3011. Therefore, the central brain 3015 derives the label information "PERSON" of the object B14 on the basis of the label information. The central brain 3015 associates the label information "PERSON" derived at time point t1 with the coordinate values (position information) of the point information P4 output from the MoPU 3012 at time point t1. As a result, at time point t1, the central brain 3015 recognizes the coordinate values (position information) of the object B14 on the basis of the point information P4 and recognizes the type of the object B14.

In Fig. 28, a timing at which the next label information of the object B14 is output from the IPU 3011 is set to time point t2. Therefore, at time point t2, the central brain 3015 derives the label information "PERSON" of the object B14 on the basis of the label information output from the IPU 3011. The central brain 3015 associates the label information "PERSON" derived at time point t2 with the coordinate values (position information) of the point information P4 output from the MoPU 3012 at time point t2.

Here, due to a frame rate difference between the other camera incorporating the MoPU 3012 and the ultra-high-definition camera incorporating the IPU 3011, in the period from time point t1 to time point t2, the point information P4 of the object B14 is acquired by the central brain 3015, but the label information is not acquired. In this case, the central brain 3015 associates the point information P4 acquired in the period from time point t1 to time point t2 with the label information "PERSON" associated with the immediately preceding time point t1. Here, the point information P4 acquired by the central brain 3015 in the period from time point t1 to time point t2 is an example of "new point information". In the example shown in Fig. 28, since the plurality of point information P4 are output from the MoPU 3012 in the period from time point t1 to time point t2, the central brain 3015 acquires the plurality of point information P4. Thus, in the example shown in Fig. 28, the central brain 3015 associates any of the plurality of point information P4 acquired in the period from time point t1 to time point t2 with the label information "PERSON" associated with the immediately preceding time point t1. Unlike the example shown in Fig. 28, in a case in which one piece of point information P4 is output from the MoPU 3012 in the period from time point t1 to time point t2, the central brain 3015 associates the one piece of point information P4 with the label information "PERSON" associated with the immediately preceding time point t1.

Here, even in a case in which a period in which the type of the object of which a motion is being tracked is uncertain occurs, the central brain 3015 continuously outputs the point information of the object at a high frame rate, and thus, there is a low risk of losing sight of the coordinate values (position information) of the object. Therefore, in a case in which the association between the point information and the label information is performed once, the central brain 3015 can presumptively assign the immediately preceding label information to the point information acquired before the next label information is acquired.

(Thirteenth Embodiment)

Next, a thirteenth embodiment of the disclosure will be described while omitting or simplifying a portion overlapping the sixth to twelfth embodiments.

Heat generation in a case in which the information processing device 1E that controls autonomous driving of the vehicle 3100 performs advanced arithmetic processing is a problem. Therefore, the thirteenth embodiment provides a vehicle 3100 having a cooling function for the information processing device 1E.

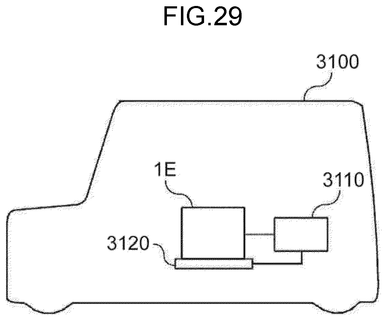

Fig. 29 is an explanatory diagram for describing a schematic configuration of the vehicle 3100. As shown in Fig. 29, the information processing device 1E, a cooling execution device 3110, and a cooling unit 3120 are mounted on the vehicle 3100.

The information processing device 1E according to the thirteenth embodiment is a device that controls autonomous driving of the vehicle 3100, and has, as an example, the configuration shown in Fig. 23 similar to that of the sixth embodiment. The cooling execution device 3110 acquires a detection result of the object from the information processing device 1E, and causes the cooling unit 3120 to cool the information processing device 1E on the basis of the detection result. The cooling unit 3120 cools the information processing device 1E by using at least one piece of cooling means such as air cooling means, water cooling means, and liquid nitrogen cooling means. Hereinafter, a cooling target in the information processing device 1E will be described as the central brain 3015 (specifically, the CPU 3014 configuring the central brain 3015) that controls the autonomous driving of the vehicle 3100, but the invention is not limited thereto.

The information processing device 1E and the cooling execution device 3110 are communicatively connected via a network (not shown). The network may be any of a vehicle network, the Internet, a local area network (LAN), and a mobile communication network. The mobile communication network may conform to any of a 5th generation (5G) communication scheme, a long term evolution (LTE) communication scheme, a 3rd generation (3G) communication scheme, and a communication scheme after a 6th generation (6G) communication scheme.

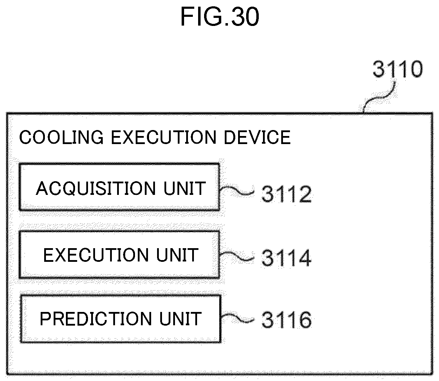

Fig. 30 is a block diagram showing an example of a functional configuration of the cooling execution device 3110. As shown in Fig. 30, the cooling execution device 3110 includes an acquisition unit 3112, an execution unit 3114, and a prediction unit 3116 as functional constituents.

The acquisition unit 3112 acquires a detection result of an object from the information processing device 1E. For example, the acquisition unit 3112 acquires point information of the object output from the MoPU 3012 as the detection result.

The execution unit 3114 executes cooling of the central brain 3015 on the basis of the detection result of the object acquired by the acquisition unit 3112. For example, in a case in which it is recognized that the object is moving on the basis of the point information of the object output from the MoPU 3012, the execution unit 3114 causes the cooling unit 3120 to start cooling the central brain 3015.

The execution unit 3114 is not limited to executing cooling of the central brain 3015 on the basis of the detection result of the object, and may execute cooling of the central brain 3015 on the basis of a prediction result of an operation status of the information processing device 1E.

Here, the prediction unit 3116 predicts an operation status of the information processing device 1E, specifically, the central brain 3015 on the basis of the detection result of the object acquired by the acquisition unit 3112. For example, the prediction unit 3116 acquires a learning model stored in a prescribed storage area. The prediction unit 3116 predicts the operation status of the central brain 3015 by inputting the point information of the object output from the MoPU 3012, acquired by the acquisition unit 3112, to the learning model. Here, the learning model outputs a status and a change amount of the computing power of the central brain 3015 as the operation status. The prediction unit 3116 may predict and output a temperature change of the information processing device 1E, specifically, the central brain 3015 together with the operation status. For example, the prediction unit 3116 predicts the temperature change of the central brain 3015 on the basis of the number of point information of the object output from the MoPU 3012 acquired by the acquisition unit 3112. In this case, the prediction unit 3116 predicts that the temperature change will increase as the number of point information increases, and predicts that the temperature change will decrease as the number of point information decreases.

In the above case, the execution unit 3114 causes the cooling unit 3120 to start cooling the central brain 3015 on the basis of the prediction result of the operation status of the central brain 3015 from the prediction unit 3116. For example, in a case in which the status and change amount of the computing power of the central brain 3015 predicted as the operation status exceed a prescribed threshold, the execution unit 3114 causes the cooling unit 3120 to start cooling. In a case in which the temperature based on the temperature change of the central brain 3015 predicted as the operation status exceeds a prescribed threshold, the execution unit 3114 causes the cooling unit 3120 to start cooling.

The execution unit 3114 may execute cooling of the central brain 3015 by using cooling means corresponding to the prediction result of the temperature change of the central brain 3015 from the prediction unit 3116. For example, the execution unit 3114 may cause the cooling unit 3120 to execute cooling by using a larger number of cooling means as the predicted temperature of the central brain 3015 becomes higher. As a specific example, in a case in which it is predicted that the temperature of the central brain 3015 will exceed a first threshold, the execution unit 3114 causes the cooling unit 3120 to execute cooling by using one piece of cooling means. On the other hand, in a case in which it is predicted that the temperature of the central brain 3015 will exceed a second threshold more than the first threshold, the execution unit 3114 causes the cooling unit 3120 to execute cooling by using a plurality of cooling means.

The execution unit 3114 may execute cooling of the central brain 3015 by using stronger cooling means as the predicted temperature of the central brain 3015 becomes higher. For example, in a case in which it is predicted that the temperature of the central brain 3015 will exceed the first threshold, the execution unit 3114 causes the cooling unit 3120 to execute cooling by using air cooling means. In a case in which it is predicted that the temperature of the central brain 3015 will exceed the second threshold more than the first threshold, the execution unit 3114 causes the cooling unit 3120 to execute cooling by using water cooling means. In a case in which it is predicted that the temperature of the central brain 3015 will exceed a third threshold more than the second threshold, the execution unit 3114 causes the cooling unit 3120 to execute cooling by using liquid nitrogen cooling means.

The execution unit 3114 may determine cooling means to be used for cooling on the basis of the number of point information of the object output from the MoPU 3012 acquired by the acquisition unit 3112. In this case, the execution unit 3114 may cause the central brain 3015 to be cooled by using stronger cooling means as the number of point information becomes larger. For example, in a case in which the number of point information exceeds the first threshold, the execution unit 3114 causes the cooling unit 3120 to execute cooling by using air cooling means. In a case in which the number of point information exceeds the second threshold more than the first threshold, the execution unit 3114 causes the cooling unit 3120 to execute cooling by using water cooling means. In a case in which the number of point information exceeds the third threshold more than the second threshold, the execution unit 3114 causes the cooling unit 3120 to execute cooling by using liquid nitrogen cooling means.

Incidentally, there is a case in which a moving object present on a roadway is detected as a trigger for the operation of the central brain 3015. For example, in a case in which a moving object present on a roadway is detected when the vehicle 3100 is performing autonomous driving, the central brain 3015 may perform arithmetic processing for controlling the vehicle 3100 with respect to the object. As described above, heat generation in a case in which the central brain 3015 that controls the autonomous driving of the vehicle 3100 performs advanced arithmetic processing is a problem. Therefore, the cooling execution device 3110 according to the thirteenth embodiment predicts heat dissipation of the central brain 3015 on the basis of the detection result of the object from the information processing device 1E, and executes cooling of the central brain 3015 before or simultaneously with the start of heat dissipation. As a result, the central brain 3015 is suppressed from becoming high temperature during the autonomous driving of the vehicle 3100, and can perform advanced calculation during the autonomous driving.

(Fourteenth Embodiment)

Next, a fourteenth embodiment of the disclosure will be described while omitting or simplifying a portion overlapping the sixth to thirteenth embodiments.

The MoPU 3012 included in the information processing device 1E according to the fourteenth embodiment derives a z coordinate value of an object as point information from an image of the object captured by the camera 3030. Hereinafter, each aspect of the information processing device 1E according to the fourteenth embodiment will be sequentially described.

An information processing device 1E according to a first aspect has the configuration shown in Fig. 24 similar to that of the seventh embodiment.

In the first aspect, the MoPU 3012 derives a z coordinate value of an object as point information from an image of the object captured by a plurality of cameras 3030, specifically, the cameras 3030L and 3030R. As described above, in a case in which one MoPU 3012 is used, it is possible to derive an x coordinate value and a y coordinate value of the object as the point information. Here, in a case in which the two MoPUs 3012 are used, it is possible to derive a z coordinate value of the object as point information on the basis of images of the object captured by the two cameras 3030 by using the principle of a stereo camera. Therefore, in the first aspect, the z coordinate value of the object is derived as the point information on the basis of the images of the object captured by the camera 3030L of the MoPU 3012L and the camera 3030R of the MoPU 3012R by using the principle of a stereo camera.

An information processing device 1E according to a second aspect has the configuration shown in Fig. 24 similar to that of the seventh embodiment.

In the second aspect, the MoPU 3012 derives an x coordinate value, a y coordinate value, and a z coordinate value of an object as point information from an image of the object captured by the camera 3030 and a radar signal based on a reflected wave of an electromagnetic wave emitted to the object by the radar 3032 from the object. As described above, the radar 3032 can acquire three-dimensional point cloud data of the object based on the radar signal. That is, the radar 3032 can detect a z-axis coordinate in the three-dimensional orthogonal coordinate system. In this case, the MoPU 3012 uses the principle of a stereo camera to combine the x coordinate value and the y coordinate value of the object imaged by the camera 3030 at the same timing as the timing at which the radar 3032 acquires the three-dimensional point cloud data of the object with the z coordinate value of the object indicated by the three-dimensional point cloud data, thereby deriving coordinate values of three coordinate axes of the object as point information.

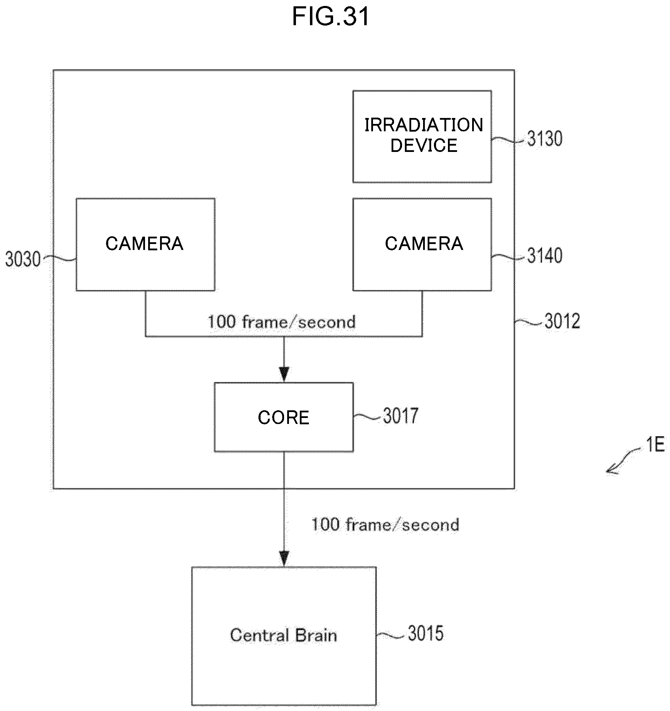

An information processing device 1E according to a third aspect has a configuration shown in Fig. 31. Fig. 31 is a five block diagram showing an example of a configuration of the information processing device 1E. Fig. 31 shows only a partial configuration of the information processing device 1E.

In the third aspect, a MoPU 3012 derives a z coordinate value of an object as point information from an image of the object captured by a camera 3030 and a result of imaging structured light applied to the object by an irradiation device 130.

As shown in Fig. 31, in the MoPU 3012, the image of the object captured by the camera 3030 and distortion information indicating a distortion of a pattern of the structured light which is a result of the camera 140 imaging the structured light applied to the object by the irradiation device 130 are input to the core 3017 at a frame rate of 100 frames/second or more. The core 3017 outputs point information to the central brain 3015 on the basis of the input image of the object and the distortion information.

Here, as one of methods for identifying a three-dimensional position or a shape of an object, there is a structured light method. The structured light method includes irradiating an object with structured light patterned in a dot shape, and acquiring depth information from a distortion of the pattern. The structured light method is disclosed, for example, in the reference document (http://ex-press.jp/wp-content/uploads/2018/10/018_teledyne_3rd.pdf).

The irradiation device 130 shown in Fig. 31 irradiates an object with structured light. The camera 140 images the structured light with which the object is irradiated by the irradiation device 130. The camera 140 outputs distortion information based on a distortion of a pattern of the imaged structured light to the core 3017.

Here, the MoPU 3012 synchronizes a timing at which the camera 3030 captures an image with a timing at which the camera 140 images structured light. Specifically, the MoPU 3012 outputs a control signal to the camera 3030 and the camera 140 to capture images at the same timing. As a result, the number of images per second captured by the camera 3030 is synchronized with the number of images per second captured by the camera 140 (for example, 1920 frames/second). As described above, the number of images per second captured by the camera 3030 and the number of images per second captured by the camera 140 are larger than the frame rate of the ultra-high-definition camera included in the IPU 3011, that is, the number of images per second captured by the ultra-high-definition camera.

The core 3017 derives a z coordinate value of the object as point information by combining the x coordinate value

and the y coordinate value of the object captured by the camera 3030 at the same timing as the timing at which the structured light is imaged by the camera 140 with the distortion information based on the distortion of the pattern of the structured light.

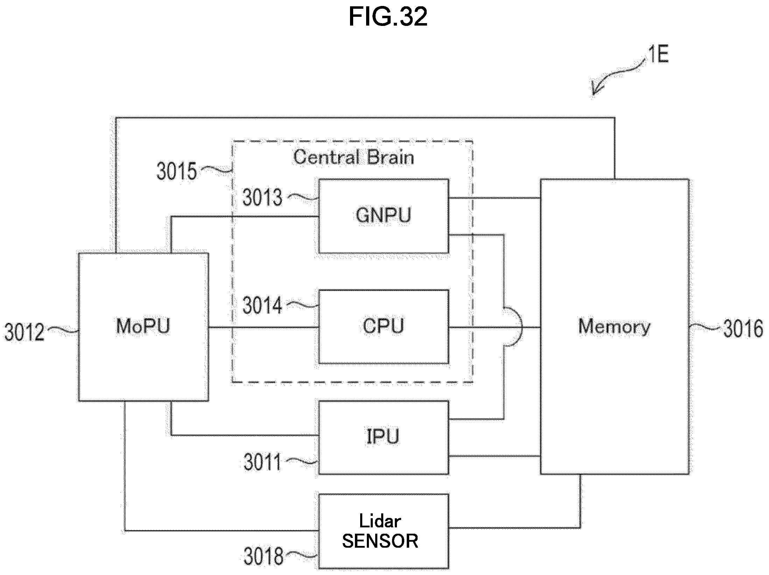

An information processing device 1E according to a fourth aspect has a configuration shown in Fig. 32. Fig. 32 is a sixth block diagram showing an example of a configuration of the information processing device 1E. Fig. 32 shows only a partial configuration of the information processing device 1E.

The block diagram shown in Fig. 32 is obtained by adding a Lidar sensor 3018 to the configuration of the block diagram shown in Fig. 23. The Lidar sensor 3018 is a sensor that acquires point cloud data including an object present in a three-dimensional space and a road surface on which the vehicle 3100 is traveling. The information processing device 1E can derive position information of the object in a depth direction, that is, a z coordinate value of the object by using the point cloud data acquired by the Lidar sensor 3018. It is assumed that the point cloud data acquired by the Lidar sensor 3018 is acquired at intervals longer than those of the x coordinate value and the y coordinate value of the object output from the MoPU 3012. The MoPU 3012 includes a camera 3030 similarly to the above-described aspect of the fourteenth embodiment.

In the fourth aspect, the MoPU 3012 uses the principle of a stereo camera to combine the x coordinate value and the y coordinate value of the object imaged by the camera 3030 at the same timing as the timing at which the Lidar sensor 3018 acquires the point cloud data of the object with the z coordinate value of the object indicated by the point cloud data, thereby deriving coordinate values of three coordinate axes of the object as point information.

Here, in the fourth aspect, the MoPU 3012 derives a z coordinate value of the object at time point t+1 as the point information from an x coordinate value, a y coordinate value, and a z coordinate value of the object at time point t and an x coordinate value and a y coordinate value of the object at a time point (for example, time point t+1) next to time point t. Time point t is an example of a "first time point", and time point t+1 is an example of a "second time point". In the fourth aspect, the z coordinate value of the object at time point t+1 is derived by using shape information, that is, geometry. Hereinafter, details thereof will be described.

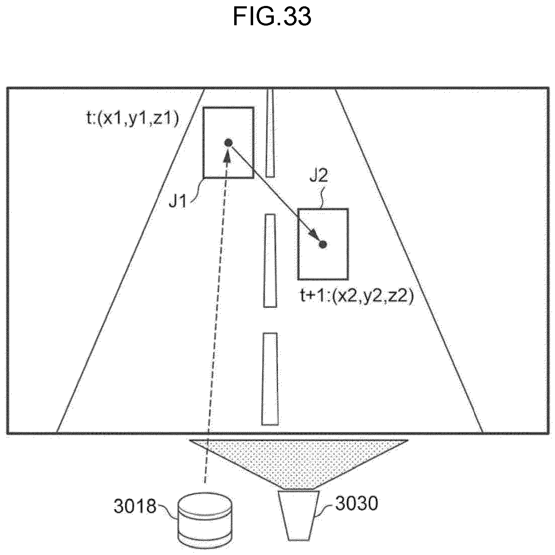

Fig. 33 is a diagram schematically showing detection of coordinates of an object in time series. In Fig. 33, J indicates a position of an object represented by a rectangle, and the position of the object moves in time series from J1 to J2. In Fig. 33, coordinate values of the object at time point t at which the object is located at J1 are (x1, y1, z1), and coordinate values of the object at time point t+1 at which the object is located at J2 are (x2, y2, z2).

First, time point t will be described.

The MoPU 3012 derives an x coordinate value and a y coordinate value of an object from an image of the object captured by the camera 3030. Subsequently, the MoPU 3012 integrates the z coordinate value of the object indicated by the point cloud data acquired from the Lidar sensor 3018, the x coordinate value, and the y coordinate value to derive three-dimensional coordinate values (x1, y1, z1) of the object at time point t.

Next, time point t+1 will be described.

The MoPU 3012 derives a z coordinate value of the object at time point t+1 on the basis of geometry of a space and changes in the x coordinate value and the y coordinate value of the object from time point t to time point t+1. The geometry of a space includes a shape of a road surface obtained from an image captured by the ultra-high-definition camera included in the IPU 3011 and the point cloud data from the Lidar sensor 3018, and a shape of the vehicle 3100.

The geometry indicating the shape of the road surface is generated in advance at time point t. The MoPU 3012 can simulate a case in which the vehicle 3100 travels on the road surface by using the geometry indicating the shape of the vehicle 3100 together with the geometry indicating the shape of the road surface, and can estimate a movement amount of each of the x-axis, the y-axis, and the z-axis.

Therefore, the MoPU 3012 derives the x coordinate value and the y coordinate value of the object at time point t+1 from the image of the object captured by the camera 3030. The MoPU 3012 can derive the z coordinate value of the object at time point t+1 by calculating the movement amount of the z axis in a case in which the object changes from the x coordinate value and the y coordinate value (x1, y1) at time point t to the x coordinate value and the y coordinate value (x2, y2) at time point t+1 through the simulation. The MoPU 3012 integrates the x coordinate value, the y coordinate value, and the z coordinate value to derive three-dimensional coordinate values (x2, y2, z2) of the object at time point t+1.

As shown in Fig. 33, since the object moves in the depth direction together with the movement in plane coordinates (that is, the x-axis and the y-axis), it is also necessary to detect the movement in the z-axis direction in order to control the autonomous driving of the vehicle 3100 with high accuracy. Here, there is a case in which the MoPU 3012 cannot acquire the z coordinate value of the object that can be derived from the point cloud data of the Lidar sensor 3018 at a speed as high as the x coordinate value and the y coordinate value of the object. Therefore, in the fourth aspect, the MoPU 3012 derives the z coordinate value of the object at time point t+1 from the x coordinate value, the y coordinate value, and the z coordinate value of the object at time point t and the x coordinate value and the y coordinate value of the object at time point t+1. As a result, according to the information processing device 1E of the fourth aspect, the MoPU 3012 can realize two-dimensional motion detection using high-speed frame shots and three-dimensional motion detection in high performance with a small amount of data.

In the above description, the case in which the MoPU 3012 derives the z coordinate value of the object as the point information from the image of the object captured by the camera 3030 has been exemplified, but the disclosed technology is not limited to this aspect. For example, instead of the MoPU 3012, the central brain 3015 may derive the z coordinate value of the object as the point information. In this case, the central brain 3015 derives the z coordinate value of the object as the point information by performing the processing executed by the MoPU 3012 in the above description on the image of the object captured by the camera 3030. As an example, the central brain 3015 derives the z coordinate value of the object as the point information from images of the object captured by the plurality of cameras 3030, specifically, the cameras 3030L and 3030R. In this case, the central brain 3015 derives the z coordinate value of the object as the point information on the basis of the images of the object captured by the camera 3030L of the MoPU 3012L and the camera 3030R of the MoPU 3012R by using the principle of a stereo camera.

(Fifteenth Embodiment)

Next, a fifteenth embodiment of the disclosure will be described while omitting or simplifying a portion overlapping the sixth to fourteenth embodiments.

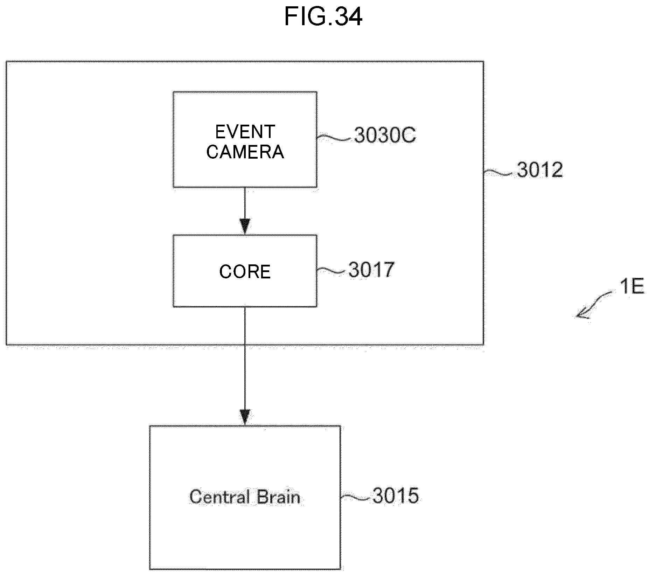

Fig. 34 is a seventh block diagram showing an example of a configuration of an information processing device 1E according to the fifteenth embodiment. Fig. 34 shows only a partial configuration of the information processing device 1E.

As shown in Fig. 34, in the MoPU 3012, an image of an object (hereinafter, referred to as an "event image" in some cases) captured by an event camera 3030C is input to the core 3017. The core 3017 outputs point information to the central brain 3015 on the basis of the input event image. The event camera is disclosed in, for example, the reference document (https://dendenblog.xyz/event-based-camera/).

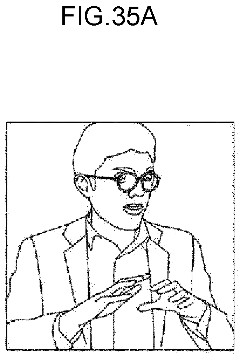

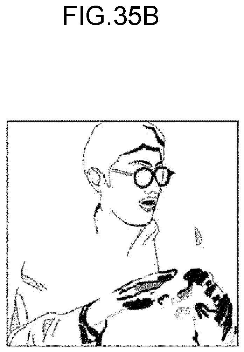

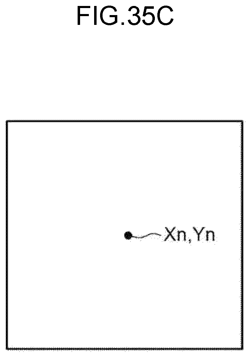

Fig. 35 is an explanatory diagram for describing an image (event image) of an object captured by the event camera 3030C. Fig. 35A is a diagram showing an object that is an imaging target of the event camera 3030C. Fig. 35B is a diagram showing an example of the event image. Fig. 35C is a diagram showing an example in which the centroid of a difference portion between an image captured at the current time and an image captured at the previous time, indicated by the event image, is calculated as point information. In the event image, a difference portion between the image captured at the current time and the image captured at the previous time is extracted as a point. Therefore, in a case in which the event camera 3030C is used, for example, as shown in Fig. 35B, points of respective moving parts in the person region shown in Fig. 35A are extracted.

On the other hand, as shown in Fig. 35C, the core 3017 extracts a person as an object and then extracts coordinates of a feature point (for example, only one point) representing a person region. As a result, an amount of data transferred to the central brain 3015 and the memory 3016 can be reduced. Since a person who is an object can be extracted from the event image at any frame rate, in the case of the event camera 3030C, the object can be extracted at a frame rate of the maximum frame rate (for example, 1920 frames/second) or higher of the camera 3030 mounted on the MoPU 3012 in the above embodiment, and point information of the object can be ascertained with high accuracy.

In the information processing device 1E according to the fifteenth embodiment, the MoPU 3012 may include a visible light camera 3030A in addition to the event camera 3030C, similarly to the above-described embodiment. In this case, in the MoPU 3012, a visible light image of the object captured by the visible light camera 3030A and an event image are input to the core 3017. The core 3017 outputs point information to the central brain 3015 on the basis of at least one of the input visible light image and event image.

For example, in a case in which the object can be identified from the visible light image of the object captured by the visible light camera 3030A, the core 3017 outputs the point information on the basis of the visible light image. On the other hand, in a case in which the object cannot be identified from the visible light image due to a prescribed factor, the core 3017 outputs the point information on the basis of the event image. The prescribed factor includes at least one of a case in which a movement speed of the object is a predetermined value or more and a case in which a light amount change of the ambient light per unit time is a prescribed value or more. For example, in a case in which the object cannot be identified from the visible light image because an action of the object is fast, the core 3017 identifies the object on the basis of the event image, and outputs an x coordinate value and a y coordinate value of the object as the point information. In a case in which the object cannot be identified from the visible light image due to a sudden change in an amount of ambient light such as backlight, the core 3017 identifies the object on the basis of the event image, and outputs an x coordinate value and a y coordinate value of the object as point information. With this configuration, according to the information processing device 1E, it is possible to selectively use the camera 3030 that images an object according to a prescribed factor.

(Sixteenth Embodiment)

Next, a sixteenth embodiment of the disclosure will be described while omitting or simplifying a portion overlapping the sixth to fifteenth embodiments.

As an example, an information processing device 1E according to the sixteenth embodiment has the configuration shown in Fig. 23 similar to that of the ninth embodiment.

In the ninth embodiment, the case in which the central brain 3015 infers the control variable by performing multivariate analysis (see, for example, Formula (2)) according to an integration method as shown in Formula (1) every time sensor information is acquired has been described. That is, in a case in which the sensor information is acquired every nanosecond, the central brain 3015 infers the control variable in units of nanoseconds by performing multivariate analysis by using the sensor information acquired each time. In contrast, in the sixteenth embodiment, the central brain 3015 calculates a control variable from a correlation between a variable and the control variable. This will be described in detail.

Similarly to the ninth embodiment, the central brain 3015 acquires sensor information detected by a sensor. Similarly to the ninth embodiment, the central brain 3015 acquires the point information output from the MoPU 3012 and the label information output from the IPU 3011. Here, the "central brain 3015" is an example of a "processor", the sensor information is an example of "detection information", the MoPU 3012 and the IPU 3011 are examples of "other processors different from each other", and the label information is an example of "identification information". That is, the processor functions as an acquisition unit that acquires detection information obtained by detecting a surrounding situation of a moving object, point information obtained by regarding an imaged object as a point, and identification information obtained by identifying an object. In this case, the processor may acquire the point information and the identification information from different processors.

Next, similarly to the ninth embodiment, the central brain 3015 calculates each variable (for example, A, B, C,..., and N in Formula (2)) such as an air resistance, a road resistance, a road element (for example, dirt), and a slip coefficient from the acquired sensor information. That is, the processor calculates a variable related to the surrounding situation of the moving object from the acquired detection information. The central brain 3015 infers a control variable Vn by using, for example, Formula (2). That is, the processor may infer a control variable through multivariate analysis according to an integration method using deep learning.

The above description is similar to the ninth embodiment, but in the sixteenth embodiment, the central brain 3015 is configured to be able to calculate a control variable Vn' from a correlation between the variable and the control variable Vn. "Vn'" indicates the control variable calculated from the correlation, but in a case in which it is not particularly necessary to distinguish from the inferred control variable "Vn", it is simply indicated as the control variable Vn. For example, in a case in which a coefficient of the variable for the control variable Vn is set in advance, the central brain 3015 may calculate the control variable Vn' by using the variable. That is, the processor may calculate the control variable Vn' by using the predetermined coefficient of the variable for the control variable Vn.

As an example, it is assumed that regression coefficients WA, WB, WC, WD,..., and WN are determined in advance as coefficients of the variables A, B, C,..., and N for the control variable Vn. In this case, in a case in which a difference of the variable A, a difference of the variable B, a difference of the variable C, a difference of the variable D,..., and a difference of the variable N are ΔA, ΔB, ΔC, ΔD,..., and ΔN, respectively, the central brain 3015 can calculate the control variable Vn' by using the following formula. That is, the central brain 3015 can calculate the control variable Vn' by performing regression analysis from the inferred control variable Vn. As described above, the processor functions as a calculation unit that calculates the control variable Vn' from the correlation between the variable related to the surrounding situation of the moving object calculated from the detection information and the control variable Vn inferred by using the variable.

$$Vn' = Vn + WA \times \Delta A + WB \times \Delta B + WC \times \Delta C + WD \times \Delta D + \ldots + WN \times \Delta N$$

In the above description, the case in which a regression coefficient is determined in advance as the coefficient of the variable for the control variable Vn has been described as an example, but the invention is not limited thereto. For example, the regression coefficient WA may be obtained according to the following formula by using a correlation coefficient rA of the variable A for the control variable Vn. The same applies to the other variables B, C,..., and N. Therefore, such a correlation coefficient may be determined in advance as a coefficient of the variable for the control variable Vn. A determination coefficient may be obtained by squaring the correlation coefficient. Therefore, such a determination coefficient (also referred to as a contribution ratio) may be determined in advance as the coefficient of the variable for the control variable Vn.

$$WA = rA \times (\text{standard deviation of } Vn / \text{standard deviation of } A)$$

As described above, any coefficient capable of calculating the control variable Vn' from a difference of the variable may be determined in advance as the coefficient of the variable for the control variable Vn. Such a coefficient may be manually set via a user input, or may be automatically set on the basis of a simulation result, a learning result obtained through machine learning of a relationship between the control variable Vn and the variable, or the like.

As a result, the central brain 3015 can maintain a derivation frequency of the control variable Vn by executing a calculation process of the control variable Vn' based on the correlation without executing an inference process of the control variable Vn every time the sensor information is acquired. In other words, in a case in which the central brain 3015 acquires the sensor information every nanosecond, for example, the central brain executes the inference process of the control variable Vn in units of 100/1 billion seconds, and a period in which the inference process is not executed can be supplemented by the calculation process of the control variable Vn' based on the correlation.

The central brain 3015 may execute the inference process of the control variable Vn in a second cycle longer than a first cycle in which the sensor information is acquired, for example. In this case, the second cycle is preferably shorter than an imaging cycle of the ultra-high-definition camera included in the IPU 3011, and more preferably shorter than an imaging cycle of another camera included in the MPU. The central brain 3015 may execute the calculation process of the control variable Vn' based on the correlation in a third cycle shorter than the second cycle in which the inference process of the control variable Vn is executed. In this case, in a case in which the third cycle is the same as the first cycle, the control variable Vn can be derived at the same frequency as the acquisition frequency of the sensor information, which is preferable.

The central brain 3015 controls autonomous driving of the vehicle 3100 on the basis of, for example, the control variable Vn derived as described above, the point information, and the label information. As described above, the processor functions as a control unit that controls the autonomous driving of the moving object on the basis of the control variable Vn, the point information, and the identification information.

As described above, the information processing device 1E according to the sixteenth embodiment calculates the control variable from the correlation between the variable and the control variable in a case of controlling the autonomous driving of the moving object on the basis of the control variable, the point information, and the identification information. As a result, according to the information processing device 1E of the sixteenth embodiment, since the control variable can be calculated from the correlation between the variable and the control variable without executing the control variable inference process every time, an execution frequency of the control variable inference process can be reduced, and accordingly, a calculation amount and a calculation time required for controlling the autonomous driving can be reduced.

(Seventeenth Embodiment)

In a case in which a vehicle is subjected to autonomous driving, the autonomous driving is controlled by using a plurality of images of the surroundings of the vehicle captured by a camera. Therefore, in the conventional autonomous driving, there is a problem that an amount of data acquired by the processor that controls the autonomous driving increases, and an amount of calculation required for the control of the autonomous driving increases. Therefore, hereinafter, as a seventeenth embodiment of the disclosure, an information processing device or the like capable of reducing an amount of calculation required for controlling autonomous driving will be described.

Next, the seventeenth embodiment of the disclosure will be described while omitting or simplifying a portion overlapping the sixth to sixteenth embodiments.

As an example, an information processing device 1E according to the seventeenth embodiment has the configuration shown in Fig. 23 similar to that of the ninth embodiment.

While the vehicle 3100 is traveling, an obstacle may approach the vehicle 3100. In this case, the vehicle 3100 preferably travels while changing the behavior of the vehicle 3100 in order to avoid contact with or collision with the obstacle. Examples of the obstacle include other vehicles other than the own vehicle that is traveling, wall surfaces, guard rails, curbstones, and other installed objects. In the following description, a case in which another vehicle approaching the vehicle 3100 is applied as an example of the obstacle will be described.

Similarly to the ninth embodiment, the central brain 3015 controls the in-wheel motors respectively mounted on the four wheels on the basis of a control variable calculated in accordance with a state of traveling on the traveling path, which changes from moment to moment, thereby controlling a wheel speed and an inclination of each of the four wheels and the suspension supporting each of the four wheels to perform autonomous driving. Similarly to the ninth embodiment, the central brain 3015 acquires sensor information from a sensor that detects a surrounding situation of the vehicle 3100 (for example, a behavior of another vehicle).

The central brain 3015 has a function of predicting a collision including contact with an obstacle with respect to the vehicle 3100 from the acquired sensor information in order to travel while avoiding at least the obstacle.

The central brain 3015 may acquire sensor information every nanosecond from a sensor that detects a surrounding situation of the vehicle 3100. That is, the processor may acquire the detection information from a detection unit that detects the surrounding situation of the moving object in the second cycle shorter than the first cycle in which the surroundings of the moving object are imaged.

The central brain 3015 according to the embodiment divides a period in which collision prediction of an obstacle with respect to the vehicle 3100 based on the sensor information can be performed into a plurality of periods. The period during which the collision prediction can be performed is set in advance to a value such as 0.3 seconds. The period during which the collision prediction can be performed may be dynamically set according to a vehicle speed or the like. For example, the central brain 3015 divides a period in which collision prediction of an obstacle with respect to the vehicle 3100 can be performed into three periods such as an initial period, a middle period, and a late period. The central brain 3015 may divide the period in which the collision prediction of the obstacle with respect to the vehicle 3100 can be performed into two periods, or may divide the period into four or more periods.

The central brain 3015 of the embodiment calculates a control variable for controlling the autonomous driving of the vehicle 3100 by using a plurality of input parameters (for example, inputs in the above Formulas (1) and (2)) based on sensor information in each of a plurality of periods according to the time series of the plurality of periods. In a case in which a control variable is calculated in the second or subsequent period of the plurality of periods, the central brain 3015 may calculate the control variable by reducing the number of input parameters compared with the previous period.

For example, in the initial period of the three periods, the central brain 3015 of the embodiment predicts a collision direction by performing exhaustive collision prediction based on all sensor information. Next, the central brain 3015 predicts a collision site of the obstacle in the vehicle 3100 in the middle period of the three periods. In the late period of the three periods, the central brain 3015 determines a collision site and determines a countermeasure.

As a specific example, the central brain 3015 predicts collision of the obstacle from the left front of the vehicle 3100 on the basis of all sensor information in the initial period. Next, the central brain 3015 predicts the left fender as the collision site of the obstacle in the vehicle 3100 on the basis of the sensor information obtained by detecting the situation on the left front side of the vehicle 3100. As described above, in the middle period, the central brain 3015 can reduce the number of input parameters used for calculating the control variable on the basis of the prediction result in the initial period.

The central brain 3015 determines the collision site and determines a countermeasure on the basis of the sensor information indicating that the surrounding situation of the left fender has been detected. This countermeasure includes collision avoidance. In a case in which the collision is unavoidable, this countermeasure includes performing collision so that the degree of damage of the vehicle 3100 decreases. As described above, in the late period, the central brain 3015 can reduce the number of input parameters used for calculating the control variable on the basis of the prediction results in the initial period and the middle period.

As described above, according to the seventeenth embodiment, it is possible to reduce an amount of calculation required for the control of the autonomous driving.

(Eighteenth Embodiment)

Incidentally, in a case in which autonomous driving is provided, a function of predicting collision is required in order to avoid collision with an obstacle. However, it is desirable to expand a prediction target from the collision of the obstacle to the approach of the obstacle. Therefore, an information processing device or the like capable of predicting the approach of an obstacle will be described below as an eighteenth embodiment of the disclosure.

Next, the eighteenth embodiment according to the embodiment will be described while omitting or simplifying a portion overlapping the sixth to seventeenth embodiments.

As an example, an information processing device 1E according to the eighteenth embodiment has the configuration shown in Fig. 23 similar to that of the ninth embodiment.

While a vehicle is traveling, an obstacle may approach the vehicle. In this case, the vehicle preferably travels while changing a behavior of the vehicle in order to avoid contact with or collision with the obstacle. Examples of the obstacle include other vehicles other than the own vehicle that is traveling, wall surfaces, guard rails, curbstones, and other installed objects. In the following description, a case in which another vehicle approaching the vehicle 100 is applied as an example of the obstacle will be described. The obstacle is an example of a target object.

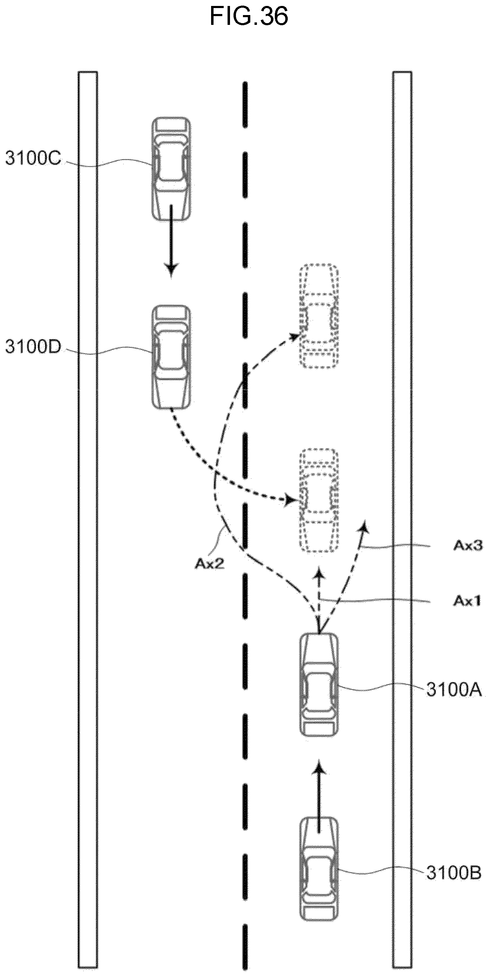

Fig. 36 is a diagram schematically showing a state in which other vehicles 3100B, 3100C, and 3100D are traveling around an own vehicle 3100A, in which the own vehicle 3100A is the vehicle 3100 traveling on a road with two opposite lanes. In the example in the drawing, another vehicle 3100B is traveling following the own vehicle 3100A, still another vehicle 3100D is traveling ahead in the opposite lane, and yet still another vehicle 3100C is traveling following the vehicle 3100D.

The central brain 3015 of the own vehicle 3100A controls the in-wheel motors mounted on the four wheels on the basis of the above-described control variables calculated in accordance with a state of traveling on the traveling path that changes from moment to moment, thereby controlling a wheel speed and an inclination of each of the four wheels and the suspension supporting each of the four wheels to perform autonomous driving. The central brain 15 acquires sensor information from a sensor that detects a surrounding situation of the own vehicle 3 100A (for example, behaviors of the other vehicles 3100B, 3100C, and 3100D). Here, the "central brain 3015" is an example of a "processor", the "sensor" is an example of a "detection unit", and the "sensor information" is an example of "detection information".

The central brain 3015 has a function of predicting a collision including contact with an obstacle serving as a target object with respect to the own vehicle from the acquired sensor information in order to travel while avoiding at least the obstacle. As shown in Fig. 36, in a case in which it is predicted from the sensor information that the vehicle 3100D will enter in front of the own vehicle 3100A, the central brain 3015 calculates a control variable indicating a behavior of the own vehicle 3100A capable of avoiding contact with at least the vehicle 3100D.

For example, in the example shown in Fig. 36, the own vehicle 3100A collides with the vehicle 3100D on a routeAx1 on which the own vehicle 3100A is traveling in the current traveling state. Therefore, the central brain 3015 calculates routes such as a routeAx2 and a routeAx3 for avoiding collision with the vehicle 3100D, selects one of the routes, and calculates a control variable. In selection of a route, a route providing (for example, a minimum value of) a control variable in which a load caused by the control variable in the own vehicle 3100A is smaller than a prescribed value determined in advance is selected.

Although it has been described that the central brain 3015 has a function of predicting collision with an obstacle, the central brain 3015 further has a function of predicting approach of an obstacle. The central brain 3015 may acquire sensor information every nanosecond from a sensor that detects a surrounding situation of the own vehicle 3100A. That is, the processor may acquire the detection information from a detection unit that detects the surrounding situation of the moving object in the second cycle shorter than the first cycle in which the surroundings of the moving object are imaged.

The central brain 3015 may calculate a distance between the own vehicle 3100A and the vehicle 3100C on the basis of the detection information, and predict the approach of the vehicle 3100C on the basis of the calculated distance and a predetermined margin.

For example, in a case in which the routeAx2 is selected as a route for avoiding collision with the vehicle 3100D and the own vehicle 3100A travels along the routeAx2, it is conceivable that the own vehicle 3100A approaches the vehicle 3100C traveling behind the vehicle 3100D. Therefore, the central brain 3015 may calculate a distance between the own vehicle 3100A and the vehicle 3100C on the basis of the sensor information, and compare the calculated distance with the margin to predict the approach of the vehicle 3100C.

The margin may be a predetermined value, may be a value experimentally obtained in advance, or may be a value acquired in advance via a user input. Fear of an approach of an obstacle is not uniform, and varies from person to person. Therefore, the margin may be determined in advance for each occupant of the own vehicle 3100A. In particular, it is also conceivable that children and elderly people have strong fear of approaching obstacles. Therefore, the margin may be determined in advance for each age of an occupant of the own vehicle 3100A.

In setting the margin, for example, a camera image obtained by imaging the inside of the own vehicle 3100A may be subjected to face authentication to identify an occupant of the own vehicle 3100A, and a margin set for each occupant may be set. Alternatively, an age of an occupant of the own vehicle 3100A may be estimated by analyzing a camera image, and a predetermined margin may be set for each age. In a case in which a plurality of people get on the own vehicle 100A, the central brain 3015 may set a margin determined to be the largest value among a plurality of margins, that is, may set a margin according to an occupant having the strongest fear.

Fear of approach becomes stronger according to a movement speed. Therefore, the central brain 3015 may change the set margin according to a movement speed of the own vehicle 3100A or the vehicle 3100C, preferably a sum of the movement speeds of the own vehicle 3100A and the vehicle 3100C. In particular, a braking distance corresponding to traveling until the vehicle 3100 stops after the brake is activated is generally proportional to the square of the speed of the vehicle 3100. Therefore, the central brain 3015 may change the set margin according to a braking distance of the own vehicle 3100A or the vehicle 3100C, preferably a sum of the braking distances of the own vehicle 3100A and the vehicle 3100C. Such a braking distance differs depending on not only a speed of the vehicle 3100 but also a state of a road surface, a weight of the vehicle 3100, the number of passengers, a cargo, a condition of the tire, and the like. Therefore, in a case in which these information can be acquired, the central brain 3015 may change the margin in consideration of these information.

Here, it is assumed that a margin M is set and the margin M is changed to a margin M'. In this case, the central brain 3015 may compare a distance Dac between the own vehicle 3100A and the vehicle 3100C with the margin M'. In a case in which $Dac > M'$, the central brain 3015 may predict that the vehicle 3100C will not approach. On the other hand, in a case in which $Dac \leq M'$, the central brain 3015 may predict that the vehicle 3100C will approach.

The central brain 3015 may control the autonomous driving of the own vehicle 3100A on the basis of a predicted result. For example, in a case in which the vehicle 3100C is predicted to approach, the central brain 3015 may correct the route Ax2 such that the protrusion to the opposite lane is reduced. In a case in which the vehicle 3100C is predicted to approach, the central brain 3015 may increase a vehicle speed of the own vehicle 3100A to return from the opposite lane early.

As described above, the information processing device 1E according to the eighteenth embodiment acquires the detection information from the detection unit that detects the surrounding situation of the moving object in the second cycle shorter than the first cycle of capturing the surroundings of the moving object, calculates the distance between the moving object and the obstacle on the basis of the detection information, and predicts the approach of the obstacle on the basis of the calculated distance and the predetermined margin. As a result, according to the information processing device 1E of the eighteenth embodiment, it is possible to provide a function of predicting the approach of an obstacle. In this case, the margin may be determined in advance for each occupant of the moving object or for each age. As a result, according to the information processing device 1E of the eighteenth embodiment, it is possible to improve a sense of security for each occupant. The information processing device 1E according to the eighteenth embodiment can change a margin according to a movement speed or a braking distance of the moving object or the obstacle. As a result, according to the information processing device 1E of the eighteenth embodiment, it is possible to predict the approach of the obstacle in conjunction with the fear of the occupant. The information processing device 1E according to the eighteenth embodiment can also control the autonomous driving of the moving object on the basis of the result predicted as described above. As a result, according to the information processing device 1E of the eighteenth embodiment, in a case in which the approach of the obstacle is predicted, it is possible to perform autonomous driving of the moving object more safely.

(Nineteenth Embodiment)

Meanwhile, in a case in which autonomous driving is provided, an unavoidable collision with an obstacle may occur. In such a case, it is desirable to control a portion with which an obstacle will collide. Therefore, hereinafter, as an eighteenth embodiment of the disclosure, an information processing device or the like capable of controlling a portion with which an obstacle will collide will be described.

The nineteenth embodiment of the disclosure will be described while omitting or simplifying a portion overlapping the sixth to eighteenth embodiments.

As an example, the information processing device 1E according to the nineteenth embodiment has the configuration shown in Fig. 23 similar to that of the ninth embodiment.

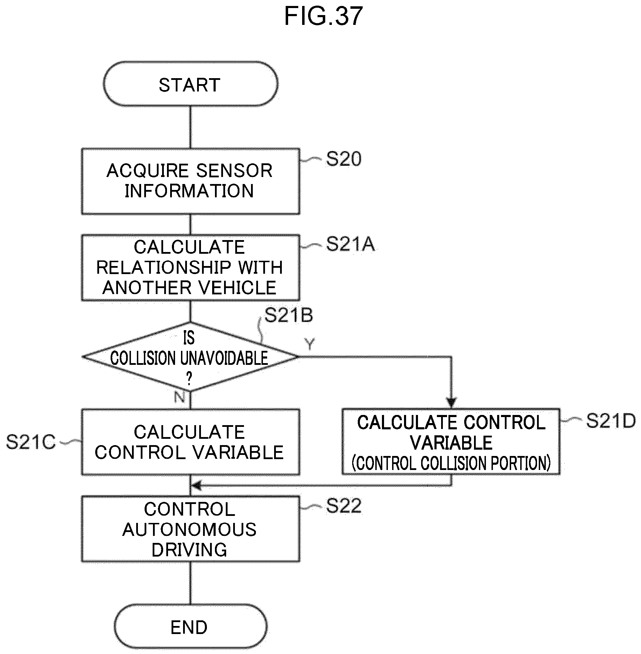

Fig. 37 is a flowchart showing an example of a flow of processing in the central brain 3015 that can control a portion with which an obstacle will collide. Here, examples of the obstacle include other vehicles other than the own vehicle that is traveling, wall surfaces, guard rails, curbstones, and other installed objects. In the following description, a case in which another vehicle approaching the vehicle 3100 is applied as an example of the obstacle will be described. While the vehicle 3100 is traveling, another vehicle may approach the vehicle 3100. In this case, the vehicle 3100 preferably travels while changing a behavior of the vehicle 3100 in order to avoid contact with or collision with another vehicle.

However, in a case in which it is difficult to avoid a collision with another vehicle, that is, an unavoidable collision with an obstacle may occur. In order to cope with such a case, the central brain 3015 executes the flow shown in the drawing.

In step S20, as described above, the central brain 15 may acquire the sensor information every nanosecond from the sensor that detects the surrounding situation of the vehicle 3100 (including behaviors of other vehicles). Here, the "central brain 3015" is an example of a "processor", the "vehicle" is an example of a "moving object", the "sensor" is an example of a "detection unit", and the "sensor information" is an example of "detection information". That is, the processor may function as an acquisition unit that acquires the detection information from the detection unit that detects the surrounding situation of the moving object in the second cycle shorter than the first cycle of imaging the surroundings of the moving object.

In step S21A, the central brain 3015 may calculate a relationship between the own vehicle and another vehicle. For example, the central brain 3015 may calculate positions, a distance, relative speeds, and the like between the own vehicle and another vehicle on the basis of the sensor information acquired in step S20.

In step S21B, the central brain 3015 may predict a collision with another vehicle and determine whether the collision is unavoidable. For example, the central brain 3015 may determine whether the collision is unavoidable, by using the relationship calculated in step S21A and a predetermined threshold for collision determination. That is, the processor may function as a prediction unit that predicts the collision of an obstacle with respect to the moving object on the basis of the detection information.

In a case in which it is determined in step S21B that the collision is not unavoidable (No), the central brain 3015 causes the processing to proceed to step S21C. In step S21C, the central brain 3015 calculates a control variable. For example, the central brain 3015 calculates a control variable by using the same method as in the ninth embodiment on the basis of the sensor information acquired in step S20. On the other hand, in a case in which it is determined in step S21C that the collision is unavoidable (Yes), the central brain 3015 causes the processing to proceed to step S21D.

In step S21D, the central brain 3015 calculates a control variable for controlling a collision portion. For example, the central brain 3015 may calculate at least one of a collision angle and a vehicle speed of the vehicle 3100 that satisfy a constraint condition that another vehicle collides with a predetermined portion of the vehicle 3100. That is, in a case in which the predicted result indicates an unavoidable collision, the processor may function as a calculation unit that calculates a control variable for controlling the autonomous driving of the moving object so that the obstacle collides with a predetermined portion of the moving object.

Here, the central brain 3015 may set in advance, as the collision portion, a portion where the damage caused by the collision is a threshold or less, preferably the minimum. That is, the processor may function as a setting unit that sets, as the predetermined portion, a portion where the damage generated in a case in which the obstacle collides with the moving object satisfies a predetermined standard. Such a portion may be, for example, a portion where the rigidity of the vehicle 3100 is a predetermined threshold or more. Such a portion may be a portion where a distance from an engine, a motor, or a battery, which is a main component mounted on the vehicle 3100, is a predetermined threshold or more. Such a portion may be a portion where a distance from an occupant in the vehicle 3100 is a predetermined threshold or more. In the above description, the case of considering only the damage on the vehicle 3100 side has been described as an example, but in addition to this, the damage on another vehicle side may also be considered. That is, the central brain 3015 may calculate a control variable so that the vehicle 3100 collides with a predetermined portion in another vehicle.

In specifying a portion where the damage satisfies a predetermined standard, the central brain 3015 may receive a user input, and the user may manually specify such a portion. Alternatively, the central brain 3015 may receive an input of a design drawing/document (at least one of a design drawing, a design document, or a specification) related to the vehicle 3100 and automatically specify such a portion from the input design drawing/document. In this case, for example, the central brain 3015 may score a rigidity, a distance from a main component, and a distance from an occupant for each portion on the basis of the design drawing/document, and specify a portion having the largest addition sum (or weighted addition sum) of the scores. As described above, the processor may function as an input unit that receives an input of a design drawing/document related to the moving object, and a specifying unit that specifies a portion where the damage satisfies a predetermined standard on the basis of the design drawing/document.

In step S22, the central brain 3015 controls autonomous driving. For example, the central brain 3015 controls the autonomous driving on the basis of the control variable calculated in step S21C or step S21D. The central brain 3015 ends the processing in the flowchart.

As described above, the information processing device 1E according to the nineteenth embodiment acquires the detection information from the detection unit that detects the surrounding situation of the moving object in the second cycle shorter than the first cycle of imaging the surroundings of the moving object, predicts the collision of the obstacle with the moving object on the basis of the detection information, and calculates the control variable for controlling the autonomous driving of the moving object such that the obstacle will collide with a predetermined portion of the moving object in a case in which the predicted result indicates an unavoidable collision. As a result, according to the information processing device 1E of the nineteenth embodiment, even in a case in which an unavoidable collision with an obstacle occurs, it is possible to control a portion with which the obstacle will collide. In this case, the information processing device 1E according to the nineteenth embodiment may set, as the predetermined portion, a portion where the damage generated in a case in which the obstacle collides with the moving object satisfies a predetermined standard. As a result, according to the information processing device 1E of the nineteenth embodiment, it is possible to reduce and preferably minimize the damage caused by the collision. More specifically, by setting, as such a portion, at least one of a portion of which the rigidity is a predetermined threshold or more in the moving object, a portion where a distance from the engine, the motor, or the battery mounted on the moving object is a predetermined threshold or more, and a portion where a distance from an occupant of the moving object is a predetermined threshold or more, according to the information processing device 1E of the nineteenth embodiment, a recess of the moving object, the damage of the main component, the injury of the occupant, or the like can be reduced, preferably minimized. The information processing device 1E according to the nineteenth embodiment may receive an input of a design drawing/document related to the moving object, and specify a portion where the damage satisfies a predetermined standard on the basis of the design drawing/document. As a result, according to the information processing device 1E of the nineteenth embodiment, it is possible to automatically specify a portion that reduces the damage without manual intervention.

(Twentieth Embodiment)

Incidentally, in the case of performing autonomous driving of a vehicle, in a case in which the vehicle collides with an obstacle, it is preferable to promptly provide a notification. Therefore, in the following description, as a twentieth embodiment of the disclosure, an information processing device or the like capable of promptly providing a notification in a case in which a vehicle collides with an obstacle will be described.

Next, the twentieth embodiment of the disclosure will be described while omitting or simplifying a portion overlapping the sixth to nineteenth embodiments.

As an example, the information processing device 1E according to the twentieth embodiment has the configuration shown in Fig. 23 similar to that of the ninth embodiment.

While the vehicle 3100 is traveling, an obstacle may approach the vehicle 3100. In this case, the vehicle 3100 preferably travels while changing the behavior of the vehicle 3100 in order to avoid contact with or collision with the obstacle. Examples of the obstacle include other vehicles other than the own vehicle that is traveling, wall surfaces, guard rails, curbstones, and other installed objects. In the following description, a case in which another vehicle approaching the vehicle 3100 is applied as an example of the obstacle will be described.

Similarly to the ninth embodiment, the central brain 3015 controls the in-wheel motors respectively mounted on the four wheels on the basis of the control variables calculated in accordance with the state of traveling on the traveling path, which changes from moment to moment, thereby controlling a wheel speed and an inclination of each of the four wheels and the suspension supporting each of the four wheels to perform autonomous driving. Similarly to the ninth embodiment, the central brain 3015 acquires sensor information from a sensor that detects a surrounding situation of the vehicle 3100 (for example, a behavior of another vehicle).

The central brain 3015 has a function of predicting a collision including contact with an obstacle with respect to the vehicle 3100 from the acquired sensor information in order to travel while avoiding at least the obstacle.

The central brain 3015 may acquire sensor information every nanosecond from a sensor that detects a surrounding situation of the vehicle 3100. That is, the processor may acquire the detection information from a detection unit that detects the surrounding situation of the moving object in the second cycle shorter than the first cycle in which the surroundings of the moving object are imaged.

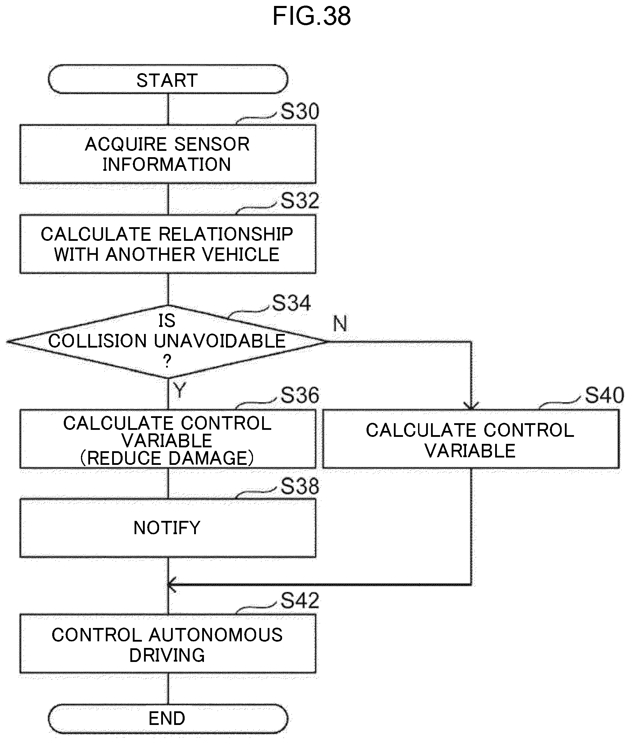

Fig. 38 is a flowchart showing an example of a flow of processing that enables reduction of damage generated in the vehicle 3100 in an unavoidable collision and is executed by the central brain 3015.

In step S30, as described above, the central brain 3015 acquires sensor information from the sensor that detects a surrounding situation of the vehicle 3100. In step S32, the central brain 3015 calculates a relationship between the own vehicle and another vehicle. For example, the central brain 3015 may calculate positions, a distance, relative speeds, and the like between the own vehicle and another vehicle on the basis of the sensor information acquired in step S30.

In step S34, the central brain 3015 predicts a collision of another vehicle and determines whether the collision is unavoidable. For example, the central brain 3015 may determine whether the collision is unavoidable by using the relationship calculated in step S32 and a predetermined threshold for collision determination. That is, the processor may function as a prediction unit that predicts the collision of the obstacle with respect to the moving object on the basis of the detection information. In a case in which the determination in step S34 is a positive determination, that is, in a case in which it is determined that the collision is unavoidable, the process proceeds to step S36.

In step S36, the central brain 3015 calculates a control variable for reducing the damage generated in the vehicle 3100 in the unavoidable collision. For example, the central brain 3015 may calculate a control variable corresponding to the damage in which the damage generated in the vehicle 3100 in the unavoidable collision is a predetermined threshold or less. At least one of a deformation position and a deformation amount of the vehicle 3100 may be applied as the damage generated in the vehicle 3100. At least one of a collision angle of the vehicle 3100 and a vehicle speed may be applied as the control variable corresponding to the damage generated in the vehicle 3100.

In step S38, the central brain 3015 provides a notification to a preset contact address via a communication line. Examples of the contact address in this case include an emergency call destination of a police station and an emergency call destination of a fire department. Examples of the contact address in this case include an owner of the vehicle 3100 and a family member of the owner of the vehicle 100. In a case in which the process in step S38 is ended, the process proceeds to step S32.

On the other hand, in a case in which the determination in step S34 is a negative determination, that is, in a case in which it is determined that the collision is not unavoidable, the process proceeds to step S40. In step S40, the central brain 3015 calculates a control variable. For example, the central brain 3015 calculates the control variable by using the same method as in the ninth embodiment on the basis of the sensor information acquired in step S30. In a case in which the process in step S40 is ended, the process proceeds to step S42.

In step S42, the central brain 3015 controls autonomous driving. For example, the central brain 3015 controls the autonomous driving on the basis of the control variable calculated in step S36 or step S40. In a case in which the process in step S42 is ended, the processing in the flowchart is ended.

As described above, according to the twentieth embodiment, it is possible to promptly provide a notification in a case in which a vehicle collides with an obstacle.

In the above several embodiments, the process to be executed by each processor (for example, the IPU 3011, the MoPU 3012, and the central brain 3015) is merely an example, and a processor that executes each process is not limited. For example, the process executed by the MoPU 3012 in the above embodiment may be executed by the central brain 3015 instead of the MoPU 3012, or may be executed by a processor other than the IPU 3011, the MoPU 3012, and the central brain 3015.

(Twenty-first Embodiment)

Hereinafter, as a twenty-first embodiment of the disclosure, an information processing device or the like that protects an occupant at the time of a collision with another vehicle or an object and a secondary collision in a vehicle having an autonomous driving function will be described.

In the above-described fifth embodiment, as shown in Fig. 19, an example of a case in which a collision of the own vehicle 2012A with another surrounding vehicle (for example, other vehicles 2012B, 2012C, and 2012D) is unavoidable in the above-described process for reducing the damage has been described. In contrast, in the twenty-first embodiment, a process for reducing the damage in the case of colliding with not only another vehicle but also another vehicle and then re-colliding with another object is executed. Here, the re-collision includes a secondary collision, a tertiary collision, and the like. Differences from the fifth embodiment will be described below. The same constituents as those described in the fifth embodiment will be denoted by the same reference numerals, and detailed description thereof will be omitted.

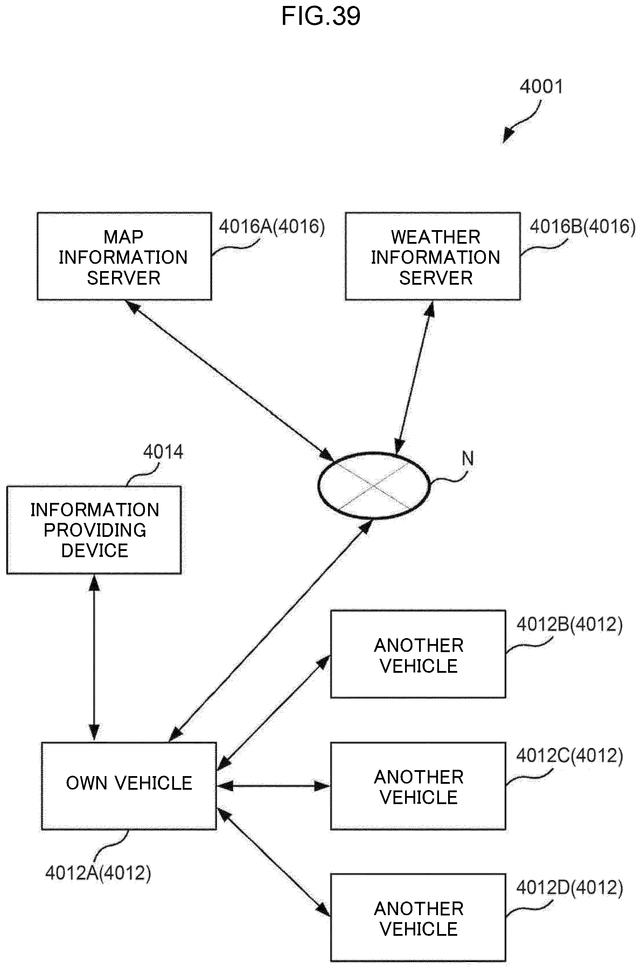

Fig. 39 is a configuration diagram of a vehicle system 4001 according to the embodiment. As shown in Fig. 39, the vehicle system 4001 according to the embodiment includes a plurality of vehicles 4012, information providing device 4014, and server 4016. The vehicles 4012 include an own vehicle 4012A and other vehicles 4012B, 4012C, and 4012D traveling around the own vehicle 4012A. In the embodiment, a central brain 4120 serving as an information processing device is mounted on each of the other vehicles 4012B, 4012C, and 4012D in addition to the own vehicle 4012A, but the invention is not limited thereto. The information providing device 4014 and the server 4016 are examples of external devices.

The information providing device 4014 is a monitoring unit including a camera, a radar, and the like. The information providing device 4014 is installed around a traveling path on which the vehicle 4012 travels, for example, at an upper part of a traffic light, a post of a street lamp, a gate that supports a sign, or the like.

As an example, the server 4016 includes a map information server 4016A and a weather information server 4016B. The map information server 4016A has a map information database, and can provide detailed map information as map information to the own vehicle 4012A. The detailed map is a map including information regarding topography and structures around the traveling path. The weather information server 4016B can provide the own vehicle 4012A with weather information at present and in the near future (for example, one hour ahead). The map information server 4016A and the weather information server 4016B are connected to the own vehicle 4012A via a public network N. In Fig. 39, the map information server 4016A and the weather information server 4016B are connected to only the own vehicle 4012A, but are not limited thereto, and may be connected to other vehicles 4012B, 4012C, and 4012D.

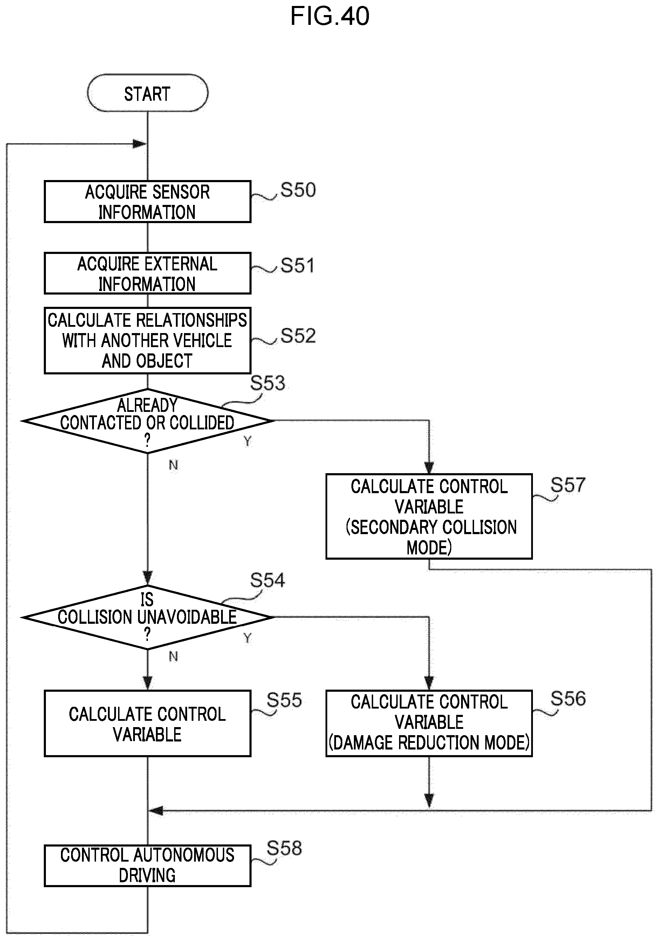

Fig. 40 is a flowchart showing an example of a flow of processing in the central brain 4120 that can reduce damage generated in the own vehicle 4012A in an unavoidable collision. The processes in steps S50 and S51 are an example of the function of the acquisition unit. The processes in steps S52 to S57 are an example of the function of the calculation unit. The process in step S58 is an example of the function of the control unit.

In step S50 in Fig. 40, the central brain 4120 acquires sensor information including road information detected by the sensor.

In step S51, the central brain 4120 acquires external information. Specifically, the central brain 4120 acquires a captured image of surroundings of the own vehicle 4012A, detection data of the vehicle and an object, and information regarding a traffic light or the like from the information providing device 4014. The central brain 4120 acquires map information from the map information server 4016A and acquires weather information from the weather information server 4016B.

In step S52, the central brain 4120 calculates a relationship between the own vehicle 4012A and another vehicle or an object. Specifically, the central brain 4120 calculates a position and a speed of another vehicle type (a vehicle size of a two-wheeled vehicle, a large-wheeled vehicle, or the like, whether the vehicle is communicative vehicle (other vehicles 4012B, 4012C, 4012D), or the like) with respect to the own vehicle 4012A. The central brain 4120 calculates the type (a human, an animal, a falling object, or the like), a position, and a speed of an object on the traveling path with respect to the own vehicle 4012A.

In step S53, the central brain 4120 determines whether the own vehicle 4012A has already come into contact with or collided with another vehicle or the object. In a case in which the central brain 4120 determines that the own vehicle 4012A has already come into contact with or collided with another vehicle or an object (case of Y in step S53), the process proceeds to step S57. On the other hand, in a case in which the central brain 4120 determines that the own vehicle 4012A has not yet come into contact with or collided with another vehicle or the object, that is, has not come into contact with or collided with another vehicle or the object (N in step S53), the process proceeds to step S54.

In step S54, the central brain 4120 determines whether or not the own vehicle 4012A is unavoidably collided with another vehicle or the object. In a case in which the central brain 4120 determines that the own vehicle 4012A is unavoidably collided with another vehicle or the object (Y in step S54), the process proceeds to step S56. On the other hand, in a case in which the central brain 4120 determines that the own vehicle 4012A is not unavoidably collided with another vehicle or an object (N in step S54), the process proceeds to step S55.

In step S55, the central brain 4120 calculates the above 16 control variables (Vn, Rn, Cn, Sn) on the basis of the sensor information acquired in step S50 and the external information acquired in step S51. The process proceeds to step S58.

In step S56, the central brain 4120 calculates, as a damage reduction mode, the control variables (Vn, Rn, Cn, Sn) for reducing the damage generated in the own vehicle 4012A in the unavoidable collision on the basis of the sensor information acquired in step S50 and the external information acquired in step S51. The process proceeds to step S58.

In a case in which it is determined in step S53 that the own vehicle 4012A has already come into contact or collided, step S57 is executed. In step S57, the central brain 4120 calculates, as a re-collision mode, the control variables (Vn, Rn, Cn, Sn) for reducing the damage generated in the own vehicle 4012A at the time of re-collision on the basis of the sensor information acquired in step S50 and the external information acquired in step S51. The process proceeds to step S58.

In step S58, the central brain 4120 controls the autonomous driving of the own vehicle 4012A on the basis of the calculated control variables. The process returns to step S50.

According to the embodiment, similarly to the fifth embodiment, in a case in which the own vehicle 4012A is unavoidably collided, a control variable indicating a relationship in which the risk is minimized is calculated on the basis of a correlation between the own vehicle 4012A and another vehicle or an object. Even in a case in which the own vehicle 4012A has already come into contact with or collided with another vehicle or an object, a control variable indicating a relationship in which the risk is minimized is calculated on the basis of a correlation with another vehicle or an object. For example, in a case in which the own vehicle 4012A protrudes to an opposite lane due to a reaction after the own vehicle 4012A has collided with another vehicle, a control variable is calculated to minimize the damage in a case in which the own vehicle 4012A collides with another vehicle again. For example, in a case in which the outside of the traveling path is a cliff, the control variable is calculated to keep the own vehicle 4012A on the traveling path so that the own vehicle 4012A does not fall on the cliff due to a reaction when the own vehicle collides with another vehicle.

As described above, according to the information processing device (specifically, the central brain 4120) of the embodiment, at the time of collision of the own vehicle 4012A, it is possible to accurately calculate an incident angle with respect to a colliding counterpart, a reflection angle, a repulsive speed, a movement distance, and a movement direction after the collision, and to prevent secondary damage due to the re-collision such as a secondary collision and a tertiary collision after the collision. It may be determined whether to stop a collision in the primary collision, stop a collision in the secondary collision, or allow a collision after the tertiary collision according to a collision target, the time until the collision, a surrounding environment, and the like.

According to the embodiment, the own vehicle 4012A and another vehicle 4012 (for example, the following vehicle) or another object (for example, a pedestrian or an animal) around a colliding counterpart are also considered, and the own vehicle 4012A collides with the counterpart again. Accordingly, consideration for surrounding vehicles is also achieved.

According to the embodiment, it is possible to prepare for the re-collision in consideration of a surrounding situation of the own vehicle 4012A (for example, the presence of a cliff or a guardrail). For example, the central brain 4120 also calculates to which position the own vehicle 4012A and the counterpart repel and move after the collision in consideration of the surrounding situation (whether the surrounding is a cliff, a guardrail, or a sidewalk) at the time of collision. In particular, in a case in which the surrounding is a cliff or a sidewalk with a person, a method of re-collision is calculated such that the own vehicle 4012A or the counterpart does not move in a direction thereof after the collision, and in a case in which the surrounding is a sidewalk or a street tree with no person, or a guardrail, the calculation is performed such that the own vehicle or the counterpart may slightly re-collide in a direction thereof. Through the calculation, the central brain 4120 calculates the control variables (Vn, Rn, Cn, Sn).

(Twenty-second Embodiment)

In the above-described embodiment, for example, the first embodiment, the control of a vehicle is realized by obtaining an index value, but instead of this, the control of a vehicle can also be realized by obtaining a control variable used for driving control. Therefore, an information processing device and the like using a control variable will be described below as a twenty-second embodiment of the disclosure.

The information processing device according to the embodiment may obtain a control variable necessary for driving control with high accuracy on the basis of a large amount of information related to vehicle control. The information processing device described below is similar to that of the first embodiment except that a control variable is used, and thus, in order to avoid duplicate description, the description of the same configuration and the like as those of the first embodiment will be omitted.

The information processing device according to the embodiment can be realized by, for example, the central brain as shown in Fig. 1. A plurality of gateways are communicatively connected to the central brain. The central brain is connected to an external cloud via the gateway. The central brain is configured to be able to access the external cloud via the gateway. On the other hand, due to the presence of the gateway, the central brain is configured to be not able to be directly accessed from the outside.

The central brain outputs a request signal to a server every time a prescribed time elapses. Specifically, the central brain outputs a request signal representing an inquiry to the server in units of prescribed cycles, for example, every nanosecond.

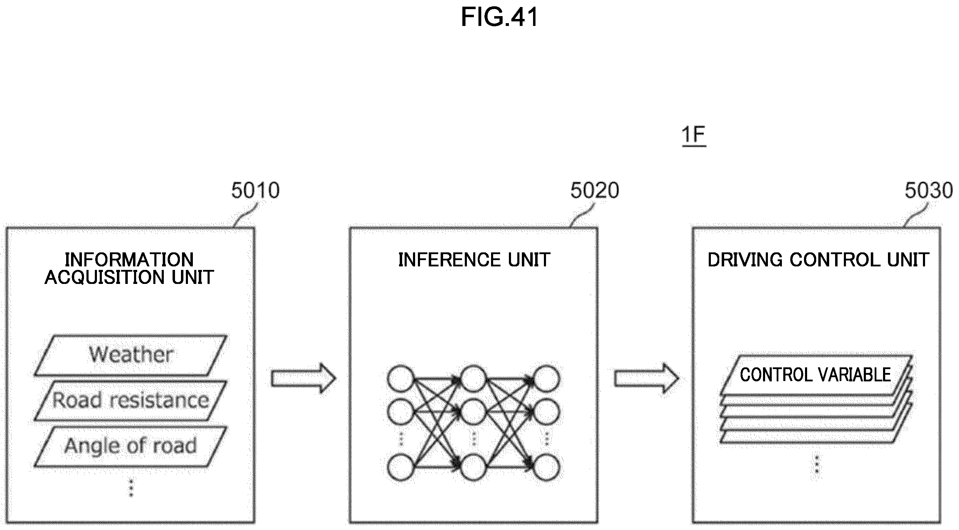

Fig. 41 is a block diagram showing an example of an information processing device according to the twenty-second embodiment of the disclosure. An information processing device 1F of the disclosure includes at least an information acquisition unit 5010 capable of acquiring a plurality of information related to a vehicle, an inference unit 5020 that obtains index values from the plurality of information acquired by the information acquisition unit 5010 and infers a plurality of control variables by using the index values, and a driving control unit 5030 that executes driving control of the vehicle on the basis of the plurality of control variables.

The information acquisition unit 5010 can acquire various types of information related to the vehicle. The information acquisition unit 5010 may include, for example, communication means for acquiring information that can be acquired from sensors attached to various places of the vehicle, a server (not shown), or the like via a network. Examples of the sensors included in the information acquisition unit 5010 include a radar, a LiDAR, a high-pixel/telephoto/ultra-wide angle/360 degrees/high-performance camera, a vision recognition sensor, a microsound sensor, an ultrasonic sensor, a vibration sensor, an infrared sensor, an ultraviolet sensor, an electromagnetic wave sensor, a temperature sensor, a humidity sensor, a spot AI weather forecast sensor, a high-precision multi-channel GPS sensor, and a low-altitude satellite information sensor. Alternatively, long tail incident AI data and the like can be exemplified. The long tail incident AI data is trip data of the vehicle mounted at level 5.

Examples of the sensor information incorporated from the plurality of types of sensors include a temperature and a material of the ground (for example, a road), the outside air temperature, the outside air humidity, vertical and lateral inclination angles of a slope, freezing of a road, a moisture amount, a material of each tire, a wear situation, an air pressure, a road width, the presence or absence of passing prohibition, the vehicle type information of an oncoming vehicle and front and rear vehicles, cruising states of these vehicles, and surrounding situations (birds, animals, soccer balls, accident vehicles, earthquakes, fire, winds, typhoons, heavy rain, light rain, snowstorm, fog, and the like). In the embodiment, detection of such information is performed in units of prescribed cycles, for example, every nanosecond.

It should be particularly noted that the above-described information acquisition unit 5010 includes a vehicle lower sensor provided in a lower portion of the vehicle and capable of detecting a temperature, a material, and a tilt of the traveling ground. The independent smart tilt can be executed by using the vehicle lower sensor.

Here, as the one or more sensor information, sensor information from a sensor that detects a surrounding situation of the vehicle can be applied. In a case in which a plurality of sensor information are used as one or more sensor information, a predetermined number of sensor information may be applied. The predetermined number is, for example, three. Index values for controlling the wheel speed, the inclination, and the suspension are calculated on the basis of three sensor information. The number of index values calculated from a combination of the three sensor information is, for example, three. The index values for controlling the wheel speed, the inclination, and the suspension include, for example, an index value calculated from information regarding an air resistance in the sensor information, an index value calculated from information regarding a road resistance in the sensor information, and an index value calculated from information regarding a slip coefficient in the sensor information.

The inference unit 5020 aggregates index values calculated for each piece of sensor information or each of different combinations of a plurality of sensor information, and calculates control variables for controlling the wheel speed, the inclination, and the suspension. For example, the inference unit 5020 calculates an index value from sensor information of a sensor that detects a surrounding situation of the vehicle and calculates a control variable. In a case of using a plurality of sensor information, the inference unit 5020, for example, calculates a plurality of index values from a combination of sensors 1, 2, and 3, calculates a plurality of index values from a combination of sensors 4, 5, and 6, calculates a plurality of index values from a combination of the sensors 1, 3, and 7, and calculates a control variable by aggregating the index values.

As an example, the inference unit 5020 uses information regarding a material, weather, wind, and an inclination of a road in order to calculate an index value from information regarding an air resistance. Similarly, the inference unit 5020 uses information regarding a material, wind, and an inclination of a road in order to calculate an index value from information regarding a road resistance. Similarly, the inference unit 5020 uses information regarding a material of a road in order to calculate an index value from information regarding a road element.

As described above, the inference unit 5020 calculates a predetermined number, for example, 300 index values while changing a combination of the sensor information, and calculates control variables from the calculated index values. Specifically, a calculation unit may be capable of calculating a control variable from sensor information by using machine learning, more specifically, deep learning. In other words, the calculation unit that calculates an index value and a control variable may be configured by AI.

The inference unit 5020 can obtain an accurate control variable by performing multivariate analysis (see, for example, Formula (2)) according to an integration method as shown in the following Formula (1) by using the calculation power at Level 6 for data every nanosecond and long tail incident AI data collected by many sensor groups and the like in the information acquisition unit 5010. More specifically, the inference unit 5020 obtains an indexed value of each variable at an edge level and in real time while obtaining an integral value of delta values of various ultra-high resolutions with the calculation power at Level 6, and can obtain a result occurring in the next nanosecond as the highest probability theoretical value. In order to realize this, for example, an integral value obtained by time-integrating a delta value (for example, a minute time change value) of a function (in other words, a function indicating ae behavior of each variable) capable of specifying each variable (for example, a plurality of information acquired by the information acquisition unit 5010) such as an air resistance, a road resistance, a road element (for example, dirt), and a slip coefficient is input to a deep learning model of the inference unit 5020. The deep learning model of the inference unit 5020 outputs a control variable (for example, a control variable with the highest certainty factor (that is, an evaluation value)) corresponding to the input integral value. The output of the control variable is performed in units of nanoseconds.

[Math. 1]

$$V = \int_a^b f(A)dt$$

[Math. 2]

$$V_n = DL(f(A,B,C,D,\ldots,N)(dA_n/dt))$$

As an example, in Formula (1), "f(A)" is an expression in which a function indicating a behavior of each of variables such as an air resistance, a road resistance, a road element (for example, dirt), and a slip coefficient is expressed in a simplified manner. As an example, Formula (1) is a formula indicating the time integral v of "f (A)" from the time point a to the time point b. In the formula, DL represents deep learning (for example, a deep learning model optimized by performing deep learning on a neural network), dAn/dt represents a delta value of f(A, B, C, D, ..., N), and A, B, C,..., and N represent index values calculated from the sensor information, for example, an index value calculated from an air resistance, an index value calculated from a road resistance, an index value calculated from a road element, and an index value calculated from a slip coefficient. f(A, B, C, ..., N) represents a function indicating behaviors of A, B, C,..., and N, and Vn represents a value (that is, a control variable) output from the deep learning model optimized by performing deep learning on the neural network.

Here, a form example in which an integral value obtained by time-integrating the delta value of the function is input to the deep learning model of the inference unit 5020 is described, but this is merely an example. For example, an integral value (for example, a result occurring in the next nanosecond) obtained by time-integrating a delta value of a function indicating a behavior of each of variables such as an air resistance, a road resistance, a road element, and a slip coefficient may be inferred by the deep learning model of the inference unit 5020, and as an inference result, an integral value having the highest certainty factor (that is, an evaluation value) may be acquired by the inference unit 5020 every nanosecond.

Here, a form example in which an integral value is input to the deep learning model or an integral value is output from the deep learning model is described, but this is merely an example, and the technology of the disclosure can be established without using an integral value. For example, at least one control variable may be inferred by a deep learning model optimized by performing deep learning on a neural network by using training data in which values corresponding to A, B, C,..., and N are used as example data and values corresponding to at least one control variable (for example, the result occurring in the next nanosecond) are used as correct answer data.

Each control variable obtained by the inference unit 5020 can be further refined by increasing the number of times of deep learning. For example, it is possible to calculate a more accurate control variable by using enormous data such as a tire, rotation of a motor, a steering angle, a material of a road, weather, an influence of dust or at the time of secondary curved deceleration, slip, steering for collapse of balance or re-acquisition, and a speed control method, or long tail incident AI data.

The driving control unit 5030 may execute driving control of the vehicle on the basis of a plurality of control variables specified by the inference unit 5020. The driving control unit 5030 may be capable of realizing autonomous driving control of the vehicle. Specifically, it is possible to acquire a result that occurs in the next nanosecond from a plurality of control variables with the highest probability theoretical value and perform the driving control of the vehicle in consideration of the probability theoretical value.

According to the information processing device 1E having the above-described configuration, similarly to that of the first embodiment, since analysis and inference of information can be performed by using the calculation power at Level 6 that is extremely larger than the calculation power at Level 5, it is possible to perform detailed analysis at a level that is not compared with the related art. This enables vehicle control for safe autonomous driving. The multivariate analysis using the above AI can produce a value difference of 1000 times compared to the world at Level 5.

(Twenty-third Embodiment)

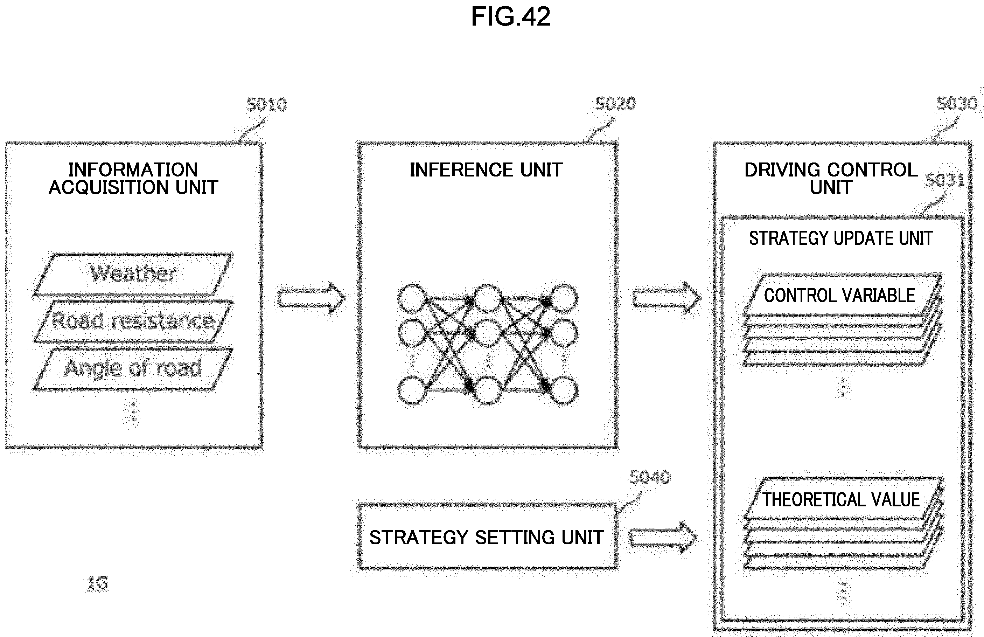

Fig. 42 is a block diagram showing an example of an information processing device according to a twenty-third embodiment of the disclosure. An information processing device 1G according to the embodiment is different from the information processing device 1F in that the information processing device 1G includes a strategy setting unit 5040 that sets a travel strategy until the vehicle reaches a destination, in addition to the constituents of the information processing device 1F according to the above-described twenty-second embodiment.

The strategy setting unit 5040 may set a travel strategy from a current location to a destination on the basis of information regarding the destination input by an occupant or the like of a vehicle, traffic information between the current location and the destination, or the like. **In** this case, information at that time at which the strategy setting is calculated, that is, data currently acquired by the information acquisition unit 5010 may be considered. This is to calculate a more realistic theoretical value by taking into consideration not only simple calculation of a route to a destination but also a surrounding situation at that moment. The travel strategy may include at least one theoretical value of an optimal route to a destination (also referred to as a strategy route), a traveling speed, a tilt, and braking. Preferably, the travel strategy may include all theoretical values of the optimal route, the travel speed, the tilt, and the braking described above.

The plurality of theoretical values configuring the travel strategy set by the strategy setting unit 5040 can be used for autonomous driving control in the driving control unit 5030. The driving control unit 5030 preferably includes a strategy update unit 5031 capable of updating the travel strategy on the basis of differences between the plurality of control variables inferred by the inference unit 5020 and respective theoretical values set by the strategy setting unit 5040.

The control variable inferred by the inference unit 5020 is inferred on the basis of information acquired during traveling of the vehicle, specifically, for example, a friction coefficient detected during actual traveling. Therefore, by considering this control variable, the strategy update unit 5031 can cope with the momentary change at the time of passing through the strategy route. Specifically, the strategy update unit 5031 calculates a difference (delta value) between the theoretical value and the control variable included in the travel strategy, and can thus derive an optimal solution again and reformulate the strategy route. As a result, it is possible to realize the closest autonomous driving control without slipping. Since the calculation power at Level 6 described above can be used in such an update process, correction and fine adjustment can be performed in units of prescribed cycles, for example, in units of nanoseconds, and more precise traveling control can be realized.

In a case in which the information acquisition unit 5010 includes the above-described vehicle lower sensor, the vehicle lower sensor also detects the temperature, a material, and the like of the ground, so that it is possible to cope with the momentary change at the time of passing through the strategy route. An independent smart tilt can also be implemented in calculating a travel course included in the travel strategy. Even in a case in which another information is detected (for example, flying tires, fragments, or animals), it is possible to recalculate an optimal travel course at an instant and perform optimal course management by coping with the momentary change at the time of passing through the strategy route.

**In** the above-described twenty-second and twenty-third embodiments, the central brain functions as a control unit that calculates a control variable for controlling a speed of the vehicle, and controls autonomous driving of the vehicle in units of prescribed cycles, for example, in units of nanoseconds, on the basis of the control variable. Specifically, the central brain controls a speed (acceleration/deceleration) of the vehicle according to the relationship of y=ax". Perfect cornering without friction is realized.

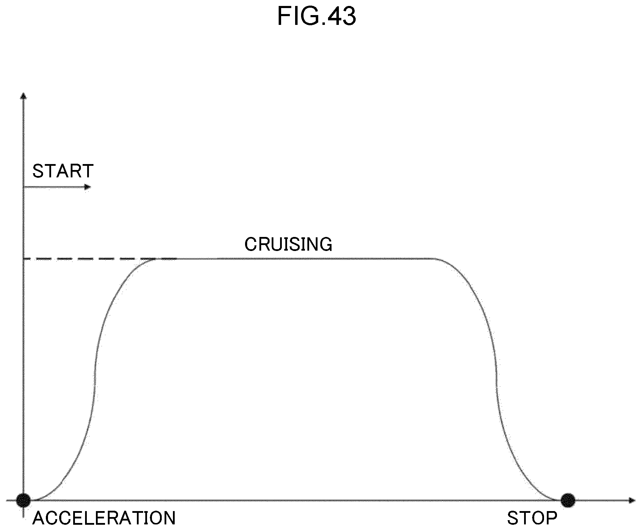

Fig. 43 is a diagram for describing a state of controlling a speed (acceleration/deceleration) of the vehicle according to the relationship of y=ax". Here, x is time, y is a speed, and a is a proportional constant and is an example of a control variable. A value of n is, for example, 2, but may be another value. That is, perfect cornering without friction refers to good smooth perfect acceleration. The acceleration is obtained such that the relationship of $y=ax^n$ is established, and the autonomous driving at the start of acceleration is controlled. That is, the acceleration can change from moment to moment. When the speed approaches a target speed, the speed is reduced by an n-th function such as $y=1-ax^n$. 1 is obtained by normalizing the target speed.

At the time of deceleration, the deceleration is acceleration that can be expressed by $y=1-ax^n$ at the start of deceleration. 1 is obtained by normalizing the speed during deceleration. The acceleration is obtained so that the relationship of $y=1-ax^n$ is established, and the autonomous driving at the start of deceleration is controlled. When the speed approaches a target speed, the speed is reduced by an n-th function such as $y= ax^n$.

Control variables inferred by the inference unit 5020 are used to control the drive of the vehicle such that the relationships of $y= ax^n$ and $y=1- ax^n$ are satisfied at the time of acceleration and deceleration of the vehicle.

The proportional constant can be smoothly changed in any number of stages every prescribed cycle, for example, every nanosecond. The central brain calculates a proportional constant from sensor information such as a driving time, battery depletion, a situation such as instantaneous emergency avoidance (avoidance accidents), a state of a material such as a tire (material condition), and a variable such as a wind speed, finely adjusts a difference by matching data accumulated in the cloud, and correctly transmits a value of the proportional constant derived through the goal seek to in-wheel motors mounted on four wheels and four spin angles, thereby realizing perfect speed control and perfect steering control for performing optimum acceleration/deceleration. This is an object-oriented goal seek traveling system. Realizing such traveling is a role of Level 6.

(Supplements)

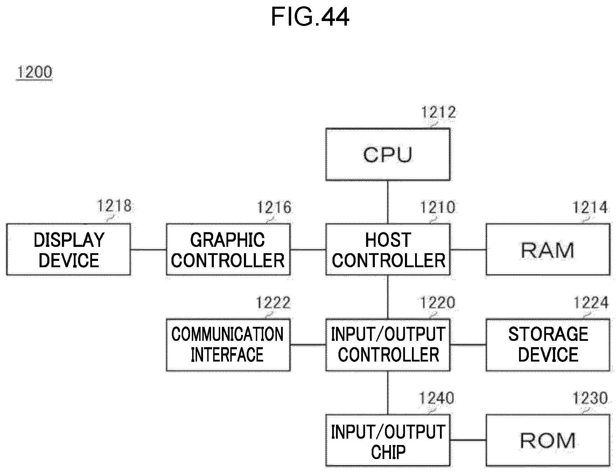

Fig. 44 schematically shows an example of a hardware configuration of a computer 1200 functioning as the information processing device (for example, a central brain) or the cooling execution device described above. A program installed in the computer 1200 can cause the computer 1200 to function as one or more "units" of the apparatus according to each of the above-described embodiments, or cause the computer 1200 to execute an operation associated with the apparatus according to each of the embodiments or one or more "units" thereof, and/or cause the computer 1200 to execute a process according to each of the embodiments or a stage of the process. Such a program may be executed by a CPU 1212 to cause the computer 1200 to execute specific operations associated with some or all of the blocks in the flowcharts and the block diagrams described in the present specification.

The computer 1200 according to each embodiment may include the CPU 1212, a RAM 1214, and a graphic controller 1216, which may be connected to each other via a host controller 1210. The computer 1200 may also include input/output units such as a communication interface 1222, a storage device 1224, a DVD drive, and an IC card drive, which may be connected to the host controller 1210 via the input/output controller 1220. The DVD drive may be a DVD-ROM drive, a DVD-RAM drive, or the like. The storage device 1224 may be a hard disk drive, a solid state drive, or the like. The computer 1200 may also include a ROM 1230 and legacy input/output units such as a keyboard, which may be connected to the input/output controller 1220 via an input/output chip 1240.

The CPU 1212 can control each unit by operating according to programs stored in the ROM 1230 and the RAM 1214. The graphic controller 1216 may obtain image data generated by the CPU 1212 in a frame buffer or the like provided in the RAM 1214 or itself, so that the image data is displayed on the display device 1218.

The communication interface 1222 can communicate with other electronic devices via a network. The storage device 1224 can store programs and data used by the CPU 1212 of the computer 1200. The DVD drive can read a program or data from a DVD-ROM or the like and provide the program or data to the storage device 1224. The IC card drive can read programs and data from an IC card and/or write programs and data into the IC card.

The ROM 1230 may store therein boot programs executed by the computer 1200 at the time of activation, and/or programs that depend on the hardware of the computer 1200. The input/output chip 1240 may also connect various input/output units to the input/output controller 1220 via a USB port, a parallel port, a serial port, a keyboard port, a mouse port, or the like.

The program may be provided by a computer readable storage medium such as a DVD-ROM or an IC card. The program may be read from a computer readable storage medium, installed in the storage device 1224, the RAM 1214, or the ROM 1230, which is also an example of a computer readable storage medium, and executed by the CPU 1212. The information processing described in such a program can be read by the computer 1200 to provide cooperation between the program and the various types of hardware resources. A device or a method may be configured by implementing operation or processing of information according to use of the computer 1200.

For example, in a case in which communication is executed between the computer 1200 and an external device, the CPU 1212 may execute a communication program loaded in the RAM 1214 and instruct the communication interface 1222 to perform communication processing on the basis of processing described in the communication program. Under the control of the CPU 1212, the communication interface 1222 can read transmission data stored in a transmission buffer area provided in a recording medium such as the RAM 1214, the storage device 1224, the DVD-ROM, or the IC card, transmit the read transmission data to the network, or write reception data received from the network in a reception buffer area or the like provided on the recording medium.

The CPU 1212 may cause the RAM 1214 to read the whole or a necessary portion of a file or a database stored in an external recording medium such as the storage device 1224, a DVD drive (DVD-ROM), or an IC card, and may execute various types of processing on data in the RAM 1214. Next, the CPU 1212 may write back the processed data to the external recording medium.

Various types of information such as various types of programs, data, tables, and databases may be stored in a recording medium and subjected to information processing. The CPU 1212 may execute various types of processing on the data read from the RAM 1214, including various types of operations, information processing, condition determination, conditional branching, unconditional branching, information retrieval/replacement, and the like, which are described throughout the disclosure and specified by a program instruction sequence, and may write back the results to the RAM 1214. The CPU 1212 may search for information in a file, a database, or the like in the recording medium. For example, in a case in which a plurality of entries each having an attribute value of a first attribute associated with an attribute value of a second attribute is stored in the recording medium, the CPU 1212 may search for an entry in which the attribute value of the first attribute matches a designated condition from the plurality of entries, read the attribute value of the second attribute stored in the entry, and thus acquire the attribute value of the second attribute associated with the first attribute satisfying a predetermined condition.

The program or software module described above may be stored in a computer readable storage medium on the computer 1200 or in the vicinity of the computer 1200. A recording medium such as a hard disk or a RAM provided in a server system connected to a dedicated communication network or the Internet can be used as a computer readable storage medium, whereby the program can be provided to the computer 1200 via the network.

Blocks in the flowcharts and the block diagrams in the embodiments may represent stages of a process in which an operation is performed or "units" of a device having a role of performing an operation. Specific stages and "units" may be implemented by a dedicated circuit, a programmable circuit supplied along with computer readable instructions stored on a computer readable storage medium, and/or a processor supplied along with computer readable instructions stored on a computer readable storage medium. Dedicated circuits may include digital and/or analog hardware circuits, and may include integrated circuits (ICs) and/or discrete circuits. Programmable circuits may include reconfigurable hardware circuits including, for example, AND, OR, XOR, NAND, NOR, and other logical operations, flip-flops, registers, and memory elements, such as field programmable gate arrays (FPGA) and programmable logic arrays (PLA).

Computer readable storage media may include any tangible device capable of storing instructions executed by a suitable device, and, as a result, a computer readable storage medium having instructions stored thereon has a product including instructions that may be executed to create means for executing operations designated in the flowcharts or block diagrams. Examples of the computer readable storage medium may include an electronic storage medium, a magnetic storage medium, an optical storage medium, an electromagnetic storage medium, and a semiconductor storage medium. More specific examples of the computer readable storage medium may include a Floppy (registered trademark) disk, a diskette, a hard disk, a random access memory (RAM), a read-only memory (ROM), an erasable programmable read-only memory (an EPROM or a flash memory), an electrically erasable programmable read-only memory (EEPROM), a static random access memory (SRAM), a compact disc read-only memory (CD-ROM), a digital versatile disk (DVD), a Blu-Ray (registered trademark) disk, a memory stick, and an integrated circuit card.

The computer readable instructions may include either source codes or object codes written in any combination of one or more programming languages, including assembler instructions, instruction-set-architecture (ISA) instructions, machine instructions, machine-dependent instructions, microcode, firmware instructions, state-setting data, or an object oriented programming language such as Smalltalk (registered trademark), or JAVA (registered trademark), C++, and conventional procedural programming languages such as the "C" programming language or similar programming languages.

The computer readable instructions may be provided to a processor of a general purpose computer, a special purpose computer, or another programmable data processing device, or a programmable circuit locally or via a local area network (LAN) or a wide area network (WAN) such as the Internet, in order to cause the processor of the general purpose computer, the special purpose computer, or another programmable data processing device or the programmable circuit to execute the computer readable instructions to generate means for executing operations designated in the flowcharts or the block diagrams. Examples of the processor include a computer processor, a processing unit, a microprocessor, a digital signal processor, a controller, and a microcontroller.

Although the disclosure has been described with reference to the embodiments, the technical scope of the disclosure is not limited to the scope described in the embodiments. It is apparent to those skilled in the art that various modifications or improvements can be made to the above embodiments. It is apparent from the description of the claims that an aspect to which such modifications or improvements are added can also be included in the technical scope of the disclosure.

It should be noted that the order of execution of each piece of processing of operations, procedures, steps, stages, and the like in the devices, the systems, the programs, and the methods shown in the claims, the specification, and the drawings can be realized in any order unless "before", "prior to", or the like is explicitly stated, and unless the output of the previous processing is used in the later processing. Even in a case in which the operation flow in the claims, the specification, and the drawings is described by using "first,", "next,", and the like for convenience, this does not mean that it is essential to perform in this order.

In the present specification, "$\alpha$ and/or $\beta$" is synonymous with "at least one of $\alpha$ and $\beta$". That is, "$\alpha$ and/or $\beta$" means only $\alpha$, only $\beta$, or a combination of $\alpha$ and $\beta$. In the present specification, the same concept as "$\alpha$ and/or $\beta$" is applied also in a case in which three or more matters are expressed by being connected by "and/or".

This application is based on Japanese Patent Application No. 2022-170165 filed on October 24, 2022, Japanese Patent Application No. 2022-172777 filed on October 27, 2022, Japanese Patent Application No. 2022-175679 filed on November 1, 2022, Japanese Patent Application No. 2022-181362 filed on November 11, 2022, Japanese Patent Application No. 2022-182131 filed on November 14, 2022, Japanese Patent Application No. 2022-186040 filed on November 21, 2022, Japanese Patent Application No. 2022-187648 filed on November 24, 2022, Japanese Patent Application No. 2022-187649 filed on November 24, 2022, Japanese Patent Application No. 2022-189546 filed on November 28, 2022, Japanese Patent Application No. 2022-210851 filed on December 27, 2022, Japanese Patent Application No. 2023-36967 filed on March 9, 2023, Japanese Patent Application No. 2023-58312 filed on March 31, 2023, Japanese Patent Application No. 2023-78139 filed on May 10, 2023, Japanese Patent Application No. 2023-82445 filed on May 18, 2023, Japanese Patent Application No. 2023-87263 filed on May 26, 2023, Japanese Patent Application No. 2023-90418 filed on May 31, 2023, and, Japanese Patent Application No. 2023-93420 filed on June 6, 2023, the contents of which form a part of this application as the contents thereof.

All documents, including publications, patent applications and patents cited herein, are hereby incorporated by reference to the same extent as in a case in which each document were individually specifically indicated and incorporated by reference, and all of the contents thereof were set forth herein.

The use of nouns and similar referents used in connection with the description of the disclosure (particularly in connection with the following claims) are to be construed to cover both the singular and the plural, unless otherwise indicated herein or clearly contradicted by context. The phrases "comprising", "having", and "including" are to be construed as openended terms (i.e., meaning "including but not limited to") unless otherwise noted. Recitation of numerical ranges herein are merely intended to serve as shorthand for referring individually to each value falling within the range, unless otherwise indicated herein, and each value is incorporated into the specification as in a case in which it were individually recited herein. All methods described herein can be performed in any suitable order unless otherwise indicated herein or clearly contradicted by context. Any example or exemplary language (e.g., "such as") used herein is intended merely to better illustrate the disclosure and does not pose a limitation on the scope of the disclosure unless otherwise claimed. No language in the specification should be construed as indicating any non-claimed element as essential to the practice of the disclosure.

Preferred embodiments of the disclosure are described herein, including the best mode known to the inventors for carrying out the disclosure. Variations of these preferred embodiments will be apparent to those skilled in the art upon reading the above description. The inventors expect skilled artisans to apply such variations as appropriate, and expect the disclosure to be practiced otherwise than as specifically described herein. Accordingly, the disclosure includes all modifications and equivalents to the contents of the claims appended hereto as permitted by applicable law. Moreover, any combination of the above elements in all variations is included in the disclosure unless otherwise indicated herein or clearly contradicted by context.

## Claims

**1.** An information processing device comprising:

an information acquisition unit that is capable of acquiring a plurality of information related to a vehicle;
an inference unit that calculates index values from the plurality of information acquired by the information acquisition unit, and uses deep learning to infer a plurality of control variables from the index values; and
a driving control unit that executes driving control of the vehicle on the basis of the plurality of control variables.

**2.** The information processing device according to claim 1, wherein
the inference unit infers the plurality of control variables from the plurality of information through multivariate analysis according to an integration method using the deep learning.

**3.** The information processing device according to claim 1, wherein
the information acquisition unit acquires the plurality of information in units of prescribed cycles, and the inference unit and the driving control unit execute inference of the plurality of control variables and driving control of the vehicle in units of the prescribed cycles by using the plurality of information acquired in units of the prescribed cycles.

**4.** The information processing device according to claim 1, further comprising:

a strategy setting unit that sets a travel strategy until the vehicle reaches a destination, wherein
the travel strategy includes at least one of theoretical values of an optimal route to the destination, a traveling speed, a tilt, and braking, and
the driving control unit includes a strategy update unit that updates the travel strategy on the basis of a difference between the plurality of control variables and the theoretical value.

**5.** The information processing device according to claim 1, wherein
the information acquisition unit includes a sensor that is provided in a lower portion of the vehicle and is capable of detecting a temperature, a material, and a tilt of a traveling ground.

**6.** An information processing device comprising:

an acquisition unit that acquires a plurality of information related to a vehicle from a detection unit including a sensor that detects a surrounding situation of the vehicle in a second cycle shorter than a first cycle of imaging surroundings of the vehicle as a cycle of detecting the surrounding situation of the vehicle;
a calculation unit that calculates an index value related to the surrounding situation of the vehicle from the plurality of acquired information, and calculates a control variable for controlling a behavior of the vehicle from the calculated index value; and
a control unit that controls the behavior of the vehicle on the basis of the calculated control variable.

7. The information processing device according to claim 6, wherein the calculation unit calculates the control variable from the index value through multivariate analysis according to an integration method using deep learning.

8. The information processing device according to claim 6, wherein the acquisition unit acquires the plurality of information in units of nanoseconds, and the calculation unit calculates the index value and the control variable in units of nanoseconds by using the plurality of information acquired in units of nanoseconds.

9. The information processing device according to claim 6, wherein the calculation unit predicts a collision of a target object with the vehicle on the basis of the plurality of acquired information, and in a case in which a predicted result indicates an unavoidable collision, the calculation unit calculates, as the control variable, a control variable corresponding to damage in which damage generated in the vehicle in the unavoidable collision is a predetermined threshold or less.

10. The information processing device according to claim 9, wherein the damage generated in the vehicle is at least one of a deformation position and a deformation amount of the vehicle.

11. The information processing device according to claim 9, wherein the control variable corresponding to the damage generated in the vehicle is at least one of a collision angle and a vehicle speed of the vehicle.

12. A vehicle comprising the information processing device according to any one of claims 1 to 11.

13. A program for causing a computer to function as the information processing device according to any one of claims 1 to 11.

14. An information processing device comprising:

a processor, wherein
the processor
acquires detection information obtained by detecting a surrounding situation of a moving object, point information obtained by regarding an imaged object as a point, and identification information for identifying the object,
calculates a control variable from a correlation between a variable related to the surrounding situation of the moving object calculated from the detection information and the control variable inferred by using the variable, and
controls autonomous driving of the moving object on the basis of the control variable, the point information, and the identification information.

15. The information processing device according to claim 14, wherein

a coefficient of the variable for the control variable is determined in advance, and
the processor
calculates the control variable by using the coefficient.

16. The information processing device according to claim 14, wherein

the processor
executes a process of inferring the control variable in a second cycle longer than a first cycle of acquiring the detection information.

17. The information processing device according to claim 16, wherein

the processor
executes a process of calculating the control variable in a third cycle shorter than the second cycle.

18. The information processing device according to any one of claims 14 to 17, wherein

the processor
infers the control variable through multivariate analysis according to an integration method using deep learning.

**19.** The information processing device according to any one of claims 14 to 17, wherein

the processor
acquires the point information and the identification information from different processors.

**20.** An information processing method of causing a computer to execute processing of:

acquiring detection information obtained by detecting a surrounding situation of a moving object, point information obtained by regarding an imaged object as a point, and identification information for identifying the object;
calculating a control variable from a correlation between a variable related to the surrounding situation of the moving object calculated from the detection information and the control variable inferred by using the variable; and
controlling autonomous driving of the moving object on the basis of the control variable, the point information, and the identification information.

**21.** A program for causing a computer to execute processing of:

acquiring detection information obtained by detecting a surrounding situation of a moving object, point information obtained by regarding an imaged object as a point, and identification information for identifying the object;
calculating a control variable from a correlation between a variable related to the surrounding situation of the moving object calculated from the detection information and the control variable inferred by using the variable; and
controlling autonomous driving of the moving object on the basis of the control variable, the point information, and the identification information.

**22.** An information processing device comprising:

a processor, wherein
the processor
acquires detection information from a detection unit that detects a surrounding situation of a moving object in a second cycle shorter than a first cycle of imaging surroundings of the moving object,
divides a period in which a collision of an obstacle with the moving object based on the detection information is predictable into a plurality of periods, and
calculates a control variable for controlling autonomous driving of the moving object by using a plurality of input parameters based on the detection information in each of the plurality of periods according to a time series of the plurality of periods.

**23.** The information processing device according to claim 22, wherein
in a case in which the control variable is calculated in a second or subsequent period of the plurality of periods, the processor calculates the control variable by reducing the number of input parameters compared with the number of input parameters in a previous period.

**24.** An information processing method of causing a computer to execute processing of:

acquiring detection information from a detection unit that detects a surrounding situation of a moving object in a second cycle shorter than a first cycle of imaging surroundings of the moving object;
dividing a period in which a collision of an obstacle with the moving object based on the detection information is predictable into a plurality of periods; and
calculating a control variable for controlling autonomous driving of the moving object by using a plurality of input parameters based on the detection information in each of the plurality of periods according to a time series of the plurality of periods.

**25.** A program for causing a computer to execute processing of:

acquiring detection information from a detection unit that detects a surrounding situation of a moving object in a second cycle shorter than a first cycle of imaging surroundings of the moving object;
dividing a period in which a collision of an obstacle with the moving object based on the detection information is predictable into a plurality of periods; and
calculating a control variable for controlling autonomous driving of the moving object by using a plurality of input parameters based on the detection information in each of the plurality of periods according to a time series of the plurality of periods.

**26.** An information processing device comprising:

a processor, wherein
the processor
acquires detection information from a detection unit that detects a surrounding situation of a moving object in a second cycle shorter than a first cycle of imaging surroundings of the moving object,
calculates a distance between the moving object and an obstacle on the basis of the detection information, and
predicts approach of the obstacle on the basis of the distance and a predetermined margin.

**27.** The information processing device according to claim 26, wherein
the margin is determined in advance for each occupant of the moving object.

**28.** The information processing device according to claim 27, wherein
the margin is determined in advance for each age of the occupant.

**29.** The information processing device according to claim 26, wherein

the processor
changes the margin according to a movement speed of the moving object or the obstacle.

**30.** The information processing device according to claim 29, wherein

the processor
changes the margin according to a braking distance of the moving object or the obstacle.

**31.** The information processing device according to any one of claims 26 to 30, wherein

the processor
controls autonomous driving of the moving object on the basis of the predicted result.

**32.** An information processing method of causing a computer to execute processing of:

acquiring detection information from a detection unit that detects a surrounding situation of a moving object in a second cycle shorter than a first cycle of imaging surroundings of the moving object;
calculating a distance between the moving object and an obstacle on the basis of the detection information; and
predicting approach of the obstacle on the basis of the distance and a predetermined margin.

**33.** A program for causing a computer to execute processing of:

acquiring detection information from a detection unit that detects a surrounding situation of a moving object in a second cycle shorter than a first cycle of imaging surroundings of the moving object;
calculating a distance between the moving object and an obstacle on the basis of the detection information; and
predicting approach of the obstacle on the basis of the distance and a predetermined margin.

**34.** An information processing device comprising:

a processor, wherein
the processor
acquires detection information from a detection unit that detects a surrounding situation of a moving object in a second cycle shorter than a first cycle of imaging surroundings of the moving object,
predicts a collision of an obstacle with the moving object on the basis of the detection information, and

calculates a control variable for controlling autonomous driving of the moving object such that the obstacle will collide with a predetermined portion of the moving object in a case in which the predicted result indicates an unavoidable collision.

**35.** The information processing device according to claim 34, wherein

the processor
sets, as the predetermined portion, a portion in which damage generated in a case in which the obstacle collides with the moving object satisfies a predetermined standard.

**36.** The information processing device according to claim 35, wherein
the portion in which the damage satisfies the predetermined standard may be a portion in which a rigidity of the moving object is a predetermined threshold or more.

**37.** The information processing device according to claim 35, wherein
the portion in which the damage satisfies the predetermined standard is a portion in which a distance from an engine, a motor, or a battery mounted on the moving object is a predetermined threshold or more.

**38.** The information processing device according to claim 35, wherein
the portion in which the damage satisfies the predetermined standard is a portion in which a distance from an occupant in the moving object is a predetermined threshold or more.

**39.** The information processing device according to any one of claims 36 to 38, wherein

the processor
receives an input of a design drawing/document related to the moving object, and
specifies a portion in which the damage satisfies the predetermined standard on the basis of the design drawing/document.

**40.** An information processing method of causing a computer to execute processing of:

acquiring detection information from a detection unit that detects a surrounding situation of a moving object in a second cycle shorter than a first cycle of imaging surroundings of the moving object;
predicting a collision of an obstacle with the moving object on the basis of the detection information; and
calculating a control variable for controlling autonomous driving of the moving object such that the obstacle will collide with a predetermined portion of the moving object in a case in which the predicted result indicates an unavoidable collision.

**41.** A program for causing a computer to execute processing of:

acquiring detection information from a detection unit that detects a surrounding situation of a moving object in a second cycle shorter than a first cycle of imaging surroundings of the moving object;
predicting a collision of an obstacle with the moving object on the basis of the detection information; and
calculating a control variable for controlling autonomous driving of the moving object such that the obstacle will collide with a predetermined portion of the moving object in a case in which the predicted result indicates an unavoidable collision.

**42.** An information processing device comprising:

a processor, wherein
the processor
acquires detection information from a detection unit that detects a surrounding situation of a moving object in a second cycle shorter than a first cycle of imaging surroundings of the moving object,
calculates a control variable for controlling autonomous driving of the moving object on the basis of the detection information, and
in a case in which the control variable for reducing damage generated in the vehicle in an unavoidable collision is calculated, provides a notification to a set contact address.

**43.** An information processing method of causing a computer to execute processing of:

acquiring detection information from a detection unit that detects a surrounding situation of a moving object in a second cycle shorter than a first cycle of imaging surroundings of the moving object;
calculating a control variable for controlling autonomous driving of the moving object on the basis of the detection information; and
in a case in which the control variable for reducing damage generated in the vehicle in an unavoidable collision is calculated, providing a notification to a set contact address.

**44.** A program for causing a computer to execute processing of:

acquiring detection information from a detection unit that detects a surrounding situation of a moving object in a second cycle shorter than a first cycle of imaging surroundings of the moving object;
calculating a control variable for controlling autonomous driving of the moving object on the basis of the detection information; and
in a case in which the control variable for reducing damage generated in the vehicle in an unavoidable collision is calculated, providing a notification to a set contact address.

**45.** An information processing device comprising:

an acquisition unit that acquires a plurality of information related to a vehicle from a detection unit including a sensor that detects a surrounding situation of the vehicle;
a calculation unit that calculates an index value related to the surrounding situation of the vehicle from the plurality of acquired information, and calculates a control variable for controlling a behavior of the vehicle from the calculated index value; and
a control unit that controls the behavior of the vehicle on the basis of the calculated control variable, wherein
the calculation unit predicts a collision of a target object with the vehicle on the basis of the plurality of acquired information, and in a case in which the predicted result indicates an unavoidable collision, the calculation unit calculates a control variable such that damage generated in the vehicle is damage that is a predetermined threshold or less in the unavoidable collision and a re-collision in which the vehicle collides with another target object after the collision.

**46.** The information processing device according to claim 45, wherein
the acquisition unit acquires information regarding the surrounding situation of the vehicle from another vehicle that is a collision target object.

**47.** The information processing device according to claim 45, wherein
the acquisition unit acquires information regarding the surrounding situation of the vehicle from an external device installed on a traveling path on which the vehicle travels.

**48.** The information processing device according to claim 45, wherein
the calculation unit calculates the control variable from the index value through multivariate analysis according to an integration method using deep learning.

**49.** The information processing device according to claim 45, wherein
the damage generated in the vehicle is at least one of a deformation position and a deformation amount of the vehicle.

**50.** The information processing device according to claim 45, wherein
a control variable corresponding to the damage generated in the vehicle is at least one of a collision angle and a vehicle speed of the vehicle.

**51.** A vehicle comprising:

the information processing device according to claim 47;
the sensor that is connected to the information processing device and detects the surrounding situation of the vehicle; and
a reception unit that receives the plurality of information from the external device.

Gateway
Gateway
Central Brain
Gateway
Gateway

FIG.1

1
10
INFORMATION ACQUISITION UNIT
Weather
Road resistance
Angle of road
...
20
INFERENCE UNIT
30
DRIVING CONTROL UNIT
Index VALUE
...

FIG.2

FIG.3
10
INFORMATION ACQUISITION UNIT
Weather
Road resistance
Angle of road
20
INFERENCE UNIT
30
DRIVING CONTROL UNIT
31
STRATEGY UPDATE UNIT
Index VALUE
THEORETICAL VALUE
40
STRATEGY SETTING UNIT
1A

FIG.4
1B
INFORMATION PROCESSING DEVICE
20
INFERENCE UNIT
20A
50
52
EXAMPLE DATA
EXAMPLE ENVIRONMENT INFORMATION
52A
CORRECT ANSWER DATA
CORRECT ANSWER DISTANCE
54A
54
LEARNING
VEHICLE-TO-OBSTACLE DISTANCE
TRAVELING SPEED
AIR RESISTANCE
ROAD RESISTANCE
ROAD ELEMENT
GROUND INCLINATION
52A1
52A2
52A3
52A4
52A5
52A6
REQUIRED STOP DISTANCE
+
MARGIN DISTANCE
54A1
54A2
48
53
REQUIRED STOP DISTANCE
MARGIN DISTANCE
1B

# FIG.5

10
INFORMATION ACQUISITION UNIT
56
ENVIRONMENT INFORMATION
56A
VEHICLE-TO-OBSTACLE DISTANCE
56B
TRAVELING SPEED
56C
AIR RESISTANCE
56D
ROAD RESISTANCE
56E
ROAD ELEMENT
56F
GROUND INCLINATION
INPUT
20
INFERENCE UNIT
20A
OUTPUT
58
INDEX VALUE (NON-COLLISION DISTANCE)
30
DRIVING CONTROL UNIT
58
INDEX VALUE (NON-COLLISION DISTANCE)
62
TRAVELING SPEED ARITHMETIC EXPRESSION
64
MAXIMUM SPEED
TRAVELING SPEED CONTROL AT MAXIMUM SPEED

FIG.6

TRAVELING SPEED CONTROL PROCESS
ST10
HAS TIMING DEFINED IN UNITS OF NANOSECONDS ARRIVED?
N
Y
ACQUIRE ENVIRONMENT INFORMATION
ST12
INPUT ENVIRONMENT INFORMATION TO DEEP LEARNING MODEL
ST14
ACQUIRE INDEX VALUE OUTPUT FROM DEEP LEARNING MODEL
ST16
CALCULATE MAXIMUM SPEED ON BASIS OF INDEX VALUE
ST18
PERFORM CONTROL SUCH THAT VEHICLE TRAVELS AT MAXIMUM SPEED
ST20
N
IS ENDING CONDITION SATISFIED?
ST22
Y
END

FIG.7

1C
54
1C
INFORMATION ACQUISITION UNIT
10
56
ENVIRONMENT INFORMATION
TRAVEL ROUTE
TRAVELING SPEED
GROUND INCLINATION
BRAKE CONTROL VALUE
AIR RESISTANCE
ROAD RESISTANCE
ROAD ELEMENT
56A
56B
56C
56D
56E
56F
56G
INPUT
INFORMATION PROCESSING DEVICE
20
INFERENCE UNIT
20A
OUTPUT
STRATEGY SETTING UNIT
40
TRAVEL STRATEGY
66
THEORETICAL VALUE
68
SETTING
DRIVING CONTROL UNIT
30
31
STRATEGY UPDATE UNIT
58
INDEX VALUE
70
DIFFERENCE
66
TRAVEL STRATEGY
THEORETICAL VALUE
68
UPDATE

FIG.8
DATA MANAGEMENT DEVICE
76
76
72
VEHICLE IDENTIFIER
VEHICLE IDENTIFIER
74
INDEX VALUE
INDEX VALUE
58
58
STRATEGY UPDATE UNIT
66
31
58
TRAVEL STRATEGY
INDEX VALUE
UPDATE
THEORETICAL VALUE
68
INFERENCE UNIT
20
58
INDEX VALUE
54A(54)
54B(54)
1C
1C

FIG.9
TRAVEL STRATEGY UPDATE PROCESS
SET TRAVEL STRATEGY
ST40
HAS TIMING DEFINED IN UNITS OF NANOSECONDS ARRIVED?
ST42
N
Y
HAS SECOND VEHICLE INFORMATION ACQUISITION TIMING ARRIVED?
ST44
N
Y
ACQUIRE PLURALITY OF INDEX VALUES OF SECOND VEHICLE
ST46
UPDATE TRAVEL STRATEGY ON BASIS OF PLURALITY OF INDEX VALUES
ST48
ACQUIRE ENVIRONMENT INFORMATION
ST50
INPUT ENVIRONMENT INFORMATION TO DEEP LEARNING MODEL
ST52
ACQUIRE PLURALITY OF INDEX VALUES OUTPUT FROM DEEP LEARNING MODEL
ST54
CALCULATE DIFFERENCE BETWEEN INDEX VALUE AND THEORETICAL VALUE
ST56
UPDATE TRAVEL STRATEGY ON BASIS OF DIFFERENCE
ST58
EXECUTE DRIVING CONTROL ACCORDING TO TRAVEL STRATEGY
ST60
IS ENDING CONDITION SATISFIED?
ST62
N
Y
END

FIG.10
1C
INFORMATION PROCESSING DEVICE
20
20A
INFERENCE UNIT
OUTPUT
40
STRATEGY SETTING UNIT
TRAVEL STRATEGY
THEORETICAL VALUE
66
68
OUTPUT
31
STRATEGY UPDATE UNIT
58
INDEX VALUE
66
TRAVEL STRATEGY
THEORETICAL VALUE
68
70
DIFFERENCE
UPDATE
OUTPUT
78
NOTIFICATION UNIT
DIFFERENCE > THRESHOLD?
YES
NOTIFY

FIG.11

Cloud
Rader
Vibration
Weather forecast
LiDAR
Infrared rays
Multi-channel GPS
Camera
Ultraviolet rays
Satellite data
Microsound
Electromagnetic waves
Long-tail incident AI data
Ultrasonic
Temperature
Thermal sensor

FIG.12

Gateway
Gateway
Central Brain
2120
Gateway
Gateway
2012

FIG.13

START
ACQUIRE SENSOR INFORMATION
S10
CALCULATE CONTROL VARIABLE
S11
CONTROL AUTONOMOUS DRIVING
S12
END

FIG.14

2012
2030
2032
2031
R1

FIG.15

2012
2030
2032
2031
R2

FIG.16

2012
2030
2032
2031
R3

FIG.17

2012
A1
2030
2031

FIG.18

2012
2031
2030
A2

FIG.19

2012C
2012D
2012A×2
2012A×3
2012A×1
2012A
2012B

FIG.20

1D(2120)
Central Brain
2125
2123
GNPU
2124
CPU
2122
MoPU
Memory
2126
IPU
2121

FIG.21

START
ACQUIRE SENSOR INFORMATION
S10
CALCULATE RELATIONSHIP WITH ANOTHER VEHICLE
S10A
S11B
IS COLLISION UNAVOIDABLE?
Y
N
CALCULATE CONTROL VARIABLE
S11C
CALCULATE CONTROL VARIABLE (REDUCE DAMAGE)
S11D
CONTROL AUTONOMOUS DRIVING
S12
END

FIG.22

Gateway
Gateway
Central
Brain
3015
Gateway
Gateway
3100

1E
Memory
3016
Central Brain
GNPU
CPU
IPU
3013
3014
3011
3015
MoPU
3012

FIG.23

FIG.24

3012L
Left MoPU
(Left eye)
3032L
RADAR
3030L
CAMERA
3034L
INFRARED CAMERA
3017L
CORE
3012R
Right MoPU
(Right eye)
3032R
RADAR
3030R
CAMERA
3034R
INFRARED CAMERA
3017R
CORE
1E
3011
IPU
1920 frames/sec
Central Brain
3015
1920 frames/sec
Multiple frames/sec
120 240 480 960 1920

FIG.25

$(X_{31}, Y_{31})$
3023
$(X_{32}, Y_{32})$
$(X_{11}, Y_{11})$
3021
$(X_{12}, Y_{12})$
$(X_{41}, Y_{41})$
3024
$(X_{42}, Y_{42})$
$(X_{21}, Y_{21})$
3022
$(X_{22}, Y_{22})$

FIG.26

CAMERA
3030
VISIBLE
LIGHT
CAMERA
3030A
INFRARED
CAMERA
3030B
100 frame/second
3012
CORE
3017
1E
100 frame/second
Central Brain
3015

FIG.27

CAMERA
3030
RADAR
3032
100 frame/second
3012
CORE
3017
1E
100 frame/second
Central Brain
3015

FIG.28

B14
P4
t0
t1
[PERSON]
t2
[PERSON]

FIG.29

3100
1E
3110
3120

FIG.30

3110
COOLING EXECUTION DEVICE
ACQUISITION UNIT
3112
EXECUTION UNIT
3114
PREDICTION UNIT
3116

FIG.31

IRRADIATION DEVICE
3130
CAMERA
3030
CAMERA
3140
100 frame/second
3012
CORE
3017
1E
100 frame/second
Central Brain
3015

FIG.32
1E
Memory
3016
Central Brain
GNPU
CPU
IPU
Lidar SENSOR
3013
3014
3011
3018
3015
MoPU
3012

FIG.33

t:(x1,y1,z1)
J1
J2
t+1:(x2,y2,z2)
3018
3030

FIG.34

EVENT CAMERA
3030C
3012
CORE
3017
1E
Central Brain
3015

FIG.35A

FIG.35B

FIG.35C

Xn,Yn

FIG.36

3100C
3100D
Ax2
Ax3
Ax1
3100A
3100B

FIG.37

START
ACQUIRE SENSOR INFORMATION
S20
CALCULATE RELATIONSHIP WITH ANOTHER VEHICLE
S21A
S21B
IS COLLISION UNAVOIDABLE ?
Y
N
CALCULATE CONTROL VARIABLE
S21C
CALCULATE CONTROL VARIABLE (CONTROL COLLISION PORTION)
S21D
CONTROL AUTONOMOUS DRIVING
S22
END

FIG.38

START
S30
ACQUIRE SENSOR INFORMATION
S32
CALCULATE RELATIONSHIP WITH ANOTHER VEHICLE
S34
IS COLLISION UNAVOIDABLE ?
N
Y
S36
CALCULATE CONTROL VARIABLE (REDUCE DAMAGE)
S40
CALCULATE CONTROL VARIABLE
S38
NOTIFY
S42
CONTROL AUTONOMOUS DRIVING
END

FIG.39

4001
MAP INFORMATION SERVER
4016A(4016)
WEATHER INFORMATION SERVER
4016B(4016)
4014
N
INFORMATION PROVIDING DEVICE
ANOTHER VEHICLE
4012B(4012)
OWN VEHICLE
ANOTHER VEHICLE
4012C(4012)
4012A(4012)
ANOTHER VEHICLE
4012D(4012)

FIG.40

START
ACQUIRE SENSOR INFORMATION
S50
ACQUIRE EXTERNAL INFORMATION
S51
CALCULATE RELATIONSHIPS WITH ANOTHER VEHICLE AND OBJECT
S52
S53
ALREADY CONTACTED OR COLLIDED ?
Y
N
CALCULATE CONTROL VARIABLE (SECONDARY COLLISION MODE)
S57
S54
IS COLLISION UNAVOIDABLE ?
Y
N
CALCULATE CONTROL VARIABLE
S55
CALCULATE CONTROL VARIABLE (DAMAGE REDUCTION MODE)
S56
CONTROL AUTONOMOUS DRIVING
S58

FIG.41
1F
5010
INFORMATION ACQUISITION UNIT
Weather
Road resistance
Angle of road
...
5020
INFERENCE UNIT
5030
DRIVING CONTROL UNIT
CONTROL VARIABLE
...

FIG.42

5010
INFORMATION ACQUISITION UNIT
Weather
Road resistance
Angle of road
...
5020
INFERENCE UNIT
5030
DRIVING CONTROL UNIT
5031
STRATEGY UPDATE UNIT
CONTROL VARIABLE
...
THEORETICAL VALUE
...
5040
STRATEGY SETTING UNIT
1G

FIG.43

START
CRUISING
ACCELERATION
STOP

FIG.44

1200
1212
CPU
1218
DISPLAY DEVICE
1216
GRAPHIC CONTROLLER
1210
HOST CONTROLLER
1214
RAM
1222
COMMUNICATION INTERFACE
1220
INPUT/OUTPUT CONTROLLER
1224
STORAGE DEVICE
1240
INPUT/OUTPUT CHIP
1230
ROM

**INTERNATIONAL SEARCH REPORT**

International application No. **PCT/JP2023/038380**

**A. CLASSIFICATION OF SUBJECT MATTER**

***B60W 30/085***(2012.01)i; ***B60G 3/00***(2006.01)i; ***B60L 15/20***(2006.01)i; ***B60W 10/08***(2006.01)i; ***B60W 10/22***(2006.01)i; ***B60W 30/02***(2012.01)i; ***B60W 30/08***(2012.01)i; ***B60W 30/10***(2006.01)i; ***B60W 30/095***(2012.01)i; ***B60W 40/00***(2006.01)i; ***B60W 40/02***(2006.01)i; ***B60W 40/06***(2012.01)i; ***B60W 60/00***(2020.01)i; ***B62D 7/15***(2006.01)i; ***G01B 11/00***(2006.01)i; ***G01C 3/06***(2006.01)i; ***G01C 21/34***(2006.01)i; ***G01P 13/00***(2006.01)i; ***G06N 3/04***(2023.01)i; ***G06N 3/08***(2023.01)i; ***G06T 7/00***(2017.01)i; ***G06T 7/20***(2017.01)i; ***G06T 7/70***(2017.01)i; ***G06V 10/94***(2022.01)i; ***G06V 20/58***(2022.01)i; ***G08G 1/16***(2006.01)i; ***G08G 1/0968***(2006.01)i; ***H01L 23/473***(2006.01)i; ***H04N 7/18***(2006.01)i; ***H04N 23/60***(2023.01)i; ***H05K 7/20***(2006.01)i

FI: B60W30/085; G06T7/00 650Z; G06T7/20; B60W60/00; G01C21/34; G08G1/0968; G08G1/16 C; G01B11/00 H; G01C3/06 110V; G01P13/00 E; H01L23/46 Z; H05K7/20 D; B62D7/15 A; B60G3/00; B60W40/06; B60W10/08; B60W10/22; B60L15/20 S; B60W30/095; G06T7/00 650B; H04N7/18 J; H04N23/60 500; G06V20/58; B60W30/08; G06N3/04; G06N3/08; H04N7/18 K; H04N7/18 E; H04N23/60; B60W30/10; G08G1/16 A; B60W30/02; B60W40/02; G06T7/70 A; G06V10/94; B60W40/00

According to International Patent Classification (IPC) or to both national classification and IPC

**B. FIELDS SEARCHED**

Minimum documentation searched (classification system followed by classification symbols)

B60W30/085; B60G3/00; B60L15/20; B60W10/08; B60W10/22; B60W30/02; B60W30/08; B60W30/10; B60W30/095; B60W40/00; B60W40/02; B60W40/06; B60W60/00; B62D7/15; G01B11/00; G01C3/06; G01C21/34; G01P13/00; G06N3/04; G06N3/08; G06T7/00; G06T7/20; G06T7/70; G06V10/94; G06V20/58; G08G1/16; G08G1/0968; H01L23/473; H04N7/18; H04N23/60; H05K7/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2021/090897 A1 (SONY CORPORATION) 14 May 2021 (2021-05-14) paragraphs [0014]-[0218], fig. 1-14 | 1-4 |
| Y | | 5-13 |
| A | | 14-51 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 January 2024** | **16 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2023/038380**

**C. DOCUMENTS CONSIDERED TO BE RELEVANT**

| Category* | Citation of document, with indication, where appropriate, of the relevant passages | Relevant to claim No. |
|---|---|---|
| Y | JP 2009-042115 A (MAZDA MOTOR CORP) 26 February 2009 (2009-02-26) paragraphs [0008]-[0009] | 5, 12-13 |
| Y | JP 2022-137732 A (SUZUKI MOTOR CORP) 22 September 2022 (2022-09-22) paragraphs [0015]-[0016] | 5, 12-13 |
| Y | JP 2010-205228 A (TOYOTA MOTOR CORP) 16 September 2010 (2010-09-16) paragraphs [0062], [0064] | 6-13, 22, 24-44 |
| Y | JP 2016-034814 A (TOYOTA MOTOR CORP) 17 March 2016 (2016-03-17) claim 6, paragraphs [0028]-[0031], [0070]-[0072] | 9-13 |
| Y | JP 2018-052415 A (ADVICS CO LTD) 05 April 2018 (2018-04-05) paragraphs [0019], [0022], fig. 4 | 22, 24-25 |
| Y | JP 2019-144748 A (DENSO CORP) 29 August 2019 (2019-08-29) paragraphs [0020], [0026], [0056], [0066] | 26-33 |
| Y | JP 2019-059274 A (SUBARU CORP) 18 April 2019 (2019-04-18) paragraphs [0023], [0028], [0047]-[0055], fig. 1-6 | 34-41 |
| Y | JP 2021-149806 A (HONDA MOTOR CO LTD) 27 September 2021 (2021-09-27) paragraphs [0025]-[0034], fig. 1-2 | 42-44 |
| Y | JP 2019-026056 A (SUBARU CORP) 21 February 2019 (2019-02-21) paragraphs [0032], [0088], fig. 2, 4 | 42-44 |
| A | WO 2021/200037 A1 (NEC CORPORATION) 07 October 2021 (2021-10-07) paragraphs [0014]-[0078], fig. 1-9 | 1-51 |

Form PCT/ISA/210 (second sheet) (July 2022)

**INTERNATIONAL SEARCH REPORT**
**Information on patent family members**

International application No.
**PCT/JP2023/038380**

| Patent document cited in search report | Publication date (day/month/year) | Patent family member(s) | Publication date (day/month/year) |
|---|---|---|---|
| WO 2021/090897 A1 | 14 May 2021 | US 2023/0045416 A1 paragraphs [0046]-[0257], fig. 1-14 | |
| JP 2009-042115 A | 26 February 2009 | (Family: none) | |
| JP 2022-137732 A | 22 September 2022 | EP 4056437 A1 paragraphs [0016]-[0017] | |
| JP 2010-205228 A | 16 September 2010 | (Family: none) | |
| JP 2016-034814 A | 17 March 2016 | WO 2016/021469 A1 claim 6, p. 13, line 28 to p. 15, line 26, p. 30, line 29 to p. 31, line 20 | |
| JP 2018-052415 A | 05 April 2018 | (Family: none) | |
| JP 2019-144748 A | 29 August 2019 | (Family: none) | |
| JP 2019-059274 A | 18 April 2019 | (Family: none) | |
| JP 2021-149806 A | 27 September 2021 | US 2021/0291871 A1 paragraphs [0031]-[0040], fig. 1-2 | |
| JP 2019-026056 A | 21 February 2019 | (Family: none) | |
| WO 2021/200037 A1 | 07 October 2021 | US 2023/0127338 A1 paragraphs [0030]-[0098], fig. 1-9 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022035198 A
- JP 2022170165 A
- JP 2022172777 A
- JP 2022175679 A
- JP 2022181362 A
- JP 2022182131 A
- JP 2022186040 A
- JP 2022187648 A
- JP 2022187649 A
- JP 2022189546 A
- JP 2022210851 A
- JP 2023036967 A
- JP 2023058312 A
- JP 2023078139 A
- JP 2023082445 A
- JP 2023087263 A
- JP 2023090418 A
- JP 2023093420 A